# EUROPEAN PATENT APPLICATION

(11) **EP 4 637 287 A1**
(43) Date of publication of application: **22.10.2025**
(21) Application number: 25170945.7
(22) Date of filing: 16.04.2025
(51) Int. Cl.: H05K 7/20

(54) **MODULAR LIQUID-COOLING IT SYSTEM AND METHOD**

(30) Priority: 16.04.2024 US 202463634834 P
(71) Applicant: Google LLC, Mountain View, CA 94043 (US)
(72) Inventor: Iyengar, Madhusudan Krishnan, Mountain View, California, 94043 (US); Padilla, Jorge, Mountain View, California, 94043 (US)
(74) Representative: Betten & Resch

(57) **Abstract**

The technology is directed to a modular liquid-cooling information technology ("IT") system, apparatus, and method for cooling and thermal management of IT equipment in a data center. An improved coolant distribution unit (CDU) provides cooling fluid to data racks in a data center and includes a plurality of modular CDUs ("mCDUs"). The mCDUs provide for modularity of the liquid-cooling system and greater control over fluid flow through the CDU and to the data racks. Additionally, methods are disclosed for controlling components within each mCDU to allow for continual modifications to fluid flow through the system to provide optimal cooling of data racks.

## Description

### CROSS-REFERENCE TO RELATED APPLICATIONS

The present application claims the benefit of the filing date of U.S. Provisional Patent Application No. 63/634,834, filed April 16, 2024, the disclosure of which is hereby incorporated herein by reference.

### BACKGROUND

The present application relates to thermal management and cooling of data centers utilizing liquid or fluid cooling. Liquid coolant can be fed into information technology ("IT") equipment, including without limitation, computing equipment on data center racks to reduce heat generated by servers and equipment on data center racks, as well as heat generated by components external to the assembly.

Corporations that operate large-scale computing systems invest significant resources to ensure that computing system equipment operates under optimal conditions. These computing systems are typically stored in data centers, which require expensive hardware and equipment, as well as real estate and personnel to maintain the equipment stored in the data centers. To minimize costs, data center racks and the equipment thereon are designed to be compact and capable of functioning over extended periods of time.

Given the high power outputs of each computing system, as well as the other equipment in the data rack and in the data center, high levels of heat are generated. Significant heat within and around the computing systems threatens the lifespan and operation of the computing systems.

Liquid cooling presents one method for removing heat in the system and maintaining components of computing systems, such as chip assemblies and microprocessors, within optimal temperature limits. Liquid cooling allows for removal of the excess heat with heat transfer fluid pumped into a cooling device and the heated return liquid pumped out of the device.

### BRIEF SUMMARY

The technology is directed to an improved system, apparatus and method for cooling and thermal management of IT equipment in a data center. An improved coolant distribution unit ("CDU") apparatus provides cooling fluid to data racks in a data center. The CDU includes a plurality of modular CDUs ("mCDUs") that provide for modularity of the liquid-cooling system and greater control over fluid flow through the CDU and to the data racks. Cooling system components, such as modular wall manifolds, are also disclosed that allow for modularity of the cooling system. Methods are further disclosed for controlling components within each mCDU to allow for continual modifications to fluid flow through the system to provide optimal cooling of data racks.

According to an aspect of the disclosure, a system for liquid cooling of information technology ("IT") equipment comprises a fluid coolant distribution unit ("CDU"). The CDU further includes a CDU inlet, a facility valve, a CDU outlet, a CDU inlet, a facility supply manifold fluidly, a facility return manifold, a rack supply manifold, a rack return manifold, and a plurality of modular CDUs ("mCDUs"). Facility cooling fluid from a central facility supply line external to the CDU flows through the CDU inlet. The facility valve configured to regulate an amount of cooling fluid from the central facility supply line that flows through the CDU. A CDU outlet may be fluidly coupled to a central rack supply line external to the CDU and a rack cooling fluid may exit the CDU through the CDU outlet and flow to a plurality of downstream data racks fluidly coupled to the CDU. A facility supply manifold may be fluidly coupled to the central facility supply line. The CDU inlet may be positioned between the facility supply manifold and the central facility supply line. The facility return manifold may be fluidly coupled to a central facility return line and the rack supply manifold may be fluidly coupled to the central rack supply line. The CDU outlet may be positioned between the rack supply manifold and the central facility supply line. A plurality of modular CDUs ("mCDU"), each mCDU may include a facility shelf supply line, a facility shelf return line, a control valve, a rack shelf supply line, a rack shelf return line, a pump and a heat exchanger. The facility shelf supply line may be coupled to the facility supply manifold. The facility shelf return line coupled to the facility return manifold. The control valve may be configured to regulate the amount of facility cooling fluid flowing through the mCDU. The rack shelf supply line may be coupled to the rack supply manifold. The rack shelf return line may be coupled to the rack return manifold. The pump may be positioned along the rack shelf supply line. The heat exchanger may be disposed between a first facility cooling loop and a second rack cooling loop. The heat exchanger configured to transfer heat from the rack cooling fluid flowing through a portion of the second rack cooling loop within the mCDU. The facility supply manifold, the facility return manifold, the facility shelf supply line of each of the mCDUs, and the facility shelf return line of each of the mCDUS comprise the first facility cooling loop. The rack supply manifold, the rack return manifold, the rack shelf supply line of each of the mCDUS, and the rack shelf return line of each of the mCDUS comprise the second rack cooling loop. The facility cooling fluid from the first facility cooling loop and the rack cooling fluid from the second rack cooling loop are isolated from one another. The facility shelf supply lines of each of the plurality of mCDUs collectively supply the rack cooling fluid flowing through the rack supply manifold and the CDU outlet to the plurality of downstream racks.

According to another aspect of the disclosure, a method for providing liquid cooling of information technology equipment in a data center comprises adjusting a size of a plurality of valve openings of a corresponding plurality of valves. Each valve corresponds to one of a plurality of modular coolant distribution unit ("mCDU") of a coolant distribution unit ("CDU") and each valve is configured to regulate an amount of cooling fluid flowing through the mCDU. For each of the plurality of mCDUs, the adjusting comprises : obtaining a first facility liquid supply temperature and a second rack liquid supply temperature; determining an approach temperature by obtaining a difference between the first facility liquid supply temperature and the second rack liquid supply temperature; comparing the approach temperature to a predetermined approach temperature setpoint; increasing the size of the opening of the valve when the approach temperature is greater than the predetermined approach temperature setpoint; decreasing the size of the opening of the valve when the approach temperature is less than the predetermined approach temperature setpoint; and making no adjustments to the size of the opening when the approach temperature is equal to the predetermined approach temperature setpoint.

According to an aspect of the disclosure, a system for thermal management of computing devices includes a first facility cooling loop, a second rack cooling loop, and a modular fluid coolant distribution unit ("CDU"). Facility cooling fluid flows through the first facility cooling loop, which includes a central facility supply line and a central facility return line. Rack cooling fluid flows through the second rack cooling loop and includes a central rack supply line and a central rack return line. The CDU distributes rack cooling fluid to a data rack and further includes a facility supply manifold coupled to the central facility supply line, a facility return manifold coupled to the central facility return line, a rack supply manifold coupled to the central rack supply line, a rack return manifold coupled to the central rack return line, and a plurality of micro or compact modular CDU ("mCDU") units. Each mCDU unit further includes a facility shelf supply line that is coupled to the facility supply manifold; a facility shelf return line that is coupled to the facility return manifold; an adjustable control valve that is positioned along the shelf return line; a rack shelf supply line that is coupled to the rack supply manifold; a rack shelf return line that is coupled to the rack return manifold; a pump that is positioned along the rack shelf supply line; and a heat exchanger that is disposed between the first facility cooling loop and the second rack cooling loop. The heat exchanger has a first portion forming part of the first facility cooling loop and a second portion forming part of the second rack cooling loop. Heat from the rack cooling fluid within the second portion of the heat exchanger is transferred to the facility cooling fluid within the first portion of the heat exchanger. The facility supply manifold, the facility return manifold, the facility shelf supply line, and the facility shelf return line collectively form part of the first facility cooling loop. The rack supply manifold, the rack return manifold, the rack shelf supply line, and the rack shelf return line form part of the second rack cooling loop. Facility cooling fluid from the first facility cooling loop and rack cooling fluid from the second rack cooling loop are isolated from one another.

According to another aspect of the disclosure, a method for providing liquid cooling for a data center includes adjusting a valve opening of an mCDU of a CDU of a data center cooling system. The adjusting the valve includes obtaining a first facility liquid supply temperature and a second rack liquid supply temperature; determining an actual approach temperature by obtaining a difference between the first facility liquid supply temperature and the second rack liquid supply temperature; comparing the actual approach temperature to a predetermined approach temperature setpoint; wherein when the actual approach temperature is greater than the predetermined approach temperature setpoint, increasing a size of the opening of the valve; wherein when the actual approach temperature is less than the predetermined approach temperature setpoint, decreasing a size of the opening of the valve; wherein when the actual approach temperature is neither greater or less than the predetermined approach temperature setpoint, the approach temperature is equal to the approach temperature setpoint and the valve may remain the same.

### BRIEF DESCRIPTION OF THE DRAWINGS

The accompanying drawings are not intended to be drawn to scale. Similar reference numbers and designations in the various drawings indicate like elements. For purposes of clarity, not every component may be labeled in every drawing.
FIG. 1 is a block diagram of an example data center according to an aspect of the disclosure.
FIG. 2 is an example cooling system for a set of data racks in the data center of FIG. 1.
FIG. 3 is an example coolant distribution unit for the cooling system according to an aspect of the disclosure.
FIG. 4A is a schematic diagram of components of example coolant distribution unit of FIG. 3 according to an aspect of the disclosure.
FIG. 4B is a schematic diagram of components from an example coolant distribution unit with an example filtration device according to an aspect of the disclosure.
FIG. 4C is a schematic diagram of a pressure drop sensor system according to an aspect of the disclosure.
FIG. 5A is a rear view of the example coolant unit shown in FIG. 3 according to an aspect of the disclosure.
FIG. 5B illustrates an example power distribution unit of FIG. 5A.
FIGS. 5C-5D are example top views of a CDU rack according to an aspect of the disclosure.
FIG. 6A is a schematic example data rack of the example cooling system of FIG. 2.
FIG. 6B is a schematic example server tray according to an aspect of the disclosure.
FIG. 6C is another schematic block diagram showing an example CDU and racks from FIG. 2 according to an aspect of the disclosure.
FIG. 6D is a block diagram illustrating a relationship among different components.
FIGS. 6E-6F illustrate example interconnectors for example leak detection components according to an aspect of the disclosure.
FIG. 7A is a block diagram showing a control system architecture for controlling features of the coolant distribution unit according to an aspect of the disclosure.
FIG. 7B is a flow diagram showing a control system architecture for controlling features of the coolant unit according to an aspect of the disclosure.
FIG. 8A is a flow diagram showing an example method for controlling the valve in a mCDU coolant distribution unit of a coolant distribution unit according to an aspect of the disclosure.
FIG. 8B is a flow diagram showing another example method for controlling the valve in an mCDU of a coolant distribution unit according to an aspect of the disclosure.
FIG. 9A is a flow diagram showing an example method for controlling pump speed of pumps in a micro or modular coolant distribution unit of a coolant distribution unit according to an aspect of the disclosure.
FIG. 9B is a flow diagram showing an example method for controlling pump speed of pumps in an mCDU of a CDU according to an aspect of the disclosure.
FIG. 9C is a flow diagram showing an example method for determining when an mCDU is malfunctioning according to another aspect of the disclosure.
FIG. 9D is a flow diagram showing another example method for determining when an mCDU is malfunctioning according to another aspect of the disclosure.
FIG. 9E is a flow diagram showing another example method for determining when an mCDU is malfunctioning according to another aspect of the disclosure.
FIG. 9F is a flow diagram showing another example method for determining when an mCDU is malfunctioning according to another aspect of the disclosure.
FIG. 10 is an example of a central rack supply line and central rack return line that allows for modularity of the number of racks in a cooling system according to an aspect of the disclosure.
FIG. 11 is an example mCDU according to an aspect of the disclosure.
FIG. 12 shows example components of an example mCDU.
FIGS. 13A-1 and 13A-2 are example manifold adapters coupled to a manifold according to an aspect of the disclosure.
FIGS. 13B-1 and 13B-2 are example manifold adapters coupled to a manifold according to an aspect of the disclosure.

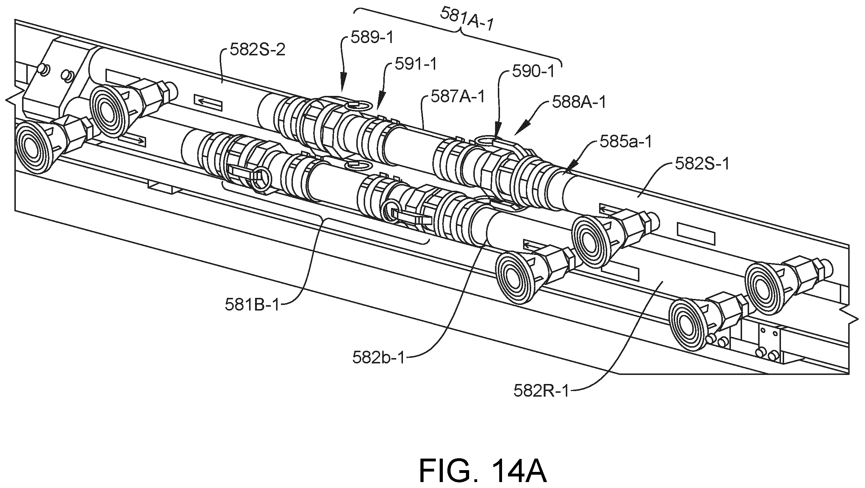

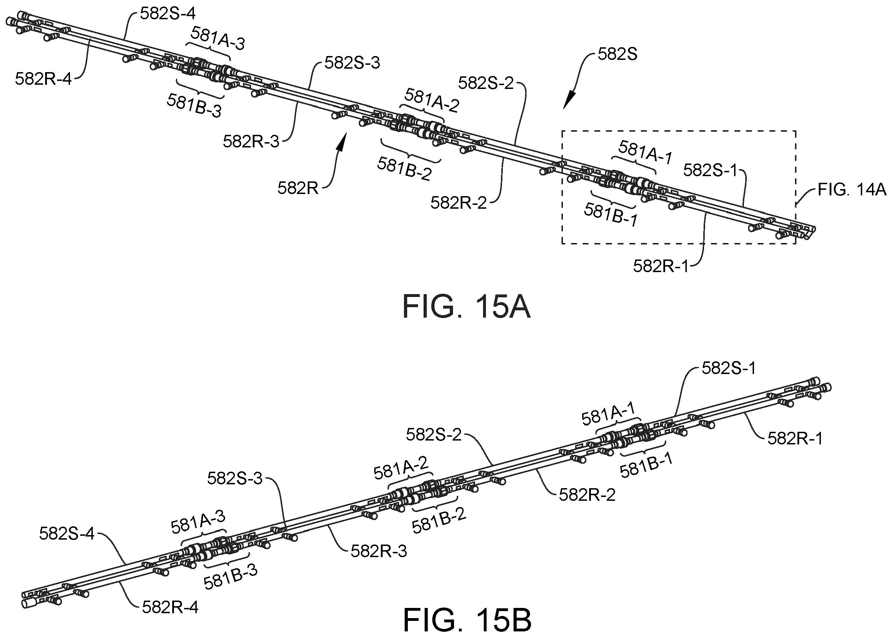

FIG. 14A is an enlarged view of FIG. 15A.

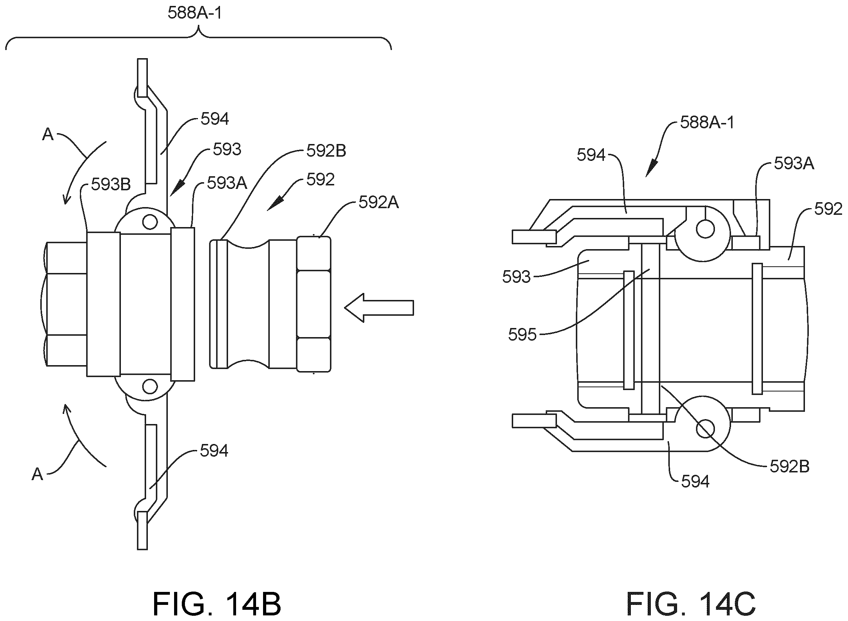

FIGS. 14B-14C are example clamp connectors of a manifold adapter according to an aspect of the disclosure.
FIG. 15A is an example manifold assembly with manifold adapters.
FIG. 15B is another view of the manifold assembly with manifold adapters in FIG. 15A.

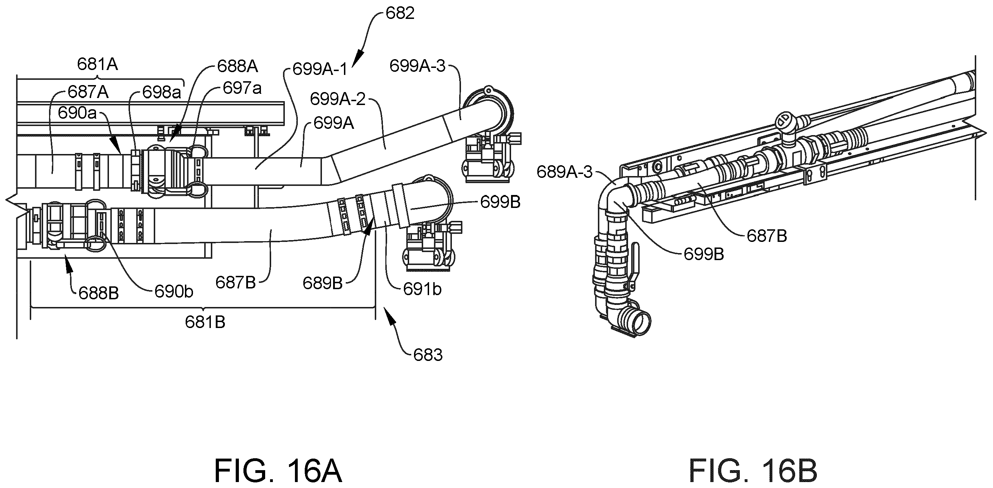

FIG. 16A depicts a portion of an example manifold assembly.
FIG. 16B depicts another view of the manifold assembly of FIG. 16A.

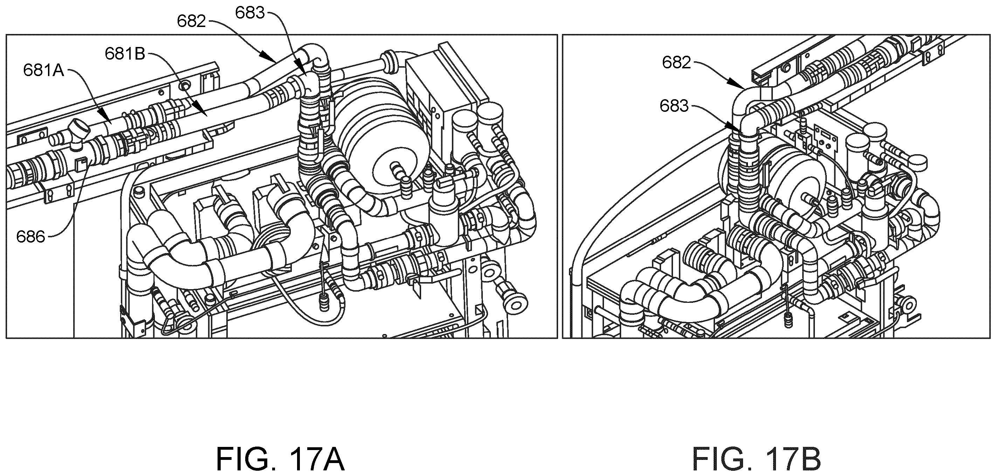

FIGS. 17A-17B depict example components positioned at a top of a central distribution unit according to aspects of the disclosure.

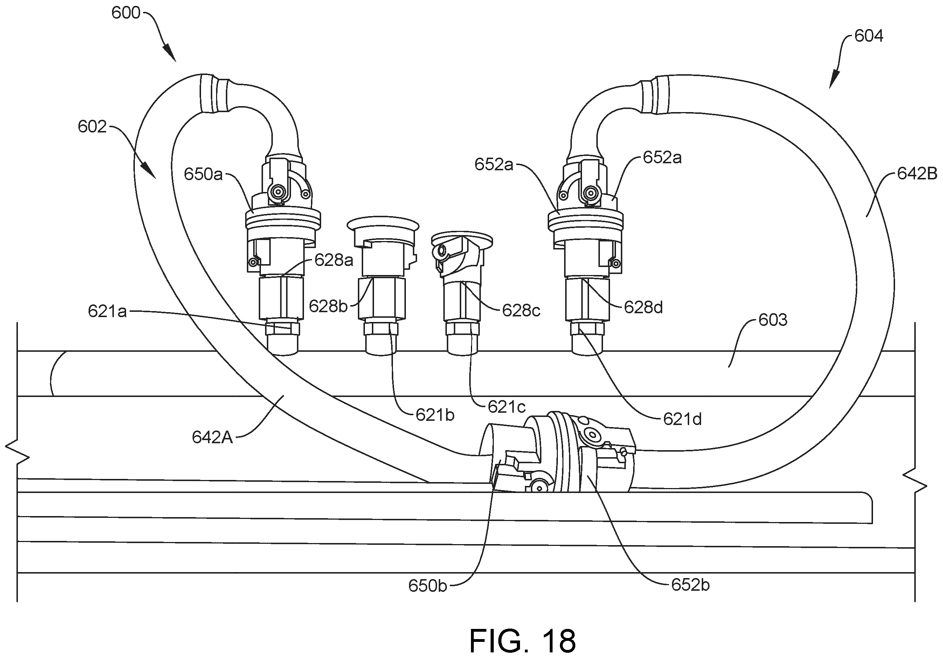

FIG. 18 depicts a section of an example wall manifold assembly with example hose kits.

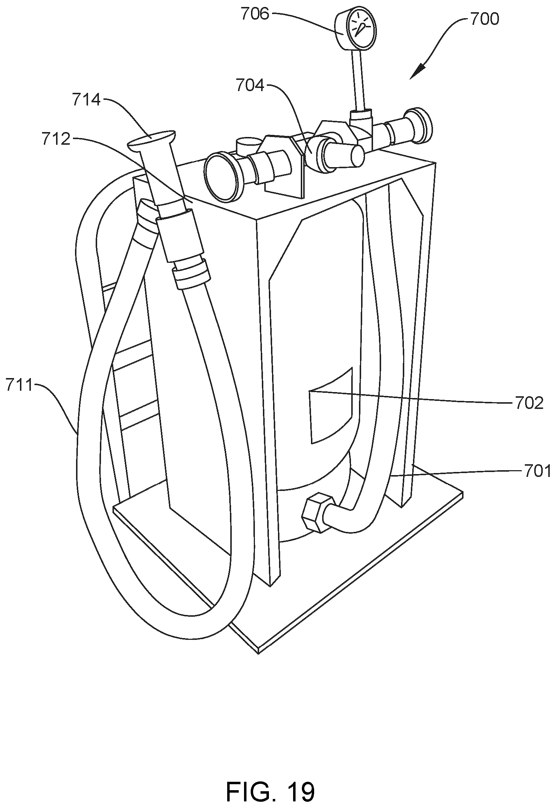

FIGS. 19-21 illustrate example charge tools according to aspects of the disclosure.

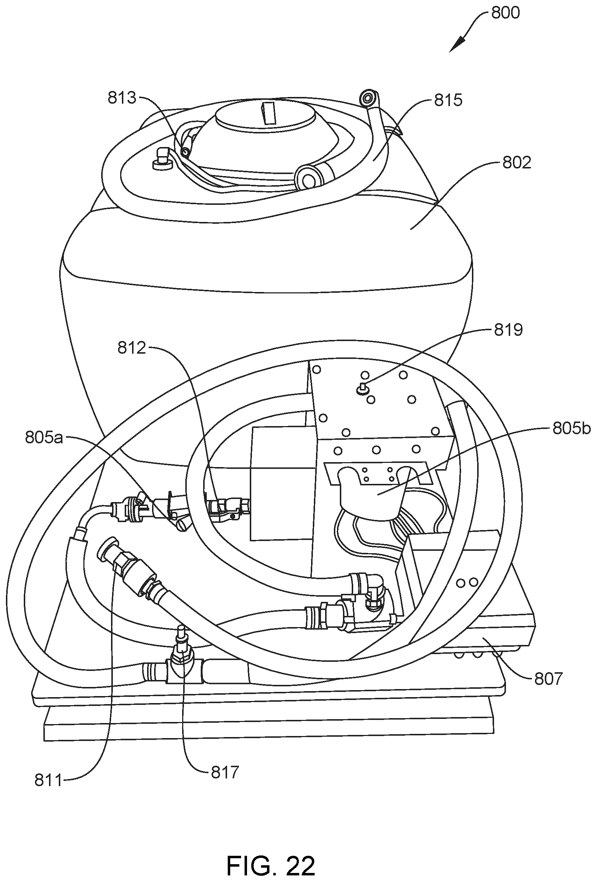

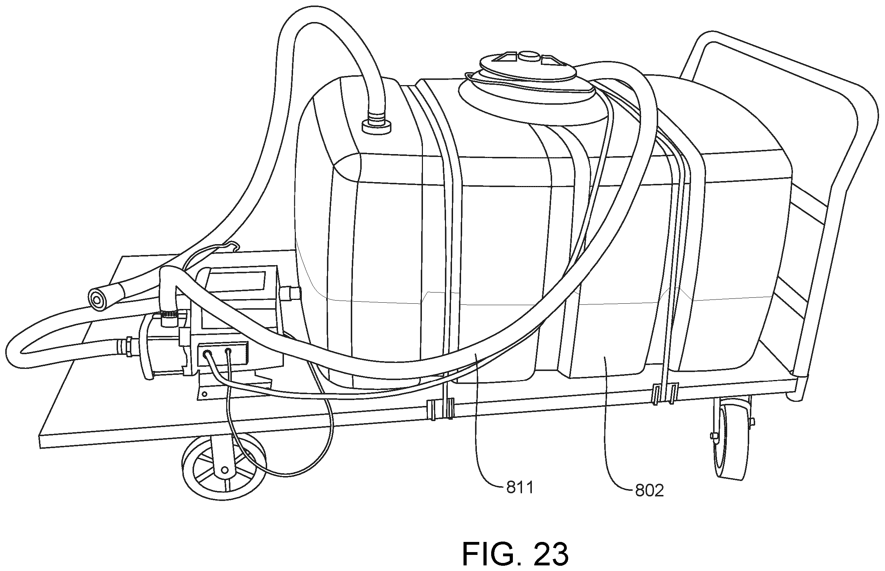

FIGS. 22-23 illustrate an example feeder kit according to an aspect of the disclosure.

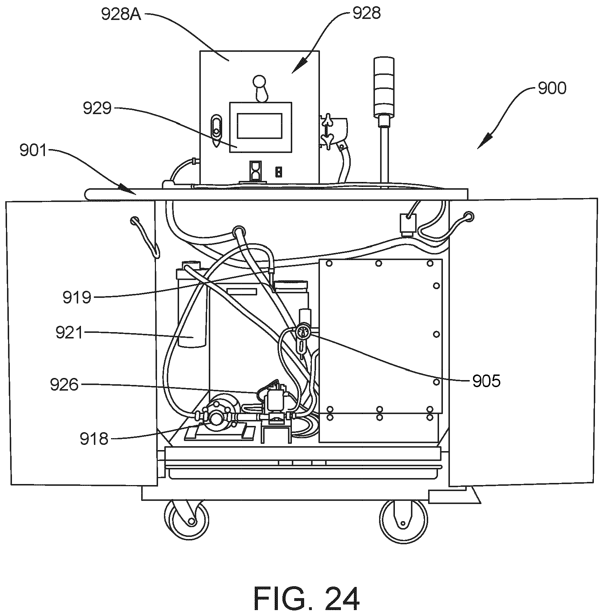

FIGS. 24-26 illustrate an example cold plate loop and rack manifold purge tool according to an aspect of the disclosure.

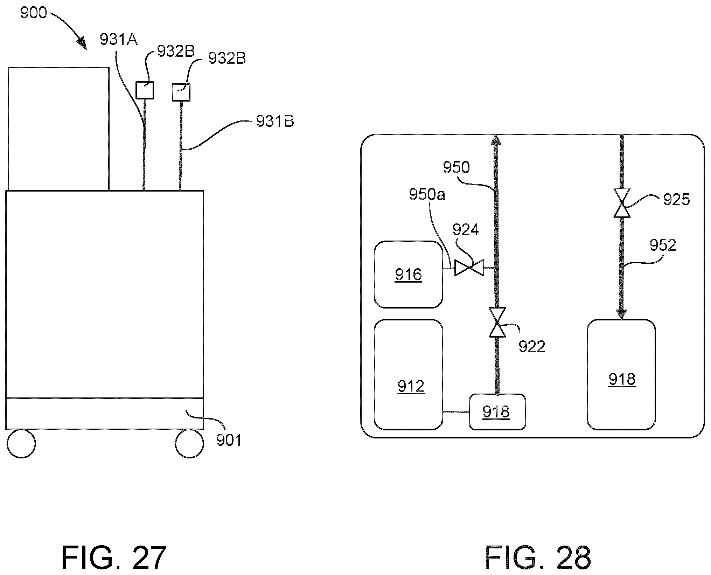

FIG. 27 is a schematic block diagram of the tool of FIGS. 24-26 according to an aspect of the disclosure.
FIG. 28 is a schematic flow diagram showing the interior of the cabinet of the tool of FIGS. 24-26 according to an aspect to the disclosure.

### DETAILED DESCRIPTION

The demand for high power computing ("HPC") systems and HPC chips, including artificial intelligence ("AI") systems and AI chips, to perform modern-day processing of large amounts of data to perform calculations, simulations, and the like, not only places unique challenges on the design, manufacture, and performance of such semiconductor chips and chip packages, but on the cooling systems that are required to dissipate the extremely high-levels of heat generated by and within HPC systems. Liquid cooling systems can be used to dissipate heat generated by HPC systems, including the computing devices and related components housed within data server racks in data centers that house the HPC systems. However, liquid cooled computing devices require higher coolant flow rate to maintain computing performance and system reliability. As chip power increases, liquid flow rate must also increase to keep up with increased heat created by the HPC chips. This can lead to a significant rise in pressure drop through connections for cooling loop assemblies. Further, the pumping power consumed by pressure drop in connectors does nothing to further cooling of the components, and is instead wasted energy needed to overcome friction and flow resistance.

An improved liquid cooling system for supplying cooling fluid to data racks is disclosed. The improved cooling system includes an improved coolant distribution unit ("CDU") that is modular and provides redundancy in the system. Although not required, the CDU may be movable to allow for easy configuration and reconfiguration of CDU and data racks coupled to the CDU, as well as easy repair of the CDU. The configuration of the CDU allows for greater control over cooling of the cooling system, as well as serviceability of the CDU and components within the cooling system.

CDU may include two cooling loops. The first cooling loop supplies facility supply and return fluid. A second and independent cooling loop supplies data rack supply and return cooling fluid. According to an aspect of the disclosure, the CDU is further comprised of several modular CDUs or "mCDUs" that are each coupled to the cooling loops and each have internal cooling loops that process facility supply and return fluid cooling, as well as rack supply and return fluid. Heat exchangers in each of the mCDUs can transfer heat from rack return fluid to facility supply fluid.

The mCDUs comprising CDU can provide improved and effective thermal management of the CDU and overall cooling system. Due to multiple mCDUs in the system, each mCDU can process an overall reduced amount of rack return fluid, as well as be independently controlled such that each mCDU may have different parameters for achieving effective heat exchange within the mCDU. This can provide for a more effective transfer of heat from rack supply fluid within mCDU to the facility supply water. Additionally, as each mCDU may operate independently of one another, while collectively pumping a supply of cooling fluid to rack supply manifold and through the CDU rack outlet, it is possible and easier to control adjustments within each mCDU that can have a greater overall impact on the supply of cooling fluid to the rack manifolds, as well as the cooling of return cooling fluid. Further, redundant mCDUs may be provided in the system, so that if one mCDU malfunctions, it is still possible for the remaining mCDUs to operate so that the CDU can remain in operation without having to take the CDU and data racks coupled to the CDU offline. Malfunction can be defined as when any one mCDU is not operating according to or at a pre-defined parameter. For example, without limitation, malfunction can include when mCDU has a high pressure drop on the rack supply cooling loop, significantly high approach temperature at the rack supply cooling loop, as compared to temperature of cooling fluid entering the overall CDU, or any desired parameter. What qualifies as a malfunction can be determined by the operator or a pre-determined factory setting for the mCDU.

A CDU control system can control the operation of each individual mCDU. The CDU control system can determine the flow rate, pressure and temperature of cooling fluid at various points within the CDU, including at inlet and outlet ports of the two cooling loops of the CDU, along individual mCDU facility supply and return and rack fluid and return loops, or along any desired portion of the CDU. Based on these determinations alone or as part of a consideration of additional features, CDU can provide instructions to each mCDU to increase or decrease pump speed, as well as allow for more or less fluid to flow through an individual mCDU. For example, a CDU control system can provide instructions to each mCDU to modify its valve position and/or pump speed and/or to maintain a current valve position and/or pump speed. Each mCDU may receive the same set of instructions, or one or more mCDUs may receive a different set of instructions, including all mCDUs having a different set of instructions or operating under a different set of parameters. For example, a control unit may determine that because the last mCDU operating in the system needs to have a greater flow rate and pump speed to achieve improved heat exchange of return cooling fluid flowing through this last mCDU, the valve openings and pump speed for the last mCDU operating in the system may be different than that of the first mCDU operating in the CDU that may be positioned closer to the CDU inlet and facility supply manifold inlet line, as well as CDU outlet to the rack manifold outlet line.

Data racks, which are fluidly coupled to the CDU through rack supply and return manifolds, may optionally or additionally include individual rack systems of valves and/or other cooling features downstream of the CDU to further enhance cooling. Improved modular tools or apparatus for filling, charging, commissioning, and/or or discharging cooling fluid from the CDU and/or data racks and/or IT trays within the data racks are also discussed.

The improved system can optionally or additionally provide for the ability to easily reconfigure the wall or rack manifolds coupled to the CDU that extend across the tops of data racks and distribute cooling liquid to each rack manifold. In some examples, manifold couplings allow for modularity of wall manifold, as well as improved connection between manifolds to minimize leaking. According to an aspect of the disclosure, manifold couplings can be used along the rack manifold or wall manifolds to couple sections of manifold together or to close off a wall manifold.

The cooling system disclosed herein described improved individual features, including without limitation, an improved modular CDU and modular wall manifold system, that allow for improved cooling of components within cooling system. The cooling system according to aspects of the disclosure are not required to work together to achieve improved cooling, and can operate individual within any one cooling system or in combination with one another.

### EXAMPLE DATA CENTER SYSTEMS AND COMPONENTS

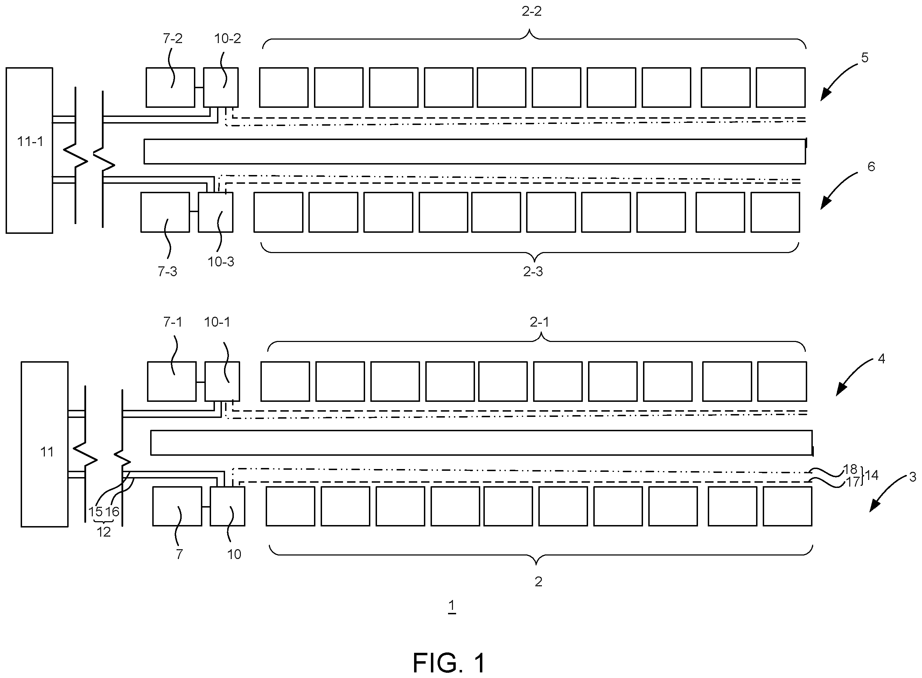

FIG. 1 illustrates a schematic portion of an example data center 1 according to aspects of the disclosure. Data center 1 may include a plurality of information technology ("IT") data racks that are configured to house electronic components, including servers and other computing devices, as well as a liquid cooling system to help ensure that components housed in data racks do not overheat and are maintained at optimal operating conditions. The cooling system can include at least one coolant distribution unit ("CDU") that pumps cooling fluid through data center pipes to individual cooling racks. Each row of data racks may be fluidly coupled to at least one corresponding CDU through data center pipes or manifolds, hose connectors, and/or the like, examples of which will be further described herein. Each CDU can be configured to receive facility cooling fluid from a facility water source that can aid in cooling rack cooling fluid returning to the CDU from the racks through a heat exchanger.

In this example, data center 1 includes a first row 3 of data racks 2 coupled to CDU 10, a second row 4 of racks 2-1 coupled to a CDU 10-1, a third row 5 of racks 2-2 coupled to a CDU 10-2, and a fourth row 6 of racks 2-3 coupled to a CDU 10-3. In this example, each row 3, 4, 5, 6 of racks 2, 2-1, 2-2, 2-3 may be coupled to a corresponding CDU 10, 10-1, 10-2, 10-3 that receives facility water from a facility water or fluid source 11 and also pumps cooling fluid to a plurality of racks in the respective row. Data center 1 may include any number of rows of racks, and each row can include any number of racks within each row. Further, in other examples, one or more of the CDUs can be coupled to racks in different rows. Facility water or fluid source 11 may be a tank exterior to the data center that is either a direct source of facility water or may store facility water on site in a reservoir that feeds each CDU. An uninterruptable power supply ("UPS") 7 may also be coupled to CDU 10 to provide power to CDU 10 when there are power interruptions or the like that may cause the CDU to lose sufficient power to run the cooling system. Similarly, UPS 7-1, 7-2, 7-3 may be coupled to respective CDUs 10-1, 10-2, 10-3. In this example, each UPS 7, 7-1, 7-2, 7-3 is positioned directly adjacent a corresponding CDU 10, 10-1, 10-2, 10-3, but in other examples the UPS may be provided at another location in data center 1.

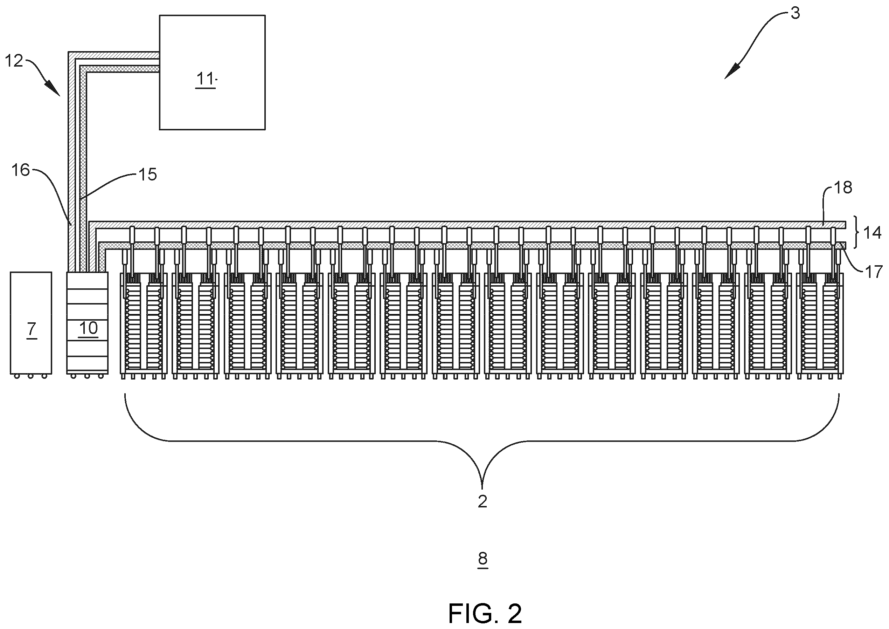

FIG. 2 illustrates an example cooling system 8 for a set of data racks, and particularly row 3 of data center 1, which includes at least ten racks and has been illustrated without the remainder of rows of data racks 2 in data center 1 for ease of illustration and discussion. FIG. 2 further illustrates additional data racks 2 in row 3 of data center 1, but it is to be appreciated that any number of data racks can be implemented and coupled to CDU 10, as shown. CDU 10 is shown connected or coupled to two cooling loops: first facility cooling loop 12 and second rack cooling loop 14. As will be discussed in more detail herein, first facility cooling loop 12 and second rack cooling loop 14 are independent and closed cooling loops, such that facility cooling fluid in first facility cooling loop 12 does not physically mingle or intermix with rack cooling fluid in second rack cooling loop 14 that will be used to cool data racks 2. Instead, the temperature of heated rack cooling fluid from second rack cooling loop 14 will be reduced and cooled down by facility cooling fluid from first facility cooling loop 12 in a liquid-to-liquid heat exchange within CDU 10, as discussed in further detail herein.

First facility cooling loop 12 is a closed loop that fluidly couples CDU 10 with a facility fluid source 11. First facility cooling loop 12 includes central facility supply line 15 and central facility return line 16, as well as additional lines and manifolds local to the CDU 10 that will be further described when discussing CDU 10 in more detail herein. As shown, central facility supply line 15 feeds water from facility fluid source 11 to CDU 10 through first facility cooling loop 12 and central facility return line 16 returns heated facility cooling fluid from CDU 10 back to facility fluid source 11 through first facility cooling loop 12.

Second rack cooling loop 14 is a closed loop that fluidly couples and connects CDU 10 with each data rack 2 in row 3. Second rack cooling loop 14 includes central rack supply line 17 and central rack return line 18, as well as additional lines and manifolds local to the CDU 10 and data racks 2 that will be further described when discussing CDU 10 and data racks 2 in more detail herein. As central rack supply and return lines 17, 18 typically overlie the top surfaces of data racks in a cooling system, such as cooling system 8, central rack supply and return lines 17,18 traditionally extend across and are supported by a shelf or other structure that can be attached to a wall and are also referred to herein as wall manifolds. Central rack supply line 17 feeds cooling fluid into each data rack 2 from CDU 10. Heated rack return cooling fluid exits each data rack 2, and heated rack return cooling fluid flows to CDU 10 through central rack return line 18. Central rack supply line 17 and central rack return line 18 may overlie and extend across tops of each data rack 2, but in other examples, central rack supply line 17 and central rack return line 18 may be positioned adjacent other portions of CDU 10, such as at the sides or rear of racks 2. Second rack cooling loop 14 can include additional lines and manifolds local to the CDU 10 and each data rack 2 and will be further described herein.

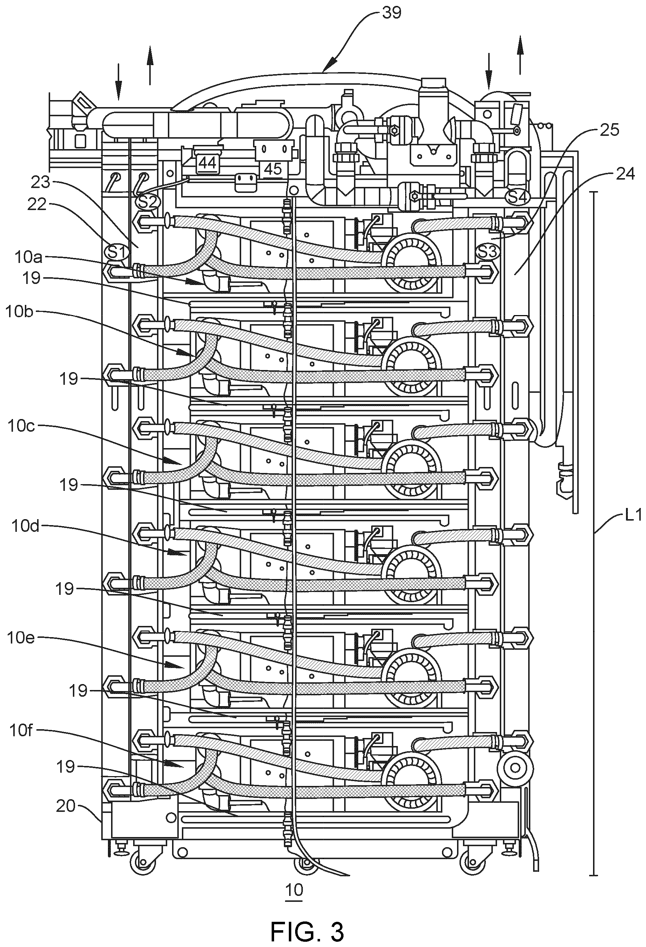

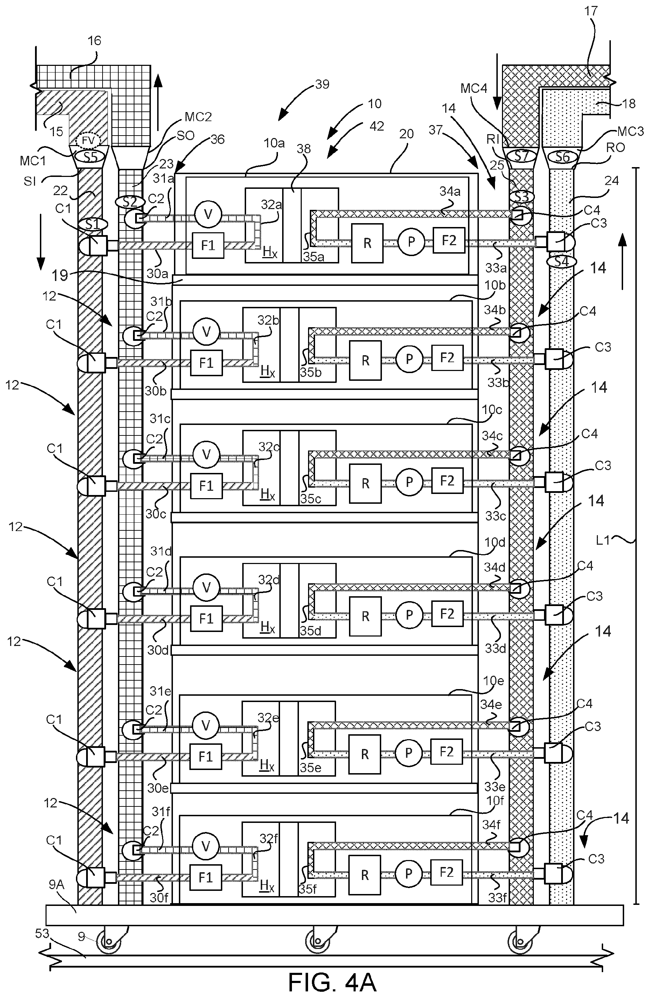

FIG. 3 illustrates an example CDU 10 and FIG. 4A provides a schematic view of some of the components of CDU 10 that illustrates further details to facilitate discussion of the features of CDU 10. As shown in this example, CDU 10 may be modular and movable. In one example, CDU 10 may be a standalone unit comprising a CDU housing 20 with base 9A, wheels 9 coupled to base 53, primary facility supply and facility return manifolds 22, 23 and primary rack supply and rack return manifolds 24, 25. The primary facility supply and facility return manifolds 22, 23 and primary rack supply and rack return manifolds 24,25 may be coupled to CDU housing 20 and movable as part of CDU 10. This can enable movement of CDU 10 along data center floor 53 with ease, which facilitates repair or replacement of CDU 10 or components within CDU 10, as well as reconfiguration of data center cooling system 8, including reconfiguration of data racks to include more or less data racks. Once CDU 10 is positioned at a desired location, primary facility supply and facility return manifolds 22, 23, as well as primary rack supply and rack return manifolds 24,25 can be coupled to the primary facility and return lines 15, 16, as well as the primary rack supply and rack return lines 17,18 through quick disconnects or other couplings. This configuration can provide for a completely movable and modular CDU 10 system that can be easily incorporated into other cooling systems and/or rack configurations. In other examples, the CDU may instead be in a fixed position. Similarly, in other examples, facility supply and facility return manifolds 22, 23 and primary rack supply and rack return manifolds 24,25 may be only fluidly connected with CDU 10 and may not otherwise be coupled to CDU housing 20 or otherwise movable with mCDUs 10a-10f and CDU 10 when relocating CDU 10 or otherwise moving CDU 10.

CDU 10 may be comprised of a plurality of mCDUs 10a, 10b, 10c, 10d, 10e, 10f that are positioned on shelves 19 of CDU housing 20 and that collectively form CDU 10. Each mCDU 10a-10f is coupled to a manifold, which is part of either first facility cooling loop 12 or second rack cooling loop 14. Each mCDU may be coupled to ports of manifolds through hose connectors or similar devices that can couple the mCDU to a manifold and allow for the flow of fluid therethrough. For example, each mCDU 10a-10f is coupled to facility supply manifold 22, facility return manifold 23, rack supply manifold 24, and rack return manifold 25. Each manifold 22, 23, 24, 25 may extend adjacent to and along length L1 of CDU housing 20. In this example, facility supply manifold 22 and facility return manifold 23 are positioned on one side of CDU housing 10 and rack supply manifold 24 and rack return manifold 25 are positioned at an opposite side of CDU housing 20, but in other examples any one of manifolds 22, 23, 24, 25 can be positioned adjacent any side of CDU housing 10.

CDU can include two primary inlets and two primary outlets, which are schematically shown in FIG. 4A. As shown, CDU can include CDU facility supply inlet SI, through which facility supply fluids are fed into CDU; CDU facility supply outlet through which facility return fluid is distributed outside of CDU; CDU rack supply outlet RO through which cooling fluid exits CDU and is fed to data racks; and CDU rack return inlet RI, through which heated cooling fluid returns from data racks and enters CDU for cooling. As shown, CDU facility supply inlet SI may be positioned at an end or portion of CDU facility supply manifold 22 and can be further coupled to facility supply line 15 by manifold coupling MC1. CDU facility supply return outlet SO may be positioned at an end or portion of CDU facility return manifold 23 and can be coupled to facility return line 16 by manifold coupling MC2. CDU rack supply outlet RO may be positioned at an end or portion of CDU rack supply manifold 24 and can be coupled to rack supply line 16 by manifold coupling MC3. CDU rack return inlet RI may be positioned at an end or portion of CDU rack return manifold 25 and can be coupled to rack return 17 by manifold coupling MC4. CDU rack supply manifold 24 may be coupled by manifold coupling MC3 to rack supply line 18.

Facility supply manifold 22 and facility return manifold 23 form part of first facility cooling loop 12, along with facility shelf supply lines 30a, 30b, 30c, 30d, 30e, 30f and facility shelf return lines 31a, 31b, 31c, 31d, 31e, 31f. Each mCDU 10a-10f includes a facility supply coupling C1 that joins facility shelf supply line 30a-30f to facility supply manifold 22. Facility return coupling C2 of mCDUs 10a-10f may join respective facility shelf return line 31a-31f to facility return manifold 23. In some examples, couplings C1, C2 may be quick disconnect couplings to allow for easy repair and maintenance of the mCDUs 10a-10f, but any type of coupling can be implemented.

In this configuration, cooling fluid from facility fluid source 11 travels through central facility supply line 15, through facility supply manifold 22, and into each mCDU 10a-10f through respective facility shelf supply lines 30a, 30b, 30c, 30d, 30e, 30f. Heated facility return cooling fluid will exit each mCDU 10a-10f through facility return manifold 23 and return to facility fluid source 11. The cooling fluid from facility fluid source 11 may be a municipal water supply, but other types of fluids are also contemplated within the scope of the disclosure.

Rack supply manifold 24 and rack return manifold 25 form part of second rack cooling loop 14, along with rack shelf supply lines 33a, 33b, 33c, 33d, 33e, 33f, and rack shelf return lines 34a, 34b, 34c, 34d, 34e, 34f. These components of second rack cooling loop 14 are positioned adjacent secondary or rack supply side 37 of each mCDU 10a-10f. A rack supply coupling C3 at each mCDU 10a-10f may join each rack shelf supply line 33a-33f to rack supply manifold 24. A rack return coupling C4 may join each rack return line 34-34f to rack return manifold 25. In some examples, couplings C3 and C4 may be quick disconnect couplings to allow for easy repair and maintenance of the various mCDUs 10a-10f, but any type of coupling can be implemented. The fluid flowing through second rack cooling loop 14 may be any known cooling liquid and can include, for example, water, deionized water, inhibited glycol and water solutions, dielectric fluids, and any suitable cooling liquid.

Each mCDU 10a-10f supplies cooling fluid to each data rack 2 to cool down components within each data rack 2. Cooling fluid exits each mCDU 10a-10f through respective rack shelf supply lines 33a, 33b, 33c, 33d, 33e, 33f and flows through rack supply manifold 24, through CDU rack supply outlet RO of CDU 10, and through central rack supply line 17,which is coupled to CDU 10. Such rack cooling fluid is at a cool (non or reduced heat) temperature when it exits mCDU 10a, flows to rack supply manifold 24, and through outlet RO of CDU 10. Data racks 2 are each coupled to central rack supply line 17 and receive rack cooling fluid from central rack supply line 17, which then cools down components within each data rack 2. As the cooling fluid reduces the temperature of and around heated components within each data rack 2, the temperature of the cooling fluid increases as heat generated by the electronic components within each data rack 2 is transferred to the cooling fluid. The now heated cooling fluid exits each data rack 2 as a heated return cooling fluid and flows through central rack return line 18, through CDU rack return inlet RI, and returns to mCDU 10a-10f through rack return manifold 25 and respective rack shelf return lines 34a-34f. Heated return cooling fluid will enter each mCDU 10a-10f, where each mCDU will cool down heated return cooling fluid, as described further below. The now cooled cooling fluid can then be supplied back to each data rack 2.

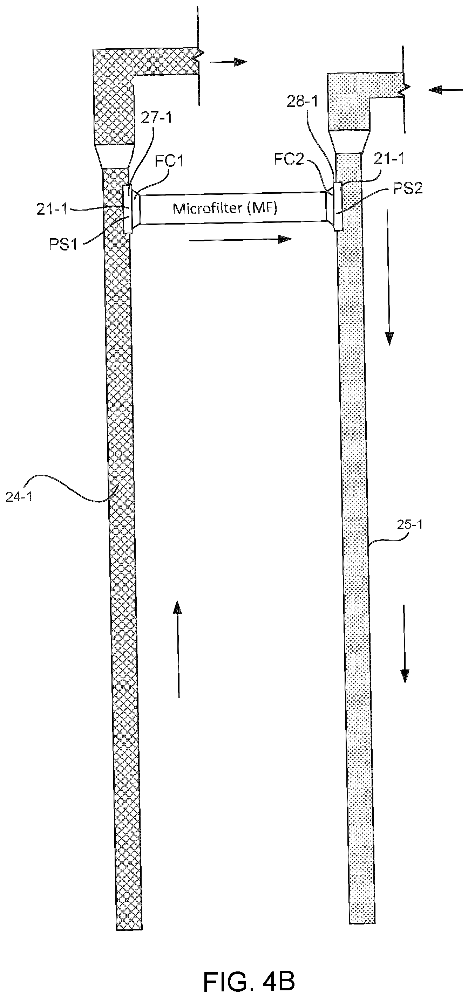

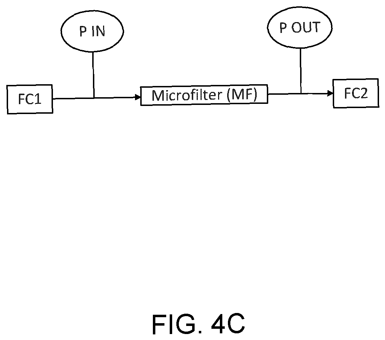

First facility cooling loop 12 and second rack cooling loop 14 are independent of one another, as schematically illustrated in FIG. 4. The following discussion will focus on mCDU 10a for ease of discussion, but it is to be appreciated that each mCDU 10a-10f of CDU 10 may possess identical structure and operate in the same or similar way. As shown, mCDU 10a further includes valve V, first filter F1, second filter F2, heat exchanger Hx, pump P, and optional reservoir R. The mCDU portion of first facility cooling loop 12 is positioned on a primary or facility supply side 36 of mCDU 10 and can further include facility shelf supply line 30a, a facility shelf return line 31a, and a facility transition line 32a. Facility shelf supply line 30a may extend between and be connected to filter F1 and facility shelf return line 31a. Facility shelf return line 31a may extend between and be connected to valve V and facility return manifold 23. Facility transition line 32a may extend between filter F1 and valve V. Facility shelf supply line 30a, facility shelf return line 31a, and facility transition line 32a collectively form a single line with connectors at each end and components, such as valve V and filter F1 along the single line.

Particulates and other solid materials in the facility cooling fluid supplied to mCDU 10a may be filtered out of the facility cooling fluid through filter F1. Valve V can be used to regulate or adjust the overall flow of facility cooling fluid through first facility cooling loop 12. In this example, valve V is shown positioned to control the flow of facility fluid exiting mCDU 10a, but in other examples the valve V may be altematively positioned on a supply side adjacent facility shelf supply line 30a or an additional valve may be positioned along facility shelf supply line 30a. Valve V may be any type of flow control valve that can regulate fluid flow, such as a ball valve or other valve configured to allow for an increase or decrease in fluid flow through the valve. Valve V can be remotely and automatically controlled, as will be discussed in further detail herein.

Various types of valves can be implemented throughout CDU, including within each mCDU. Valve V of each mCDU 10a-10f and facility valve Fv may be any conventional valve configured to regulate fluid flow. Valves can include, without limitation, ball valves and check valves, such as butterfly check valves. For example, without limitation, each valve V may have an adjustable opening and include one or more movable walls or dampers that can increase or decrease the size of the opening. When the size of the opening of control valve V is increased, the flow and amount of facility cooling fluid through valve V also increases. When the size of the opening of valve V is decreased, the flow and amount of facility cooling fluid through valve V also decreases. Valve V can also be remotely and automatically monitored and controlled, as will be discussed in further detail herein.

Second rack cooling loop 14 may be positioned at secondary or rack supply side 37 of mCDU 10a and will supply rack cooling fluid to data racks 2. Second rack cooling loop 14 can further include rack shelf supply line 33a, rack shelf return line 34a, and rack shelf transition line 35a. Rack shelf supply line 33a may extend between and be connected to reservoir R, pump P and filter F2. Rack shelf return line 34a may extend between and be connected to reservoir R and coupling C4 that connects to rack return manifold 25. Rack shelf supply line 33a, rack shelf return line 34a, and rack shelf transition line 35a collectively form a single supply, transition, and return line with connectors C3, C4 at each end, and components, such as valve V and filter F1, disposed along the single line.

Optional reservoir R, pump P and filter F2 may extend along rack shelf supply line 33a. Reservoir R can be used to collect cooled rack cooling fluid in the system that will be pumped through pump P and through filter F2.

Various types of pumps P can be implemented within CDU and each mCDU 10a-10f to accomplish the pumping of rack supply fluid through the system. For example, without limitation, stainless steel pumps, centrifugal pumps, magnetically cooled pumps can be implemented. In one non-limiting example, a seal-less centrifugal pump with a maximum power draw of approximately 2.5 kW can be implemented for use in connection with each mCDU 10a-10f, but other types of pumps and/or pumps with various power draw can be utilized. Additional pumps can also be implemented within the CDU and/or mcDU when necessary to pump facility fluid and/or to supplement the pumps P of the mCDUs. Pumps P can also be remotely and automatically monitored and controlled, as will be discussed in further detail herein.

During operation, facility cooling fluid flows from facility cooling fluid source 11, through central facility supply line 15 and first facility cooling loop 12 into mCDU 10a and through filter F1 through facility shelf supply line 30a on a primary or facility supply side 36 of mCDU 10a. At the same time, heated rack return cooling fluid flows through second rack cooling loop 14 into mCDU 10a through rack shelf return line 34a. First facility cooling loop 12 and second rack cooling loop 14 will both pass through heat exchanger Hx, but the respective facility cooling fluid and rack cooling fluid will not intermingle. As shown, facility cooling fluid in facility transition line 32a flows through heat exchanger Hx to valve V in first facility cooling loop 12, while rack cooling fluid in rack shelf supply line 33a and rack shelf transition line 35a also travels through heat exchanger Hx. Heat from heated rack cooling fluid in second rack cooling loop 14, and in this example rack shelf supply line 33a, is transferred to the facility cooling fluid traveling through facility transition line 32a and heat exchanger Hx. The temperature of facility cooling fluid in facility transition line 32a becomes elevated as heat is transferred to the cooling fluid. In contrast, the temperature of rack cooling fluid in rack shelf transition line 35a is reduced. In this example, one or more copper plates 38 may be positioned within heat exchanger Hx to facilitate liquid-to-liquid transfer of heat from heated rack cooling fluid in second rack cooling loop 14 to facility cooling fluid in first facility cooling loop 12. But, in other examples, different types of heat exchangers and methods of heat exchange may be implemented within mCDU 10a. For example, second rack cooling loop 14, and particularly rack shelf transition portion or line 35a of second rack cooling loop 14, may directly overlie or overlap one another, such that the loops share a common surface between them.

Once heated facility cooling fluid in first facility cooling loop 12 exits heat exchanger Hx, valve V can be used to adjust or control the flow of heated facility cooling fluid through facility shelf return line 31a and into facility return manifold 23, as well as adjust or control the overall flow of facility cooling fluid into mCDU 10a. Rack cooling fluid in second rack cooling loop 14 can exit heat exchanger Hx and flow into reservoir R. Rack cooling fluid will flow to pump P, which pumps rack cooling fluid through filter F2 and into rack shelf supply line 33a and rack supply manifold 24. In other examples, reservoir R may be omitted and cooling fluid exiting heat exchanger Hx may flow directly to pump P.

Each mCDU 10b-10f may be identical to mCDU 10a and include similar features. For example, each mCDU 10b-10f can include a valve V, heat exchanger Hx, first filter F1, optional reservoir R, pump P, second filter F2, facility transition line 32b, 32c, 32d, 32e, 32f, and rack shelf transition line 35b, 35c, 35d, 35e, 35f. In other examples, one or more mCDUs 10b-10f may differ from the structural arrangement of other mCDUs in CDU 10, such that all mCDUs are not identical to one another. As each mCDU 10b-10f in this example operates and includes features identical to mCDU 10a, the details and operation of each mCDU 10b-10f are not discussed for brevity.

During use, all six mCDUs 10a-10f may be operational. However, if one or more of the mCDUs malfunction and/or require maintenance, one or more mCDUs can be taken offline for updates or maintenance while the remaining mCDUs remain operational. In one example, a single mCDU can be taken offline at a given time so that the CDU 10 remains fully operational. This allows for redundancy of the mCDUs and ensures that the CDU 10 and each data rack 2 that is connected to CDU 10 can remain operational and continue to provide sufficient liquid cooling to the data racks. This prevents the need to shut down the entire mCDU and one or more data racks when updates are made to a mCDU. When one or more mCDUs must be taken offline for repairs or maintenance or when one or more of the mCDUs malfunctions and is not operational or not operating at full capacity, the valves in first facility cooling loop 12 of the remaining operational mCDUs and/or the pumps P in the second rack cooling loop 14 of the remaining operational mCDUs can be adjusted to allow for increased facility cooling fluid flow, as well as rack cooling fluid flow to each data rack 2.

CDU 10 may further include telemetry systems that monitor, collect, transmit, receive, and analyze data regarding features or aspects of the cooling fluid entering and exiting CDU 10, as well as aspects of the cooling fluid itself. In this example, CDU 10 includes at least temperature telemetry system 44 and a pressure telemetry system 45. As schematically shown in FIG. 3, temperature and pressure telemetry systems 44, 45 may be positioned toward top portion 39 of CDU 10. The flow rate pressure of cooling fluid exiting CDU 10, as well as the fluid flow rate pressure of cooling fluid exiting each mCDU 10a-10f, can be monitored by pressure telemetry system 45. Such information can help to determine pressure drop across the rack supply side and rack return side of CDU 10 and each mCDU 10a-10f in second rack cooling loop 14. Similarly, the temperature and flow rate of fluid flowing into CDU 10 on the primary side or first facility cooling loop 12, as well as the temperature of fluid flowing out of each mCDU 10a-10f and approaching data racks 2, can be monitored and obtained by temperature telemetry system 44.

As shown in FIGS. 3 and 4A, temperature and pressure telemetry systems 44, 45 may communicate with sensors S1-S4 which are provided on CDU 10, as well as sensors S3, S4 that are provided adjacent each mCDU 10a-10f, to obtain information needed to help maintain a preferred pressure and/or pressure drop and/or temperature of fluid in first and second rack cooling loops 12, 14. Sensors can be used to detect features of cooling fluid and cooling fluid flow that enters and exits each mCDU, as well as overall CDU 10. For example, sensors can be positioned at or adjacent facility supply manifold 22, facility return manifold 23, rack supply manifold 24, and rack return manifold 25 to determine flow rate into and out each mCDU 10a-10f. In an example, sensors S1-S4 may be provided at or near the connections or couplings between each manifold 22, 23, 24, 25 and the corresponding shelf supply lines and shelf return lines to detect at least temperature and/or cooling fluid flow pressure. Sensor S1 may be provided at or near coupling C1 that couples facility shelf supply line 30a to facility supply manifold 22; sensor S2 may be provided at or near coupling C2 that couples facility shelf return line 31a to facility return manifold 23; sensor S3 may be provided at or near coupling C3 that couples rack shelf supply line 33a to rack supply manifold 24; and sensor S4 may be provided at or near coupling C4 that couples rack shelf return line 34a to rack return manifold 25. Sensors S1-S4 can be used to obtain data regarding characteristics of cooling fluid flow through mCDU 10a. In other examples, sensors S1-S4 may be provided at other locations, such as at the top portion 39 of CDU 10 or elsewhere along CDU 10. In this example, sensors S1-S4 can be used by both the pressure telemetry system 45 and the temperature telemetry system 44 to detect various aspects of the fluid flow, such as cooling fluid temperature, cooling fluid pressure, rate of cooling fluid flow, and the like, but in other examples, temperature and pressure telemetry systems 44, 45 may use sensors dedicated to each individual system. Although not shown, sensors S1-S4 may be similarly provided at or near couplings C1-C4 of each of mCDUs 10b-10f.

In this example, temperature telemetry system 44 can monitor, collect, transmit, receive, and analyze data regarding numerous aspects. For example, temperature telemetry system 44 can determine the temperature of facility cooling fluid entering into CDU 10 from central facility supply line 15 into facility supply manifold 22 of first facility cooling loop 12; the temperature of facility supply cooling fluid entering each individual mCDU 10a-10f in first facility cooling loop 12; the temperature of rack supply fluid exiting CDU 10, as well as each mCDU 10a-10f in second rack cooling loop 14. When it may be desired to determine cooling fluid temperature of overall CDU 10, temperature telemetry system 44 may collect data from sensor S5 positioned at the top portion 39 of the CDU 10 adjacent CDU supply inlet SI and manifold coupling MC1 to determine the temperature of facility supply cooling fluid entering CDU 10. Temperature telemetry system 44 can also collect data from sensor S6 positioned at the top portion 39 of CDU 10 adjacent CDU rack outlet RO and at manifold coupling MC3 to determine the temperature of rack supply cooling fluid exiting CDU 10 at rack outlet RO and approaching data racks 2.

Similarly, pressure telemetry system 45 can monitor, collect, transmit, receive and analyze data regarding cooling fluid flow pressure in first and/or second rack cooling loops 12, 14. In one example, pressure telemetry system 45 can collect pressure data of rack supply cooling fluid exiting each individual mCDU 10a-10f in second rack cooling loop 14 and flowing into rack supply manifold 24, as well as pressure data of rack supply cooling fluid exiting rack supply manifold 24 and flowing into central rack supply line 17 and approaching data racks 2, all of which form part of cooling loop 14.

In one example, to determine pressure of overall CDU 10, pressure telemetry system 45 can collect data from sensors at or near CDU housing 10 and in this example, sensors S6 at manifold coupling MC3, which couples rack supply manifold 24 to central rack supply line 17; and sensor S7 at manifold coupling MC4, which couples rack return manifold 24 to central rack return line 18.

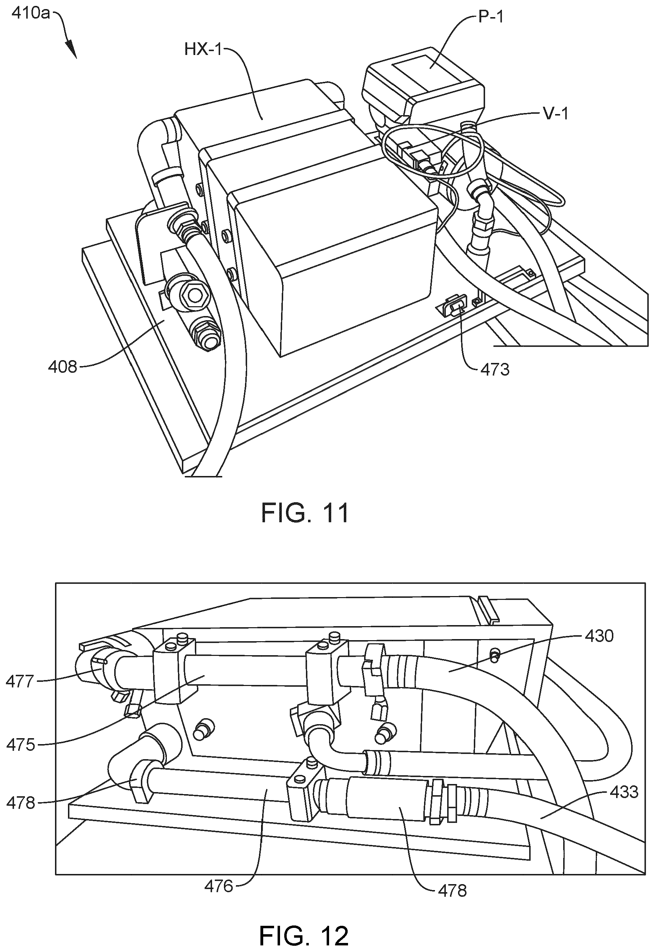

As noted above, impurities, sediment and the like may build up or otherwise be found within cooling fluid. Features can be implemented into the cooling system to help filter such particulates and impurities which can impair operation of mCDU and otherwise affect cooling. For example, as previously noted, filters F1 and F2 may be provided within each of the mCDUs to filter cooling fluid flowing through the mCDU from both the facility supply and return manifolds, as well as rack supply and return manifolds. Example filters can include, without limitation, strainer housings with mesh or microfilters, such as discussed in further detail regarding FIG. 12. Another optional feature to provide improved filtering is the addition of a side stream filter that is positioned between CDU supply and return manifolds. For example, a filter can be positioned laced between rack supply manifold and rack return manifold, as well as or altematively between facility supply manifold and facility return manifold.

FIG. 4B illustrates one example implementation of side stream microfiltration to achieve filtration within facility supply and return manifolds. As shown, a side stream filter or microfilter MF may be placed between rack supply manifold 22-1 and rack return manifold 23-1. Microfilter MF may be a pipe or tubing with microfilter mesh therein and through which cooling fluid must flow. Various sizes of microfilters can be implemented, but in one example, microfilter size is 0.2 microns to ensure that bacteria can be filtered from the coolant. Microfilter MF may have a first filter coupling FC1 at a first end that couples to a port on rack supply manifold 22-1, as well as a second coupling FC2 at a second end that couples to rack return manifold 24-1. First and second couplings FC1, FC2 may be dripless quick disconnects to enable hot swapping for maintenance.

During operation of cooling system, cooling fluid will be pumped to each of the mCDUs coupled to the rack supply manifold 24-1. Some of the cooling fluid will pass through to the outlet of CDU and proceed to supply cooling fluid to the racks in the system. Some of the cooling fluid will also pass through microfilter MF. As cooling fluid exits microfilter MF, filtered cooling fluid will then flow into rack return manifold 25-1, which will then flow into each of the mCDUs to which rack return manifold 25-1 is coupled.

FIG. 4C provides a schematic arrangement showing implementation of a monitoring system that provides pressure drop information to an operator. In one example, pressure drop sensors PS1 and PS2 may be positioned at the respective inlet 27-1 and outlet 28-1 of microfilter MF to measure pressure at inlet 27-1 and pressure drop at outlet 28-1. When a pressure drop threshold is exceeded, a maintenance alert can be triggered to notify the operator that the pressure drop threshold has been exceeded.

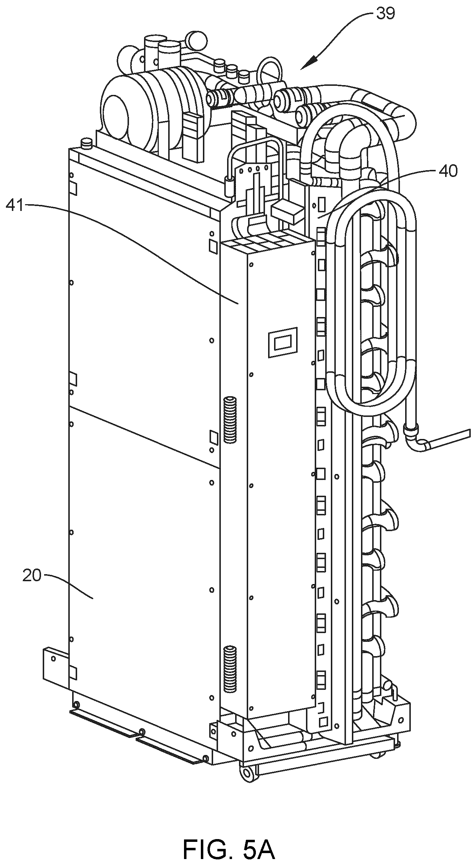

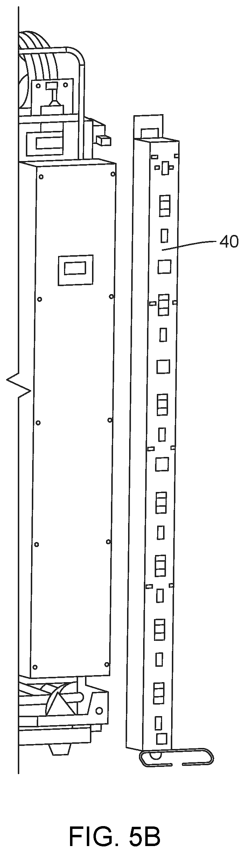

Additional components to assist with operation of CDU 10 can be provided adjacent CDU housing 20, such as a power supply system, such as a distribution unit ("PDU") and a program logic controller ("PLC"), but in other examples, these or additional components may be directly incorporated into CDU 10 and/or CDU housing 20. A PDU may be implemented to control electrical power to CDU 10 and data racks. FIGS. 5A-5B illustrates an example PDU 40 that allows for the management and distribution of electricity to CDU 10 and data racks 2. FIG. 5B illustrates PDU 40 separated from CDU housing 20 for better illustration. PDU 40 can be provided on or adjacent any surface of CDU 10, such as on one of the side or rear surfaces. In this example, PDU 40 is positioned along a side surface of CDU 10. PDU 40 can further include electrical outlets, as well as switches to power CDU 10 on and off. The PDU 40 power source may be a utility power source or other secondary power source. An uninterruptible power supply ("UPS") 7, as shown in FIGS. 1-2, can provide a backup power source for PDU 40 and CDU 10.

A programmable logic controller ("PLC") may be housed in a PLC unit housing 41 that is mounted to CDU housing 20 or it may be positioned anywhere along cooling system or within the data center. An example PLC 42 may include at least a central processing unit or other computing components that will assist with controlling rack and facility cooling fluid flow through CDU 10. In this example, PLC 42 can control the overall cooling fluid flow into and out of CDU 10 through first facility cooling loop 12 and second rack cooling loop 14. PLC 42 can communicate with temperature telemetry system 44 and pressure telemetry system 45 to aid with determining conditions of cooling fluid flowing through CDU 10 and each mCDU 10a-10f, as well as communicate with each individual mCDU 10a-10f. PLC 42 may determine whether adjustments need to be made to the system to increase or decrease cooling fluid flow and temperature of rack supply cooling fluid or facility supply cooling fluid.

For example, as will be discussed in more detail below, PLC 42 can be used to control the flow of facility cooling fluid through first facility cooling loop 12 by controlling the size of the opening of valve V in each mCDU 10a-10f, which further controls the flow of heated facility cooling fluid through facility shelf return lines 31a-31f, facility return manifold 23, and central facility return line 16. Flow of facility cooling fluid at each valve V in each mCDU 10a-10f will also impact the flow of facility cooling fluid through the remainder of first facility cooling loop 12, including flow of facility cooling fluid from facility fluid source 11 and through central facility supply line 15, facility supply manifold 22, and facility shelf supply lines 30a-30f.

PLC 42 may further control the flow of rack supply fluid through second rack cooling loop 14 by controlling the pump speed for each pump P in each mCDU 10a-10f, which further controls the flow of cooled rack supply cooling fluid through rack shelf supply lines 33a-33f, rack supply manifold 24, and central rack supply line 17. Pump speed for each pump P will further impact flow through the remainder of second rack cooling loop 14, including flow of heated cooling fluid from data racks 2 through central rack return line 18, rack return manifold 25, and rack shelf return lines 34a-34f.

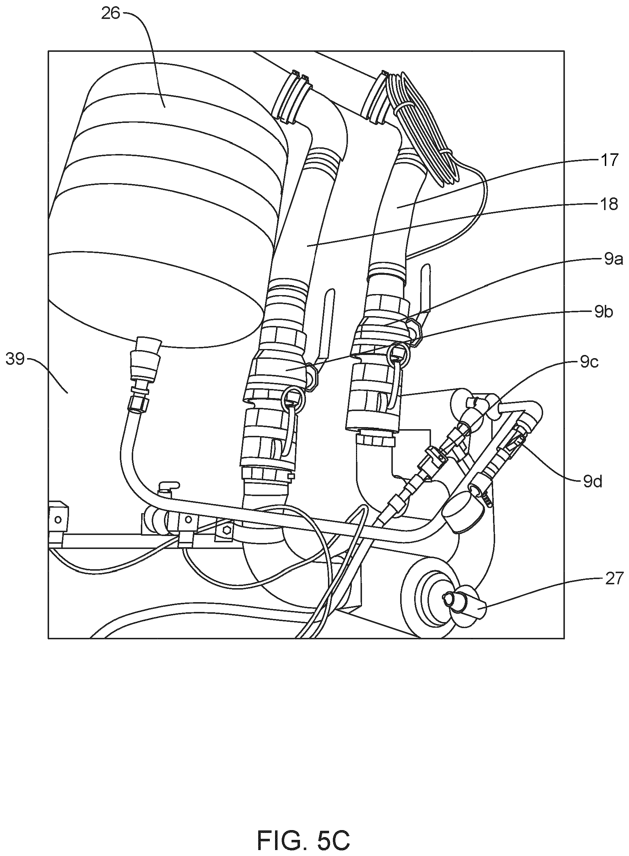

FIGS. 5C-5D illustrate two example configurations of features that can be implemented in connection with a CDU and the overall cooling system, which in this example can be positioned at top portion of CDU unit 10. FIG. 5C illustrates a portion of top portion of a CDU, such as CDU 10. Such features can include telemetry that measures and transmits data about performance of various aspects of CDU 10. A bladder or expansion tank 26, central rack supply line 17-1, and central rack return line 18-1 are shown, such as those previously described herein. Additionally, a rack water supply ("RWS") valve 9a, a rack water return ("RWR") valve 9b, an RWS purge valve 9c, and an RWR purge valve 9d may be included. Such valves can help to control flow of fluid through the lines to which the valves are attached. An example air separator 27 may be used to remove air from the central rack supply line 17-1 and/or central rack return line 18-1.

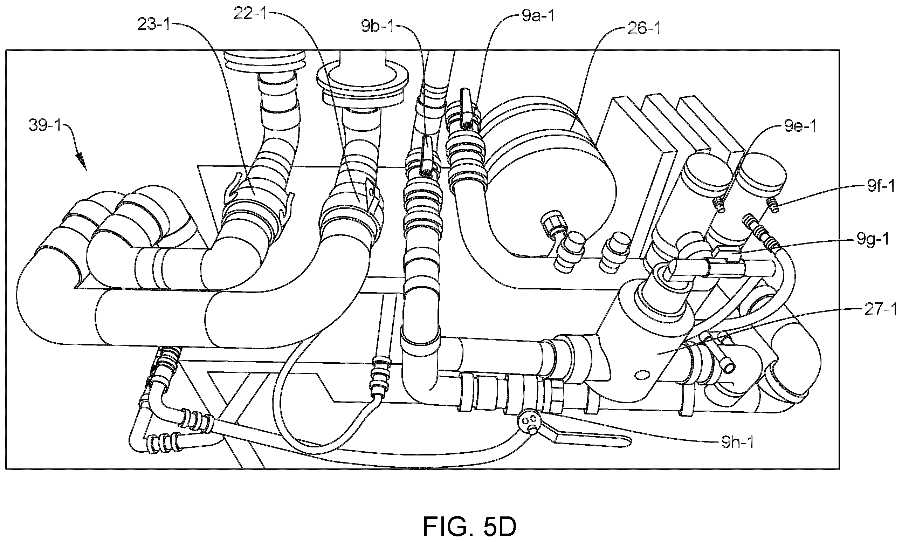

FIG. 5D depicts another example arrangement of features that can be implemented and arranged at a top of a CDU unit, such as CDU 10. The same or similar features can be implemented, as previously described. For example, features may include telemetry that measures and transmits data about performance of various aspects of CDU 10, as well as a bladder or expansion tank 26-1. An RWS valve 9a-1, an RWR valve 9b-1, an RWS purge valve 9c-1, and an RWR purge valve 9d-1 may be included. RWS purge port 9e-1, RWR purge port 9f-1, and cap valve 9g-1 are shown. An example air separator 27-1 may also be used to remove air from the central rack supply line 17-1 and/or central rack return line 18-1. Air separator main valve 9h-1 can also be used to control flow of air through the line. In this view, facility supply line 22-1 and facility return line 23-1 can be seen.

In both examples shown in FIGS. 5C-5D, removing air from these lines, including through use of expansion tanks 26, 26-1 and air separators 27, 27-1, can help to reduce corrosion, reduce noise, and improve heat transfer. For example, the air bladders can function as a fluid reservoir and absorb expansion and contraction of fluid caused by temperature change, such as when fluid in the system increases in temperature. This allows for the capture and release of air bubbles, while also maintaining system pressure. reservoir for coolant, absorbing expansion and contraction due to temperature changes and helping to maintain system pressure, effectively trapping and removing air bubbles. Notably, in this example, only one air separator 27-1 is provided in the overall cooling system, as opposed to prior systems where air separators are provided at multiple points along the cooling loops. Providing only one air separator can help to eliminate points of leakage along the cooling loops.

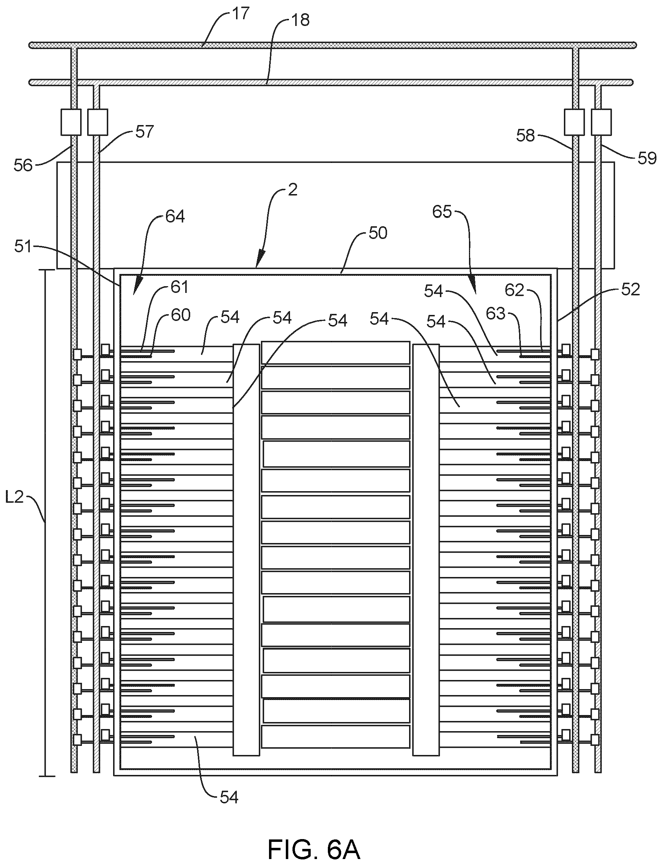

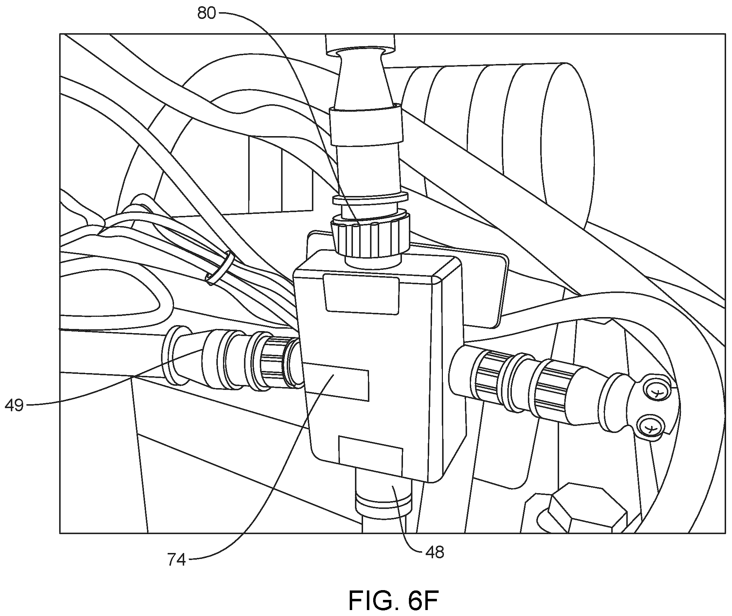

FIG. 6A illustrates a schematic diagram of an example data rack 2 of data center 1. As shown, data rack 2 includes a rack housing 50 with a first side 51 and a second side 52. A plurality of movable shelves or trays 54 overlie one another along length L2 of rack housing 50. As shown, rack cooling liquid flows into data rack 2 from CDU 10 through central rack supply line 17, which is coupled to a first data rack housing supply manifold 56 and a second data rack housing supply manifold 58 which in this example, are respectively positioned adjacent first side 51 and second side 52. Heated rack cooling liquid is returned to central rack return line 18 through first data rack housing return manifold 57 and second data rack housing return manifold 59, which in this example are positioned adjacent respective first side 51 and second side 52.

A first set 64 of trays 54 are positioned adjacent first side 51 of housing 50 and a second set 65 of trays 54 are positioned adjacent second side 52 of housing 50. Each tray 54 is configured to house or support one or more computing devices 55, such as microelectronic assemblies, including chips, such as semiconductor chips, or other devices (not shown) on a circuit board of a computing device 55.

Each computing device may be coupled to at least one cooling device, such as a cold plate. As will be discussed in more detail, each cold plate in first set 64 of trays 54 is coupled to the first data rack housing supply manifold 56 through a first tray supply line 60, as well as coupled to the first data rack housing return manifold 57 through first tray return line 61. Similarly, each computing device in second set 65 is coupled to second data rack housing supply manifold 58 through a second tray supply line 62, as well as coupled to the second data rack housing return manifold 59 through a second tray return line 63.

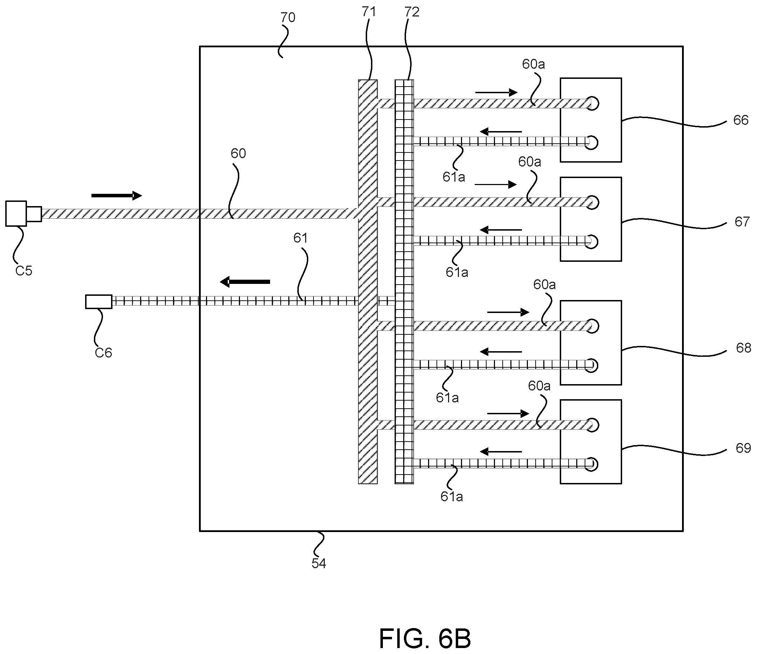

FIG. 6B illustrates an example tray 54 from first set 64 of trays 54. All trays 54 in both first and second sets 64 and 65 can include a same or similar configuration, such that only one tray 54 is discussed in detail. Four computing devices (not visible in this view) may be bonded to a circuit board 70 and four corresponding cooling devices 66, 67, 68, and 69 may be coupled to each computing device. Circuit board 70 may include a motherboard, main board, or the like. Each cooling device 66, 67, 68, 69 can receive rack cooling fluid from first data rack housing supply manifold 56. Rack supply cooling fluid may enter tray 54 through first tray supply line 60. As shown, first tray supply line 60 has a first end with a coupling C5 that can be coupled to first data rack housing supply manifold 56. The other end of first tray supply line 60 first intersects with board supply manifold 71, which is an elongated manifold that can collect rack supply cooling fluid along a length of board 70 and further disperses rack supply cooling fluid to each cooling device 66, 67, 68, 69 through respective tray supply lines 60a. Rack cooling fluid within each cooling device 66, 67, 68, 69 can cool down or reduce the temperature of each computing device. In one example, heat from computing devices may be transferred to the rack cooling fluid. Rack cooling fluid, now heated, will exit each cooling device 66, 67, 68, 69 through respective tray return lines 61a. Tray return line 61a will intersect board return manifold 72 and heated rack cooling fluid will exit tray 54 through first tray return line 61, which is coupled to first data rack housing return manifold 57 with a coupling C6. In this example, couplings C5, C6 may be quick disconnect couplings, but in other examples, other types of connectors may be used. FIG. 6B illustrates one example configuration for a tray housing computing devices and cooling devices, but numerous other configurations are contemplated within the scope of the disclosure.

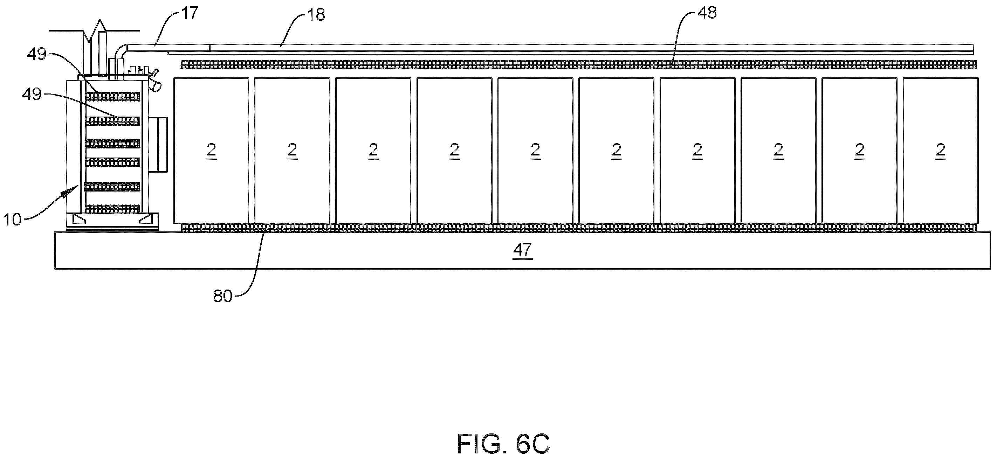

Leak detection components and features can be implemented into the overall cooling system. FIG. 6C illustrates the portion of row 3 (FIG. 1) that includes CDU 10, racks 2, and central rack supply line 33 and central rack supply line 34 (both of which can also form part of a wall manifold). Leak detection cables can be implemented at or near areas where leaks are likely to occur. For example, as shown in FIG. 6C, a first rack leak detection cable 80 may be provided along the data center floor 47 either adjacent to or underneath racks 2. A second leak detection cable 48 may be provided in the area underneath the central rack supply line 17 and central rack return line 18. Additionally, leak detection cables 49 may be provided at each mCDU to detect leaks from either the first or second cooling loops 12, 14. In some examples, the leak detection cables can be standard cables or ropes with sensors.

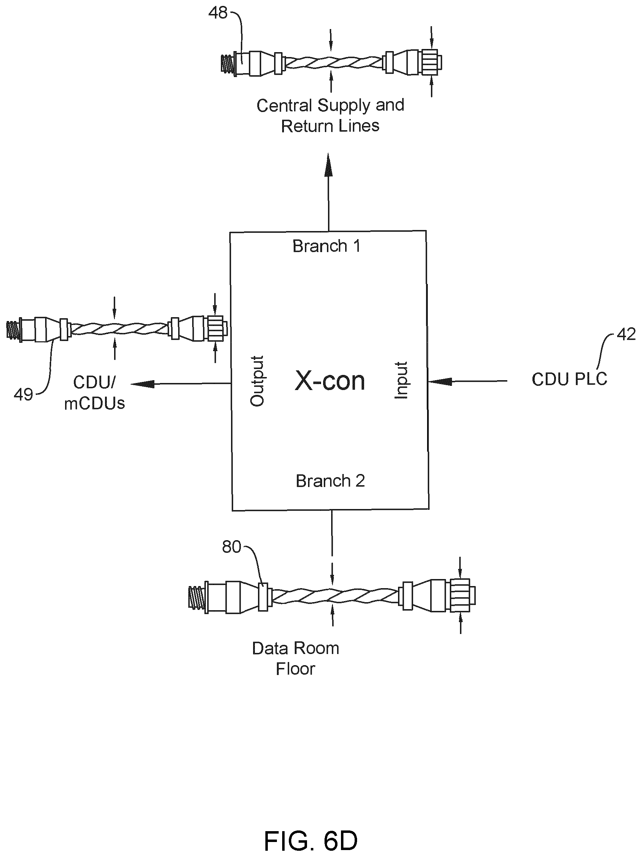

The leak detection cables may include sensors to detect the presence of water leads and other fluids. Depending on the location of the sensors, the leak detection cables can be configured to detect water at a zero height, with water sensors facing and making contact with the data room floor, or a greater height. As shown in FIG. 6D, PLC 42 may be in communication with first leak detection cable 80, which is adjacent data room floor, second leak detection cable 48, which is adjacent central supply and return lines, and CDU leak detection cable, such as an mCDU leak detection cable 49. When the leak cables detect a leak, PLC 42 can issue instructions to address the leak. For example, PLC 42 may instruct the preparation of an alert to the operator that a leak has been detected. Depending on the amount of detected fluid, PLC 42 may further adjust flow to minimize flow through the area while it is repaired. For example, PLC 42 may directly communicate with mCDUs 49. Additionally or alternatively, the CDU PLC may communicate with each of the leak detection cables and send a notification to an operator when leaks are detected.

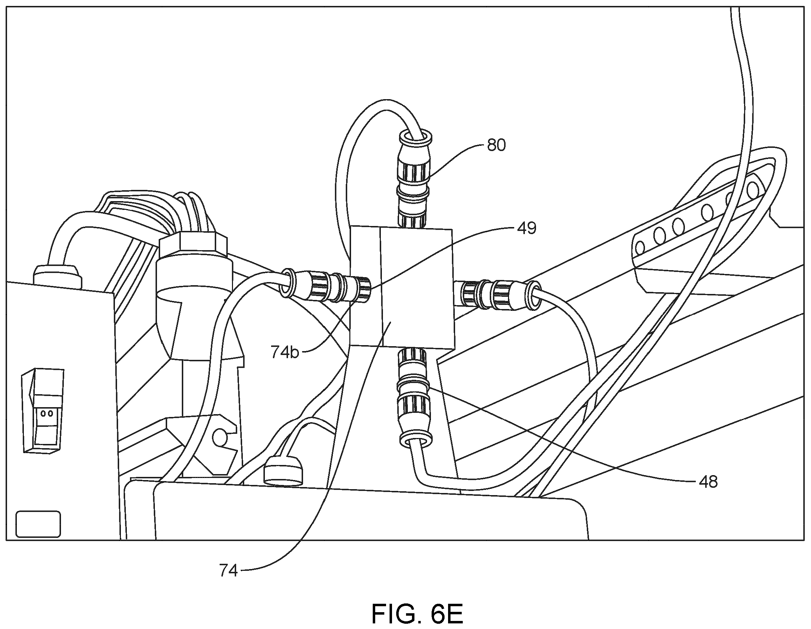

FIGS. 6E-6F shows an example top view of CDU housing 20. An example interconnection 74 is depicted with housing 74a with ports 74b or connectors at each of its sides. First leak detection cable 80, second leak detection cable 48, and CDU leak detection cable 49 intersect with one another and couple to interconnection 74.

### EXAMPLE CONTROL SYSTEM AND METHODS FOR REGULATING FLUID FLOW RATE AND TEMPERATURE IN THE DATA CENTER

The cooling of computing components and devices on data racks in the data center can be accomplished, in part, by ensuring that a sufficient amount of facility cooling fluid and rack cooling fluid flows through and out of CDU 10, and that rack supply cooling fluid flows from CDU 10 to data racks at a sufficient flow rate and temperature. At least two features of each mCDU 10a-10f of CDU 10 - control valve V in first facility cooling loop 12 and pump P in second rack cooling loop 14 - may be controlled and adjusted throughout operation of the CDU 10 and the overall cooling system, such as cooling system 8, to ensure that an adequate amount of facility cooling liquid flows through first facility cooling loop 12 to regulate the temperature of rack supply cooling fluid being fed to data racks provide optimal cooling. In some examples, the size of the opening in valve V can be adjusted and/or the pump speed of pump P may be adjusted.

Turning first to control valve V, as previously discussed, valve V is positioned on facility cooling fluid side along first facility cooling loop 12 of each mCDU 10a-10f of CDU 10. Each control valve V of each mCDU 10a-10f of CDU 10 can be adjustable to allow for a variation in the amount of facility cooling fluid (supply and return) flowing through valve V and first facility fluid cooling loop 12. For example, each valve V may have an adjustable opening and include a movable wall that can increase or decrease the size of the opening. When the size of the opening of control valve V is increased, the flow and amount of facility cooling fluid through valve V also increases. When the size of the opening of control valve V is decreased, the flow and amount of facility cooling fluid through valve V also decreases.

In some examples, a second valve, such as a facility valve Fv may be additionally provided somewhere along the portion of first facility cooling loop 12 between facility fluid source 11 and mCDUs 10a-10f. In one example, facility valve Fv can be positioned between CDU supply inlet SI of CDU 10 and central facility supply line 15. For example, facility valve Fv can be provided at or near CDU facility supply inlet SI adjacent manifold coupling MC1 (FIG. 4), which couples fluid supply manifold 22 to central facility supply line 15. Facility valve Fv can help to further regulate the overall amount of facility fluid flowing into CDU 10 and each mCDU 10a-10f. In other examples, it may be desired to position facility valve Fv to another location along the facility supply cooling loop, such as but not limited to closer to facility fluid source 11 or directly along facility fluid supply manifold 22. In still other examples, it may be desired to position facility valve Fv along fluid return manifold 23 or central facility return line 16 or alternatively, in addition to facility Fv, a second facility valve may be provided somewhere along fluid return manifold 23 or central facility return line 16.

In addition to controlling valve V of each mCDU 10a-10f and facility valve Fv, the pump speed of pump P for each mCDU 10a-10f can be controlled and modified during operation of the CDU 10 to obtain a desired flow speed of rack supply cooling fluid through data racks 2. Pump P may be positioned along second rack cooling loop 14 and, in this example, pump P is positioned just prior to rack shelf supply line 33. Pump P will pump rack cooling fluid through rack shelf supply line 33 to rack supply manifold 24. The speed of pump P can be modified during operation of the CDU to increase or decrease the speed of pump P and to maintain a desired flow rate of rack cooling fluid to data racks 2.

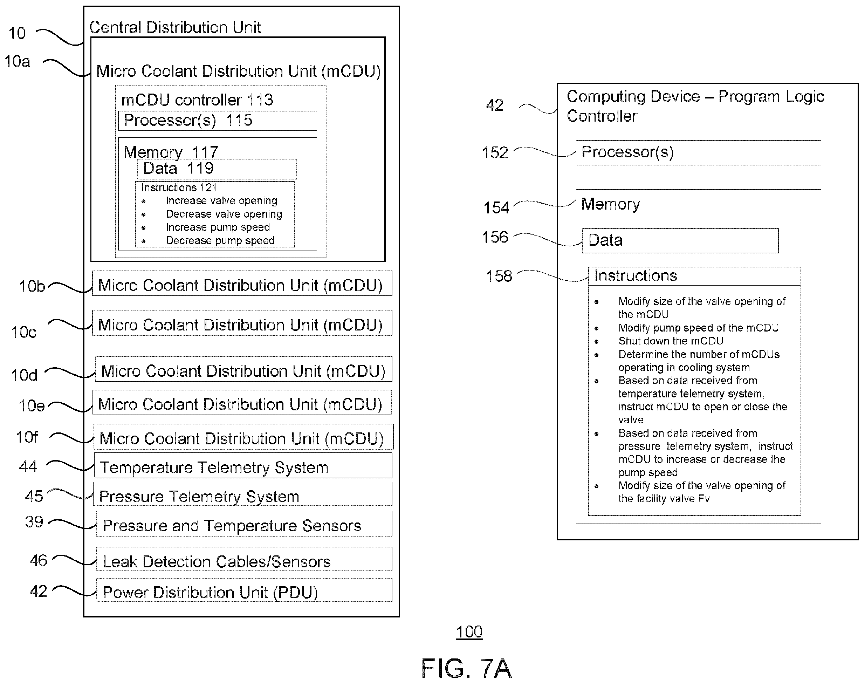

FIG. 7A illustrates an example control system 100 in which the features described above and herein may be implemented. Example control system 100 should not be considered as limiting the scope of the disclosure or usefulness of the features described herein. As shown in this example, system 100 can include CDU 10 and PLC 42. CDU 10 further includes a plurality of mCDUs 10a-10f that are similar to and arranged as previously described herein. Due to the number of mCDUs in the CDU 10, for ease of illustration, only the features of 10a are fully shown, but it is to be understood that each additional mCDU 10b-10f includes similar features. CDU 10 may further include temperature telemetry system 44 and pressure telemetry system 45, which can obtain, store, and analyze information about current cooling fluid temperature and cooling fluid flow rate in the system. Sensors 39, which also includes sensors S1-S7, can provide information about fluid flow, including without limitation, temperature and pressure, to temperature telemetry system 44 and pressure telemetry system 45.

Each mCDU 10a-10f can communicate with mCDU controller 113 that is directly or wirelessly coupled to computing device or PLC 42, including via short-range communication. mCDU controller 113 can be any computing device or accessory and may be directly provided within each mCDU 10a-10f or positioned external to mCDU 10a-10f, such as including, but not limited to anywhere else within cooling system and/or within a data center control room.

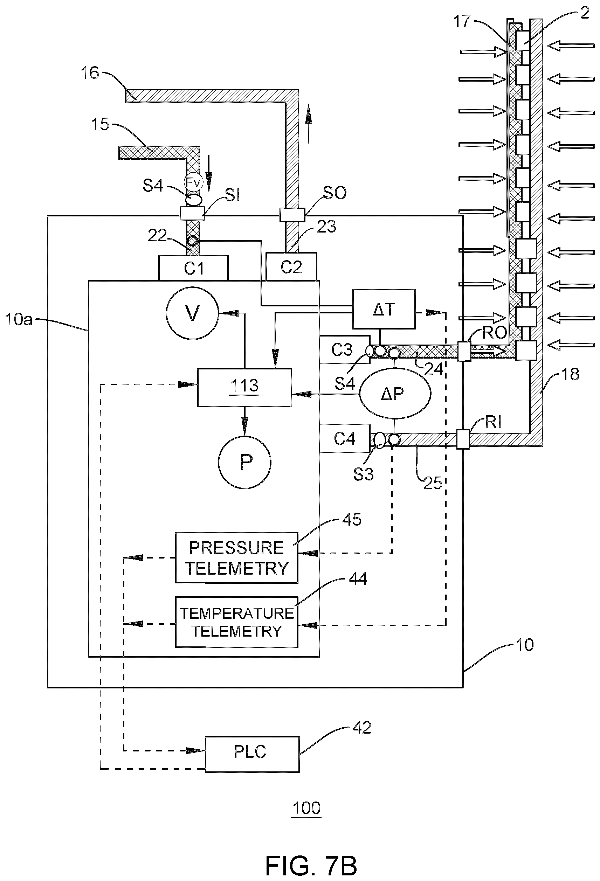

One or more processors 115 may be any conventional processors, such as commercially available microprocessors. Alternatively, the one or more processors 115 may be a dedicated device such as an application specific integrated circuit (ASIC) or other hardware-based processor. Although Figure 7B functionally illustrates the processor, memory, and other elements of mCDU controller 113 as being within the same block, it will be understood by those of ordinary skill in the art that the processor, computing device, or memory may actually include multiple processors, computing devices, or memories that may or may not be stored within the same physical housing. Similarly, the memory may be a hard drive or other storage media located in a housing different from that of computing device. Accordingly, references to a processor or computing device will be understood to include references to a collection of processors or computing devices or memories that may or may not operate in parallel.

Memory 117 of each mCDU 10a-10f may store information that is accessible by the processor(s) 115, including instructions 121 that may be executed by the processors 115. Memory 117 may be a type of memory operative to store information accessible by the processors 115 including a non-transitory computer-readable medium, or other medium that stores data that may be read with the aid of an electronic device, such as a hard-drive, memory card, read-only memory ("ROM"), random access memory ("RAM"), optical disks, as well as other write-capable and read-only memories. The subject matter disclosed herein may include different combinations of the foregoing, whereby different portions of the instructions 121 and data 119 are stored on different types of media.

Memory 117 of each mCDU 10a-10f may be retrieved, stored, or modified by processors 115 in accordance with instructions 121. For instance, although the present disclosure is not limited by a particular data structure, data 119 may be stored in computer registers, in a relational database as a table having a plurality of different fields and records, XML documents, or flat files. Data 119 may also be formatted in a computer-readable format such as, but not limited to, binary values, ASCII, or Unicode. By further way of example only, data 119 may be stored as bitmaps comprised of pixels that are stored in compressed or uncompressed form, or as various image formats (e.g., JPEG), vector-based formats (e.g., SVG), or as computer instructions for drawing graphics. Moreover, data 119 may comprise information sufficient to identify the relevant information, such as numbers, descriptive text, proprietary codes, pointers, references to data stored in other memories (including other network locations), or information that is used by a function to calculate the relevant data.

Instructions 121 for each mCDU 10a-10f can be any set of instructions to be executed directly, such as machine code, or indirectly, such as scripts, by the processor 115. In that regard, the terms "instructions," "application," "steps," and "programs" can be used interchangeably herein. The instructions can be stored in object code format for direct processing by the processor, or in any other computing device language including scripts or collections of independent source code modules that are interpreted on demand or compiled in advance. Functions, methods, and routines of the instructions are explained in more detail below. In this example, instructions can be provided to components of CDU 10, such as valve V or pump P of each of mCDU 10a-10f or facility valve Fv. Example instructions can include adjusting a parameter of one or more of the valves V or pumps P in any mCDU 10a-10f and/or a facility valve Fv that controls the supply of facility fluid into CDU 10 and facility supply manifold 22. For example, instructions to one or more of mCDU 10a-10f to modify or adjust the respective valve opening of valve V can include opening or closing valve V, as well as increasing or decreasing the size of the opening of valve V. Modifications or adjustments can further include, but are not limited to adjusting a degree, percentage, or pre-determined amount of the size of the opening to allows a desired amount of cooling fluid to flow through valve V of the mCDU 10a-10f being modified. Similarly, instructions to adjust pump P, including adjusting the speed of pump P and amount of cooling fluid pumped by pump P through one or more of mCDU 10a-10f can include, but is not limited to increasing or decreasing pump speed and/or adjusting a degree, percentage, or pre-determined amount of the pump speed. Instructions can further include instructions regarding modifying the operation of a malfunctioning mCDU, which can include completely shutting down a malfunctioning mCDU altogether, shutting down operation of only one of valve V or pump P of the malfunctioning mCDU, or adjusting parameters of valve V or pump P to reduce operations of valve V and/or pump P to a negligible amount. Additionally or alternatively, instructions can be provided to CDU facility valve Fv to modify CDU facility valve Fv to allow for increased or decreased flow from facility supply into CDU 10. For example, the opening of CDU facility valve FV can be increased or decreased to accommodate the change. Instructions can also be dispatched for a determination to be made as to how many mCDUs are operating in the system and to determine operational capacity based on the number of mCDUs operating in the system. Instructions can be based on data received from temperature and/or pressure telemetry systems or any systems or processors that make a determination that underlies a decision to modify a parameter of an mCDU.

PLC 42 may be coupled with CDU 10 via a direct and/or wireless connection. For instance, a wireless communication interface may be used to transmit and receive Bluetooth signals, WiFi signals, or signals that use other short-range wireless technologies. The features of PLC 42, processor(s) 152, memory 154, and data 156 may be the same as previously described herein with regard to CDU 10 above. PLC 142 may communicate and receive data from temperature telemetry system 44 and pressure telemetry system 45 of CDU 10. PLC 42 can then instruct each mCDU 10a-10f regarding adjustments to features within each mCDU 10a-10f.

Turning now to control of valve V in each mCDU 10a-10f, the size of the opening of control valve V in each mCDU 10a-10f may be controlled by control system 100, which can include PLC 42, temperature telemetry system 44, and mCDU controller 113. FIG. 7B illustrates a schematic flow diagram of CDU 10, mCDU 10a of CDU 10, and control of valve V, as well as pump P. PLC 42 may communicate with temperature telemetry system 44 and mCDU controller 113 to determine when it is necessary to modify the size of the opening of valve V. Although only mCDU 10a is depicted for ease and illustration and discussion, all mCDUs 10a-10f will be coupled to rack supply manifold 24 and rack return manifold 25. Fluid from each mCDU 10a-10f will exit CDU 10 through rack outlet RO and flow into rack supply line 17. Each mCDU 10a-10f will also receive heated return cooling fluid from rack return line 18, which enters CDU 10 through CDU return inlet RI.

The desired position or size of the opening of valve V at any given time may be a function of the temperature difference between facility supply fluid as it approaches and rack supply fluid as it exits CDU 10 and approaches data racks 2. In one example, the desired position or size of the opening of valve V may be based on the temperature difference between facility supply fluid as it approaches each mCDU 10a-10f and rack supply fluid as it exits each mCDU 10a-10f and approaches data racks 2. Control system 100 can then modify the size of the opening of valve V based upon a predetermined temperature setpoint, which can be compared to a differential temperature of facility fluid and rack fluid. To make this determination, a setpoint approach temperature and a differential temperature between facility cooling fluid and rack cooling fluid can be obtained. In other examples, the position can be modified based on any number of parameters, such as a temperature difference between a first differential temperature between facility supply fluid as it approaches and exits CDU 10 and a second temperature as rack supply fluid exits CDU 10.

A control or setpoint temperature T_{SETPOINT} can be established for the overall CDU 10 based on various factors. In one example, temperature setpoint T_{SETPOINT} can be based on the desired difference between the temperature of facility supply fluid on facility fluid supply side in first facility cooling loop 12 and cooling rack supply fluid on rack fluid supply side in second rack cooling loop 14. For example, CDU setpoint temperature T_{SETPOINT} may be a predetermined difference in temperature between a first temperature of facility cooling fluid that enters CDU 10 at CDU supply inlet SI and flows to facility supply manifold 22 and a second temperature of rack cooling fluid exiting rack supply manifold 24 and CDU 10 at CDU rack supply outlet RO. The desired CDU setpoint temperature T_{SETPOINT} can be further determined based on numerous parameters, including how many data racks 2 are connected to CDU 10 that CDU 10 will supply with cooling rack fluid; the number and type of components within each data rack 2; the fluid flow necessary to achieve cooling of the number of data racks 2; ambient temperature; and the like. In one example, CDU 10 setpoint temperature T_{SETPOINT} can be manually or separately calculated and input by an operator. CDU 10 setpoint temperature T_{SETPOINT} can also be selected and/or calculated by temperature telemetry system 44 and/or PLC 42. CDU setpoint temperature T_{SETPOINT} may be further stored by temperature telemetry system 44 and/or PLC 42.

Temperature setpoint T_{SETPOINT} can remain the same for a predetermined period of time or it can be continually updated during operation of CDU 10 and overall cooling system for various reasons, including when changes in the system are detected and/or a change to any parameter in the overall cooling system or CDU requires recalibration or adjustment of temperature T_{SETPOINT}. For example, when one of mCDUs 10a-10f malfunctions, it may be necessary to reevaluate temperature setpoint T_{SETPOINT} or utilize a different set of parameters to determine temperature setpoint T_{SETPOINT}. The cooling system can then recalibrate to account for fewer operational mCDUs and adjust the temperature setpoint T_{SETPOINT}. Each time Temperature setpoint T_{SETPOINT} changes, mCDUs 10a-10f can be accordingly adjusted (either automatically by a processor and/or at the request of an operator) to meet the existing temperature T_{SETPOINT}.

The actual temperature difference between the facility fluid flowing through the first facility cooling loop 12 and rack supply fluid flowing through second rack cooling loop 14 can be determined by obtaining an approach temperature. In one example, the approach temperature may be defined as a current temperature difference between the facility supply cooling fluid and rack supply cooling fluid of an mCDU. For example, with reference to mCDU 10a, at mCDU 10a, a first temperature T1 may be the temperature of the facility fluid as it supplies or enters mCDU 10a. First temperature T1 can be measured or determined at or adjacent coupling C1 where facility shelf supply line 30a is coupled to facility supply manifold 22. For example, sensor S1 may determine temperature T1. A second temperature T2 may be the temperature of rack supply cooling fluid in second rack cooling loop 14 as it exits mCDU 10a and supplies data racks 2 with rack supply fluid. Second temperature T2 can be measured or determined at coupling C3 where rack shelf supply line 33a is coupled to rack supply manifold 24. For example, sensor S4 may determine temperature T2. In one example, temperature telemetry system 44 can communicate with sensors S1 and S4 to monitor and collect data regarding the first temperature T1 and second temperature T2. With this information, temperature telemetry system 44 may calculate the temperature difference or approach temperature ΔT of fluid flow in mCDU 10a by determining the difference in temperature between the first facility supply temperature T1 and the second data rack return temperature T2, such that the approach temperature ΔT = T1-T2. The same control architecture may be implemented in each mCDU 10b-10f, but for ease of discussion, only control system 100 of mCDU 10a will be discussed.

Approach temperature ΔT of mCDU 10a can be compared to the overall CDU temperature setpoint T_{SETPOINT} in order to determine whether, at a given point in time, the size of the opening of valve V should be modified to increase, decrease, or maintain the current amount of facility cooling fluid flowing through first facility cooling facility loop 12. In one example, based on temperature data from temperature telemetry system 44, PLC 42 may compare approach temperature ΔT to CDU temperature setpoint T_{SETPOINT}. Based on this comparison, PLC 42 can communicate with mCDU controller 113 of mCDU 10a, and instruct mCDU controller 113 to modify the valve opening of valve V, such as to increase, decrease, or maintain the current size of the valve opening.

When the approach temperature ΔT is greater than CDU temperature setpoint T_{SETPOINT}, this is an indication that the temperature of rack fluid in second rack cooling loop 14 flowing to data racks 2 is too high and the rack fluid needs to be cooled down. In this example, PLC 42 can communicate with mCDU controller 113 and instruct mCDU controller 113 to adjust valve V to allow for more facility cooling fluid to flow through first facility cooling loop 12, which will help cool down rack fluid in second rack cooling loop 14. For example, the size of the opening of valve V may be increased. Further, the increase in the size of the opening of valve V may be a certain percentage increase. The increased facility fluid flow helps to increase the amount of cooling fluid available for heat exchange.

When the approach temperature ΔT is less than the CDU setpoint T_{SETPOINT}, this may be an indication that the temperature of the rack supply cooling fluid that is flowing to and cooling down components in data racks 2 is lower than the temperature that is necessary to maintain the predetermined cooling conditions. In this example, the temperature of rack fluid can be decreased. For example, the size of the opening of valve V may be decreased by a certain percentage. In one example, PLC 42 can communicate with mCDU controller 113 and instruct mCDU controller 113 to decrease the size of the valve V opening. The amount to decrease the opening of valve V can accomplished in any one of a number of ways, including but not limited to a decrease the opening by a certain percentage, such as a decrease in size of the opening by 10%; or to decrease the opening by a specific measurement, such as to reduce the valve opening by 2mm, or to reduce the valve opening to a size that is 5 mm.

When the approach temperature ΔT is equal to the CDU setpoint T_{SETPOINT}, this may indicate that the rack cooling fluid flow to the racks 2 is operating at an optimal temperature. In this example, the temperature of rack supply fluid flowing to second rack cooling loop 14 is sufficient, such that it is unnecessary to adjust or modify the size of the opening of valve V in first facility cooling loop 12 to provide increased cooling. PLC 42 may communicate with mCDU controller 113 and instruct mCDU controller 113 to take no action and to maintain the current conditions.

A same approach can additionally or altematively be taken to control facility valve Fv, which can control the overall amount of facility fluid supplied to CDU 10. Computing device or control system may determine that to increase overall cooling in the system, including supplying cooling fluid exiting CDU at a temperature sufficient to achieve cooling of IT equipment on data racks, it is necessary to increase the amount of cooling fluid in the system. For example, computing device and/or another system in communication with computing device can determine whether the current CDU operating conditions are insufficient to achieve the desired cooling and instruct facility valve Fv to modify the size of its opening. In one example, this may be based on whether the system is able to meet the predetermined temperature setpoint T_{SETPOINT}. In one example, after attempting to adjust cooling by modifying operation of valves V and pumps P of individual mCDUs 10a-10f, a determination may be made that more or less facility supply fluid should enter CDU 10. For example, if system continually exceeds temperature setpoint T_{SETPOINT}, control system may instruct facility valve Fv to increase the opening of facility valve Fv to allow for more facility fluid to enter CDU 10 and help to increase cooling. This may also occur if there is a sudden spike in the temperature of heated rack return fluid in the system and/or a spike in the overall temperature of cooling system and a decision is made to quickly cool down the cooling system. Similarly, when the differential temperature of fluid within the mCDUs is continually below temperature setpoint T_{SETPOINT}, the size of the opening of facility valve Fv can be decreased to limit the amount of flow through facility valve and to CDU 10.

Control system 100 may also control the pump speed of pump P for each mCDU 10a-10f to obtain a desired flow speed of rack supply cooling fluid through data racks 2. Pump P may be positioned on secondary or rack supply side 37 along second rack cooling loop 14 of each mCDU 10a-10f of CDU 10. The speed of pump P can be increased, decreased, or remain the same at any given point in time and for any given mCDU 10a-10f. For example, the speed of pump P can be adjusted to increase speed in order to increase the flow rate of rack supply cooling fluid flowing through second rack cooling loop 14. Alternatively, the speed of pump P can be decreased to reduce the flow rate of rack supply cooling fluid flowing through second rack cooling loop 14.

According to one example, to maintain a desired flow rate through second rack cooling loop 14, a constant pressure drop between the rack supply side and rack return side of each mCDU 10a-10f can be maintained by control system 100. For example, a CDU pressure setpoint can be obtained or designated, which will act as a pressure drop control or threshold. The control system 100 can determine pressure drop between the rack supply side and pressure drop side and then compare that pressure difference to the CDU pressure setpoint. Based on the determination, control system can then increase, decrease, or make no further changes to the speed of pump P.

A control or CDU pressure setpoint P_{SETPOINT} may be established for the overall CDU 10 based on various factors. In one example, pressure setpoint P_{SETPOINT} may be a predetermined pressure drop reflecting the difference in pressure between rack cooling fluid exiting the rack supply manifold 24 and rack cooling fluid entering the rack return manifold 25 that is required to maintain a desired flow rate through rack cooling loop 14. For example, pressure setpoint P_{SETPOINT} may be a predetermined pressure drop reflecting the difference in pressure between rack cooling fluid exiting the rack supply manifold 24 at rack outlet RO and rack fluid entering rack return manifold 25 at rack inlet RI. In some examples, rack outlet RO may also be a CDU outlet or outlet that can be coupled to components external to the CDU . In one non-limiting example, it may be determined that CDU 10 must pump rack cooling fluid to data racks 2 at a flow rate of 100 gallons/min to ensure cooling of computing components with data racks 2. Flow rate can be a function of the pressure drop necessary to maintain a flow rate of 100 gallons/min. through the rack supply side 37 and rack cooling loop 14. This means that the desired pressure drop necessary to maintain a constant flow rate can be determined based on a given flow rate. Features of the data center, including without limitation, the length of the central supply and return lines, diameter of the lines, the number of racks, and other features can also be taken into consideration when calculating flow rate and pressure drop. The pressure drop can then be set as the CDU pressure setpoint P_{SETPOINT}. In one example, CDU pressure setpoint P_{SETPOINT} can be manually input or selected by an operator. Otherwise, CDU pressure setpoint P_{SETPOINT} can be selected and/or calculated by pressure telemetry system 45 and/or PLC 42. CDU pressure setpoint P_{SETPOINT} may be further stored by pressure telemetry system 45 and/or PLC 42. When one of mCDUs 10a-10f malfunctions, pressure setpoint P_{SETPOINT} can remain the same and mCDUs can be accordingly adjusted to meet pressure setpoint P_{SETPOINT} in view of the absence of the malfunctioning mCDU. In some examples, CDU 10 pressure setpoint P_{SETPOINT} can be updated during operation of CDU 10 and cooling system. For example, if one or more mCDUs 10a-10f malfunctions and is no longer operational, the system, either automatically by a processor and/or at the request of an operator, may require recalibration or adjustment of pressure P_{SETPOINT}.

Based on the CDU pressure setpoint P_{SETPOINT}, the pump speed of pump P for each mCDU 10a-10f can be accordingly adjusted by control system 100 to ensure that a constant pressure drop is maintained. Pressure telemetry system 45, through sensors, such as sensors S3 and S4 at or near each mCDU 10a-10f, can determine flow rate pressure as data rack supply cooling fluid exits each mCDU 10a-10f. Sensors S3 and S4 are only shown positioned adjacent mCDU 10a-10f, but it is to be appreciated that sensors S3-S4 may be provided adjacent each mCDU 10a-10f and in this example, the same sensors S1-S4 can be used to detect temperature and pressure at each mCDU but in other examples different sensors can be utilized. For example, at mCDU 10a, a first pressure P1_{RACKFLUID} of data rack fluid flow can be measured or determined by a sensor S4 at coupling C3, also the point where data rack shelf supply line 33a is coupled to data rack supply manifold 24. A second pressure P2_{RACKFLUID} of data rack fluid flow can be measured or determined by sensor S3 at coupling C4, also the point where data rack shelf return line 34a is coupled to data rack return manifold 25. In one example, pressure telemetry system 45 can collect data regarding the first pressure P1_{RACKFLUID} and second pressure P2_{RACKFLUID}. With this information, pressure telemetry system 45 may calculate the pressure differential ΔP of rack fluid flow into mCDU 10a by determining the difference in pressure between the first data rack supply pressure P1_{RACKFLUID} and the second data rack return pressure P2_{RACKFLLJID}, such that ΔP=P1_{RACKFLUID} - P2RACKFLUID.

To determine whether to increase pump speed to increase the amount of fluid and/or speed of rack cooling fluid flow to racks 2; decrease pump speed to decrease the amount or speed of rack cooling fluid flow to racks 2; or to maintain current pump speed so that no changes to pump speed are made, pressure differential ΔP of mCDU 10a at any point in time can be compared to the overall CDU pressure setpoint P_{SETPOINT}. In one example, based on pressure data from pressure telemetry system 45, PLC 42 may compare differential pressure ΔP to CDU pressure setpoint P_{SETPOINT}. Based on this comparison, PLC 42 can communicate with mCDU controller 113 of mCDU 10a, and instruct mCDU controller 113 to increase, decrease, or maintain the current pump speed of pump P.

When PLC 42 determines that pressure ΔP of mCDU 10a is greater than the CDU pressure setpoint P_{SETPOINT}, this may indicate that the rack cooling fluid flow rate exceeds the desired flow rate and that it is unnecessary to maintain the current pump speed. In this scenario, pump speed of pump P of mCDU 10a may be reduced to reduce the speed of rack cooling fluid flow to racks 2. In this example, PLC 42 can communicate with mCDU controller 113 and instruct mCDU controller 113 to decrease the pump speed of pump P of mCDU 10a.

When the differential pressure ΔP is less than the CDU pressure setpoint P_{SETPOINT}, this may indicate an insufficient flow rate of rack cooling fluid to the racks 2, which could result in insufficient cooling of the racks 2. In this scenario, pump speed of pump P of mCDU 10a may be increased to increase the speed of rack supply cooling fluid flow to racks 2. In one example, PLC 42 can communicate with mCDU controller 113 and instruct mCDU controller 113 to increase the pump speed of pump P of mCDU 10a.

When the differential pressure ΔP is equal to the CDU pressure setpoint P_{SETPOINT}, this may indicate that the rack cooling fluid flow to the racks 2 is operating at an optimal condition. In this scenario, the pump speed of pump P of mCDU 10a does not need to be adjusted or modified. PLC 42 may communicate with mCDU controller 113 and instruct mCDU controller 113 to maintain the current speed of pump P of mCDU 10a.

As discussed above and according to aspects of the disclosure, change in temperature and pressure of each mCDU 10a-10f in the system can be simultaneously evaluated against the pressure setpoint P_{SETPOINT} and temperature setpoint T_{SETPOINT} of the CDU 10. This can help to ensure that at any point in time, CDU 10 provides optimal cooling of the overall cooling system, with each mCDU 10a-10f simultaneously adjusting the respective and individual flow rate/temperature and pressure. As noted above, change in pressure ΔP and change in temperature ΔT may be calculated and determined for each mCDU 10a-10f, such that the change in pressure ΔP and change in temperature ΔT of each mCDU 10a-10f may differ. The adjustments to flow rate and/or pressure required for each mCDU 10a-10f may accordingly differ. For example, controller may instruct valve V and pump P of mCDU 10a to close valve V and increase pump speed P, whereas controller and/or PLC 42 may instruct valve V and pump P of mCDU 10b to open valve V and decrease pump speed P. Further, in some examples, controller or PLC 42 may instruct valve V of mCDU 10b to open 4 inches, whereas valve V of mCDU 10c may be instructed to open only 2 inches. In some examples, it may be desired to only compare temperature differential or another feature related to temperature at any mCDU 10a-10f to the temperature setpoint T_{SETPOINT}, or to altematively only compare pressure differential or other feature related to pressure at any mCDU to pressure setpoint P_{SETPOINT} instead of comparing both temperature and pressure.

The ability to adjust the flow rate and pressure through each individual mCDU allows for greater control to make changes in each mCDU 10a-10f that will collectively achieve the desired pressure setpoint P_{SETPOINT} and temperature setpoint T_{SETPOINT} of the overall CDU 10. Furthermore, since each mCDU 10a-10f processes a smaller amount of overall cooling fluid that flows through each mCDU 10a-10f, it can be both easier to control the needed changes in each mCDU 10a-10f, as well as more quickly achieve a change, when necessary. For example, it may be easier to more quickly cool down cooling fluid fed to a rack manifold supply because smaller amounts of return rack fluid are being cooled down in each mCDU 10a-10f. Similarly, it may be easier to more quickly address a change in pressure at the outlet of CDU 10, with the ability to individually adjust each pump in each mCDU 10a-10f.

In another example, a CDU pressure setpoint P_{SETPOINT} and CDU temperature setpoint T_{SETPOINT} may be predetermined for the overall CDU 10. A control system may determine that in order to achieve the predetermined CDU pressure setpoint P_{SETPOINT} and predetermined CDU temperature setpoint T_{SETPOINT}, it is instead or additionally necessary to assign a secondary pressure setpoint P_{SETPOINT} and a secondary temperature setpoint T_{SETPOINT} that each individual mCDU 10a-10f must meet in order to collectively achieve the predetermined CDU pressure setpoint P_{SETPOINT} and CDU temperature setpoint T_{SETPOINT}. For example, each mCDU 10a-10f may be assigned a secondary pressure setpoint P_{SETPOINT} and secondary temperature setpoint T_{SETPOINT}. One or both of the secondary pressure setpoint P_{SETPOINT} and secondary temperature setpoint T_{SETPOINT} of any mCDU 10a-10f may differ from that of any other mCDU 10a-10f. A control system may continually update the secondary pressure setpoint P_{SETPOINT} and secondary temperature setpoint T_{SETPOINT} of each mCDU 10a-10f to achieve the overall CDU pressure setpoint P_{SETPOINT} and CDU temperature setpoint T_{SETPOINT}.

As discussed above, CDU 10 may be a redundant CDU 10, such that at least one extra mCDU of mCDUs 10a-10f is operating at all times. The redundant mCDU allows the CDU 10 to continue operating and providing sufficient heat exchange and cooling fluid to cooling system should one of the mCDUs is CDUI 10 no longer be operational. To ensure that all mCDUs 10a-10f are properly operating, a malfunction pressure setpoint MP_{SETPOINT} and malfunction temperature setpoint MT_{SETPOINT} may be determined. The pressure and temperature at each mCDU 10a-10f may be factored into a value that is compared to respective malfunction pressure setpoint MP_{SETPOINT} and malfunction temperature setpoint MT_{SETPOINT}.

Malfunction temperature setpoint MT_{SETPOINT} may be the maximum accepted differential temperature between the first facility liquid supply temperature T1₁ entering into CDU and the second rack supply temperature T2₁ of cooling fluid exiting one of the mCDUs 10a-10f being evaluated and entering the rack supply manifold.

In other examples, different criteria can be established to determine malfunction temperature setpoint. For example, comparison can instead be made to the system supply temperature entering into an individual mCDU 10a-10f and the second rack supply temperature T2₁ of cooling fluid exiting the mCDU 10a-10f and entering the rack supply manifold. Similarly, malfunction pressure setpoint MP_{SETPOINT} may be the maximum difference in pressure between the first data rack supply pressure P1_{RACKFLUID} and the second data rack return pressure P2_{RACKFLUID} for the mCDU being evaluated. For example, a change in pressure ΔP and change in temperature ΔT of each mCDU 10a-10f is determined as previously discussed, and as such is not again described. A predetermination can be made as to what temperature differential and what pressure differential would indicate to an operator that one of the mCDUs 10a-10f is not properly operating. In one non-limiting example, malfunction pressure setpoint MP_{SETPOINT} may be set for 20psi and the malfunction temperature setpoint MT_{SETPOINT} may be set for 20 °C, but any maximum pressure and temperature malfunction setpoints can be selected. Change in pressure ΔP and change in temperature ΔT of each mCDU 10a-10f can be determined and respectively compared to malfunction pressure setpoint MP_{SETPOINT}, which in this example is 20psi, and malfunction temperature setpoint MT_{SETPOINT}., which in this example is 20 °C. When any one of mCDUs 10a-10f reaches and/or exceeds malfunction pressure setpoint MP_{SETPOINT} and/or malfunction temperature setpoint MT_{SETPOINT}, the control system can send an alarm to the operator and/or the malfunctioning mCDU may be shut down by controller 42.

Should at least one mCDU 10a-10f no longer be operational, controller 42 can accordingly modify the adjustments required for each mCDU 10a-10f to achieve the pressure setpoint P_{SETPOINT} and CDU temperature setpoint T_{SETPOINT}. For example, if mCDU 10f is no longer operational, the control system will determine that mCDU 10f is not operational. When the change in pressure ΔP and change in temperature ΔT of each mCDU are compared to the pressure setpoint P_{SETPOINT} and temperature setpoint T_{SETPOINT} of CDU 10, the control system can automatically readjust the calculations to account for the lack of contribution from offline mCDU 10f.

Although in this example adjustments or modifications to each mCDU were determined based on a pressure setpoint P_{SETPOINT} and temperature setpoint T_{SETPOINT}, each mCDU 10a-10f may be adjusted based on any parameters to achieve a desired result. For example, determination may instead be based on a comparison of any feature related to temperature and any feature related to pressure. In one example, actual temperatures in each mCDU 10a-10f, as compared to an actual temperature desired for CDU 10 can be determined. Each mCDU 10a-10f can be custom adjusted to achieve the desired parameter. In some examples, each mCDU 10a-10f can be simultaneously adjusted. In other examples, adjustments may be made at different times.

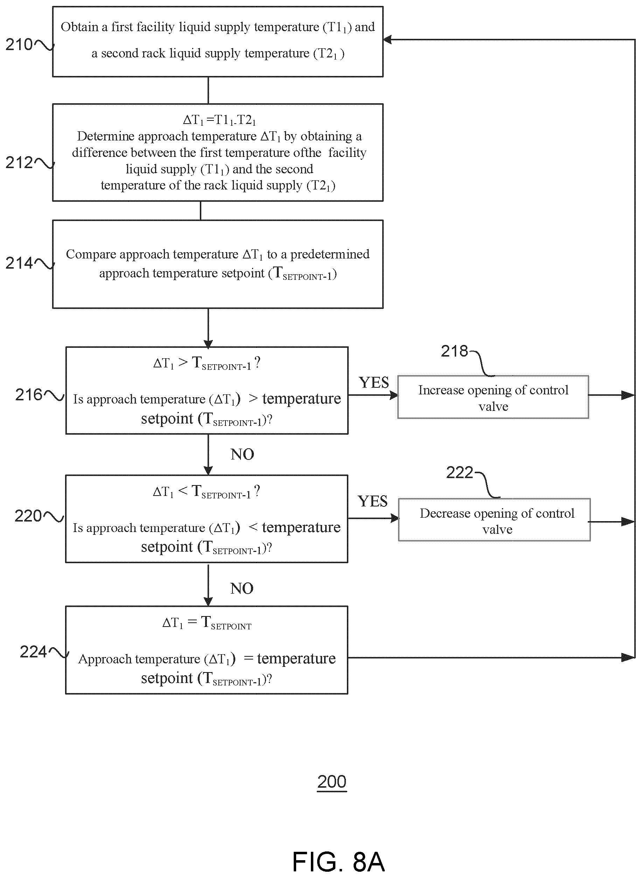

FIG. 8A is a flow chart illustrating one example method 200 of controlling the amount of facility cooling fluid or liquid flowing through first facility control loop 12, as well as the overall temperature of rack cooling fluid in the second rack control loop 14. In particular, method 200 teaches control of valve V on the facility supply side 36 of each mCDU 10a and in this example, concerns controlling the size of the opening of valve V to allow for the increase of the facility supply cooling fluid into each mCDU 10a-10f in CDU 10.

At box 210, a first facility liquid supply temperature T1₁ and a second rack liquid supply temperature T2₁ are obtained. In one example, temperature T1₁ can be obtained at or adjacent a coupling that joins facility shelf supply line 30a of mCDU 10a to facility supply manifold 22. Similarly, temperature T2₁ can be obtained at or adjacent a coupling that joins rack shelf supply line 33a to rack supply manifold 24. In one example, temperature telemetry system 44 will determine temperature T1₁ and temperature T2₁ based on information received from sensors S4 and S5 of mCDU 10a.

At box 212, a differential temperature or approach temperature ΔT₁ is determined. The approach temperature ΔT₁ can be determined by obtaining the difference between the first facility liquid supply temperature T1₁ and the second rack supply temperature T2₁. In one example, temperature telemetry system 44 can determine the approach temperature ΔT₁.

At box 214, the approach temperature ΔT₁ can be compared to a set point temperature T_{SETPOINT-1}. In one example, the temperature setpoint T_{SETPOINT-1} can be a predetermined temperature representing the desired temperature difference between the first facility supply fluid temperature as facility supply cooling fluid enters CDU 10 at facility supply manifold 22 in first facility cooling loop 12, and the second rack supply temperature as rack supply cooling fluid exits rack supply manifold 24 in second rack cooling loop 14 of CDU 10. In one example, PLC 42 may make the comparison between the approach temperature ΔT₁ and set point temperature T_{SETPOINT-1}.

At box 216, a determination is made as to whether the approach temperature ΔT₁ is greater than the temperature setpoint T_{SETPOINT-1}. For example, based on the comparison, PCL 42 may determine whether approach temperature ΔT₁ is greater than the temperature setpoint T_{SETPOINT-1}.

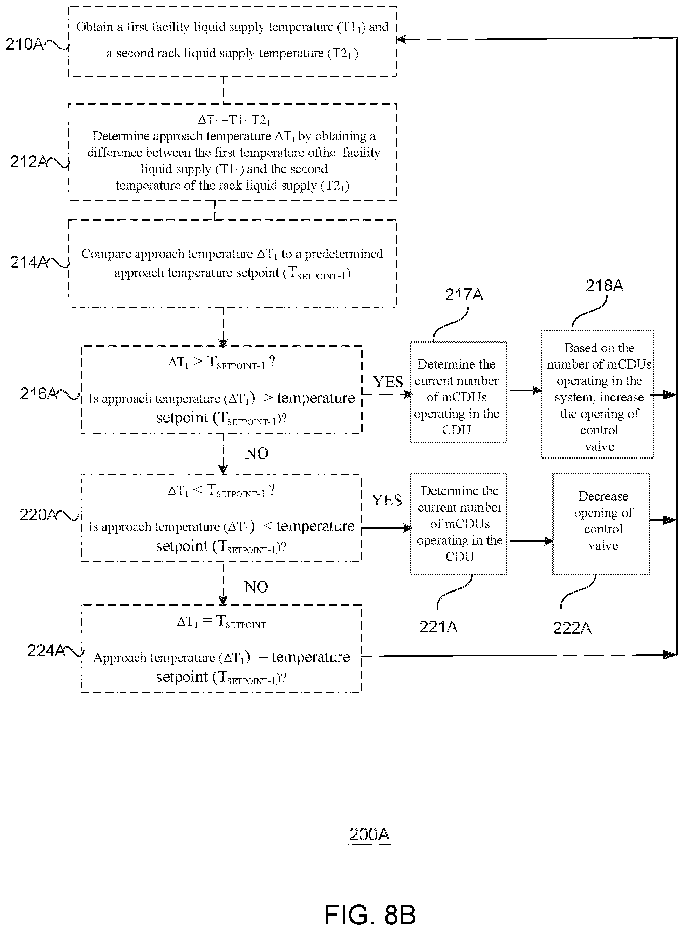

When the answer to the question in box 216 is "yes" and the approach temperature ΔT₁ is greater than the temperature setpoint T_{SETPOINT-1}, the method advances to box 218 and the opening of valve V can be increased. In some examples, the opening of valve V may be adjusted. For example, PCL 42 can determine the amount to modify the size of the opening of valve V. In some examples, valve V can be increased by a certain percentage. For example, PLC 42 may determine that in order to achieve the temperature setpoint T_{SETPOINT-1}, valve V can be opened by an additional 30%. Additionally, when determining the amount to open up valve V, the number of mCDUs operating within the CDU can optionally be assessed, as will be discussed in FIG. 8B. Modification of valve V can be based, in part, on the number of mCDUs in the system. This will allow for optimal operating conditions and redundancy, such that should one of the mCDUs malfunction, the remaining mCDUs can compensate for the loss of the malfunctioning mCDU. After valve V has been adjusted, the method begins again at box 210.

When the answer to the question in box 216 is "no" and the approach temperature ΔT₁ is not greater than the temperature setpoint T_{SETPOINT-1}, the method instead advances to box 220.

At box 220, a determination is made as to whether the approach temperature ΔT₁ is less than the temperature setpoint T_{SETPOINT-1}. For example, based on the comparison, PCL 42 may determine whether approach temperature ΔT₁ is less than the temperature setpoint T_{SETPOINT-1}.

When the answer to the question in box 220 is "yes" and approach temperature ΔT₁ is less than the temperature setpoint T_{SETPOINT-1}, the method advances to box 222 and the opening of valve V can be decreased. For example, PCL 42 can determine the amount to modify and reduce the size of the opening of valve V. In one example, PLC 42 may determine that in order to achieve the temperature setpoint T_{SETPOINT-1}, the opening of valve V can be closed by 20%. Additionally, in other examples an exact amount in which to reduce the opening of valve V can be determined. For example, PLC 42 can instead determine that valve V must be closed by a specific amount, such as two inches, or within a range, such as one and a half inches to two inches (1.5-2). In other examples, when determining the amount required to adjust valve V, the number of mCDUs operating within the CDU can be determined and taken into consideration, as also discussed in FIG. 8B. After the opening of valve V has been adjusted or allowed to remain the same, the method returns back to box 210 and starts over again.

However, when the answer to the question in box 220 is "no" and approach temperature ΔT₁ is less than the temperature setpoint T_{SETPOINT-1}, the method instead advances to box 224.

When the method progresses to box 224, it is known that the approach temperature ΔT₁ is neither greater than nor less than temperature setpoint T_{SETPOINT-1}. That is, approach temperature ΔT₁ is equal to temperature setpoint T_{SETPOINT-1} and no adjustments need to be made to the opening of the valve V. PLC 42 may instruct the mCDU 113 controller to maintain the current size of the opening and/or may provide no instructions so that mCDU controller 113 maintains the current size opening of valve V. Thereafter, the method proceeds back to box 210 and starts over again.

Method 200 can be performed for each mCDU 10a-10f at the same time, at staggered times, and/or any desired times. The method disclosed in FIG.8A is one method to determine whether to modify the size of the valve opening, such as increasing or decreasing the size of the opening. The method further relies upon the process of elimination to determine that no change is to be made in box 224. In alternative arrangements, it can first be determined whether the approach temperature ΔT₁ is equal to temperature setpoint T_{SETPOINT-1} or whether ΔT₁ is less than temperature setpoint T_{SETPOINT-1}. The comparison can progress in any order. The number of mCDUs operating in the system can also be determined at any point in time and/or stored in system memory each time a change is made to the number of mCDUs, and later accessed when needed to determine whether to adjust flow rate and/or pump rate in the system.

When one of the plurality of mCDUs malfunctions, due to redundancy in the system made possible in this example by including at least one extra mCDU, the malfunctioning mCDU can be taken offline for repairs and/or some or all of its features, such as speed of pump P and opening of valve V, can be reduced to a negligible amount. The CDU can then compensate for the loss of the malfunctioning mCDU and recalibrate the CDU to operate with only the remaining number of mCDUs in any number of ways.

FIG. 8B illustrates flow chart 200A showing an optional method that evaluates how many mCDUs are currently functioning or operating by evaluating the number of remaining operational mCDUs. In this example, blocks 210A, 212A, 214A, 216A, 220A, and 224A are identical to corresponding blocks 210, 212, 214, 216, 220, and 224 of FIG. 8A and are not again described here. The difference here is that at block 216A, if the answer is "yes", at block 217A, a determination can be made regarding the number of mCDUs that are currently operating in the CDU. This can be based on receiving information from the control system regarding whether an mCDU is malfunctioning and has been shut down and/or taken offline. At block 218A, based, in part, on the number of operational mCDUs, the valve opening of the mCDU can be increased to allow for more fluid to flow through mCDU 10a. In other examples, the determination of how many mCDUs are operating can be made at a different point in time and/or stored in memory and accessed.

Similarly, at block 220A, if the answer is "yes", at block 221A, a determination can be made to determine the number of mCDUs that are currently operating in the CDU. At block 222A, based, in part, on the number of operational mCDUs, the valve opening of the mCDU can be decreased. This can be based on receiving information from the control system regarding whether an mCDU is malfunctioning and has been shut down and/or taken offline. In other examples, the determination of how many mCDUs are operating can be made at a different point in time and/or stored in memory and accessed.

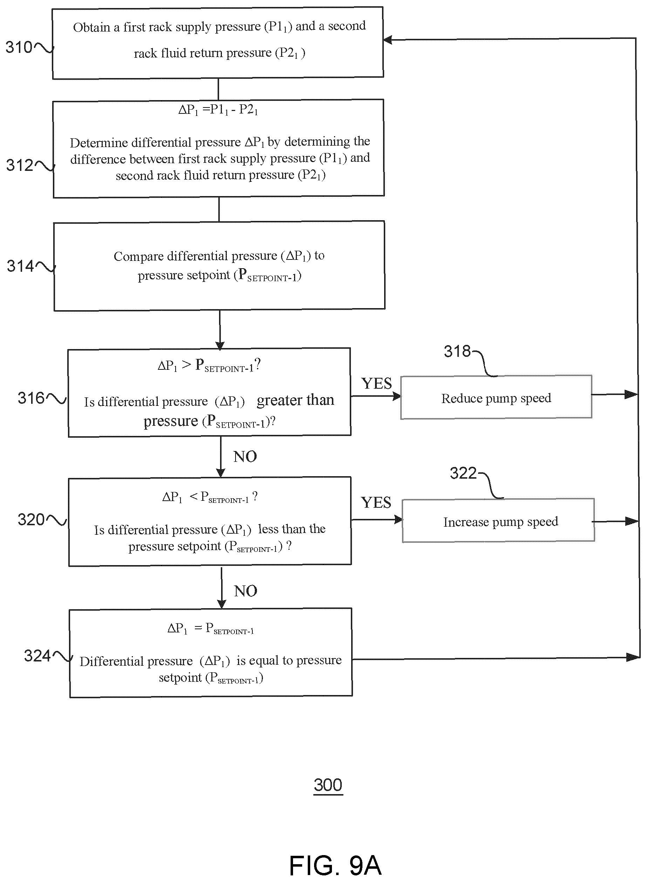

FIG. 9A is a flow chart illustrating an example method 300 for controlling a pump speed for pump P of any one or more of mCDUs 10a-10f in order to maintain a constant pressure drop and flow speed of rack cooling fluid through data racks 2.

At block 310, a first rack supply pressure P1₁ and a second rack cooling fluid return pressure P2₁ can be obtained for each mCDU in the CDU. In one example, sensors at each mCDU 10a-10f can determine flow rate pressure as data rack supply cooling fluid exits each mCDU 10a-10f. For example, at mCDU 10a, a first pressure P1₁ of data rack cooling fluid flow can be measured or determined by sensor S4 at coupling C3 where or a point where data rack shelf supply line 33a is coupled to data rack supply manifold 24. A second pressure P2₁ of data rack cooling fluid flow can be measured or determined by sensor S3 at coupling C4 or the point where data rack shelf return line 34a is coupled to data rack return manifold 25. In some examples, PCL 42 can obtain first pressure P1₁ and second pressure P2₁ from sensors S3, S4.

At block 312, differential pressure ΔP₁ can be determined. Differential pressure ΔP₁ can be obtained by determining the difference in pressure between the first pressure of first data rack supply cooling fluid (P1₁) and the second pressure of data rack cooling fluid return P2₁. For example, PCL 42 may calculate this difference to obtain differential pressure ΔP₁. In one example, pressure telemetry system 45 can determine the differential pressure ΔP₁.

At block 314, differential pressure ΔP₁ can be compared to a pressure setpoint P_{SETPOINT-1}. Pressure setpoint P_{SETPOINT-1} may be a predetermined pressure drop reflecting the difference in pressure between rack supply cooling fluid exiting the rack supply manifold 24 and rack return cooling fluid entering the rack return manifold 25 that is required to maintain a desired flow rate through rack cooling loop 14. For example, PCL 42 may compare the difference between differential pressure ΔP₁ and pressure setpoint P_{SETPOINT-1}.

At block 316, a determination is made as to whether differential pressure ΔP₁ is greater than pressure setpoint P_{SETPOINT-1}. For example, PCL 42 may compare the differential pressure ΔP₁ and the pressure setpoint P_{SETPOINT-1} and make the determination whether the differential pressure ΔP₁ is greater than the pressure setpoint P_{SETPOINT-1}.

When the answer to the question at block 316 is "yes," the method advances to block 318 and the pump speed can be reduced. For example, PCL 42 can instruct mCDU controller 113 to reduce the pump speed of pump P of mCDU 10a. In some examples, PCL 42 can determine the pump speed of pump P that is necessary to bring differential pressure ΔP₁ closer to pressure setpoint P_{SETPOINT-1}, and instruct mCDU controller 113 to decrease the pump speed by such amount or to reduce the pump speed by a certain percentage or otherwise generally reduce the pump speed of pump P. Additionally, when determining the amount to reduce the output of or pump speed of pump P, the number of mCDUs currently operating within the CDU can also be determined. The speed of pump P can be modified based, in part, on the number of mCDUs currently operating or identified as being operable in the system. After pump P has been adjusted, the method begins again at box 310.

When the answer to the question at block 316 is "no", the method advances to block 320. At block 320, a determination is made whether the differential pressure ΔP₁ is less than the pressure setpoint P_{SETPOINT-1}. For example, PCL 42 can determine if the differential pressure ΔP₁ is less than the pressure setpoint P_{SETPOINT-1}.

When the answer to the question at block 320 is "yes," the method advances to block 322. At block 322, pump speed is increased. For example, PCL 42 can instruct mCDU controller 113 to increase the pump speed of pump P of mCDU 10a. In some examples, PCL 42 can determine the pump speed of pump P that is necessary to bring differential pressure ΔP₁ closer to pressure setpoint P_{SETPOINT-1} and instruct mCDU controller 113 to increase the pump speed by such amount or to increase the pump speed by a certain percentage or otherwise generally increase the pump speed of pump P. In some examples, when determining the amount to increase output of pump P, the number of mCDUs currently operating within the CDU can be determined. Pump P can be modified based, in part, on the number of mCDUs currently operating or identified as being operable in the system. After pump P has been adjusted, the method begins again at box 310.

When the answer to the question at block 320 is "no," the method advances to block 324. At block 324, it is known that that differential pressure ΔP₁ is equal to the pressure setpoint P_{SETPOINT-1}. For example, by block 324, PCL 42 will have determined that the differential pressure ΔP₁ is neither greater than nor less than the pressure setpoint P_{SETPOINT-1}. By process of elimination, PCL 42 will determine that differential pressure ΔP₁ is equal to the pressure setpoint P_{SETPOINT-1} and can instruct mCDU controller 113 to take no action or simply provide no further instructions to mCDU controller 113 until a change is required. Thereafter, the method begins again at box 310.

Although reference was only made to mCDU 10a, it is to be appreciated that the example methods disclosed in FIGS. 8A, 8B, and 9A, as previously described, as well as FIGS. , 9B, 9C and 9D, which will be further described herein, can be performed at any time for each mCDU 10a-10f, such as simultaneously, or at alternating, staggered, and/or pre-determined times. Additionally, it may instead be desired to only make an adjustment based on one of temperature or pressure, and not both temperature and pressure. Moreover, the number of mCDUs operating in the system can be determined, such as by a controller or other component, at any point in time. The number of mCDUs can additionally or altematively be stored in memory each time a change is made to the number of mCDUs, such that it can be later accessed when a determination must be made to adjust flow rate or temperature, including adjusting valve V and/or pump P in each of the mCDUs.

The method disclosed in FIG. 9A is one method to determine whether to increase or decrease pump speed and relies upon process of elimination to determine that no change is to be made in box 324. In alternative arrangements, it can first be determined whether the differential pressure ΔP₁ is equal to pressure setpoint P_{SETPOINT-1} or whether ΔP₁ is less than pressure setpoint P_{SETPOINT-1}. The comparison can progress in any order.

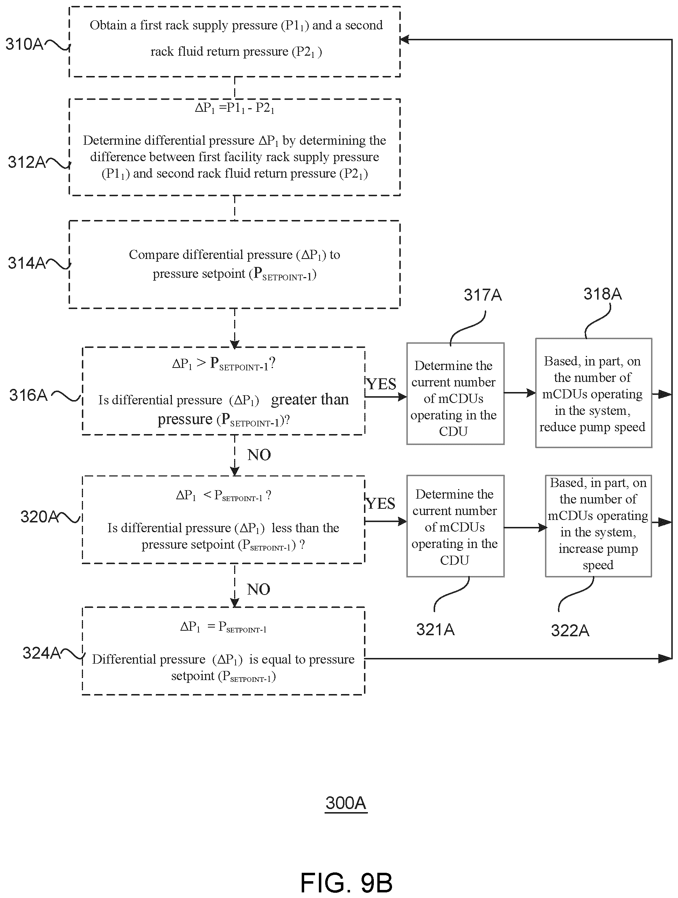

FIG. 9B illustrates flow chart 300A showing another optional method. As previously discussed, when one of the plurality of mCDUs malfunctions, the malfunctioning mCDU can be taken offline or otherwise shut down for repairs. The CDU can then compensate for the loss by taking into account the number of remaining operational mCDUs and the necessary pump speed and volume of flow through each of the remaining mCDUs. In one example, blocks 310A, 312A, 314A, 316A, 320A, and 324A are identical to corresponding blocks 310, 312, 314, 316, 320, and 324 of FIG. 9A and are not again described here. The difference here is that at block 316A, if the answer is "yes", at block 317A, a determination can be made regarding the number of mCDUs that are currently operating. At block 318, based, in part, on the number of operational mCDUs, the pump speed of the mCDU can be reduced. In other examples, the determination can be made at a different point in time and/or stored in memory and accessed.

Similarly, at block 320, if the answer is "yes", at block 321A, a determination can be made regarding the number of mCDUs that are currently operating. At block 322A, based, in part, on the number of operational mCDUs, the pump speed of the mCDU can be increased.

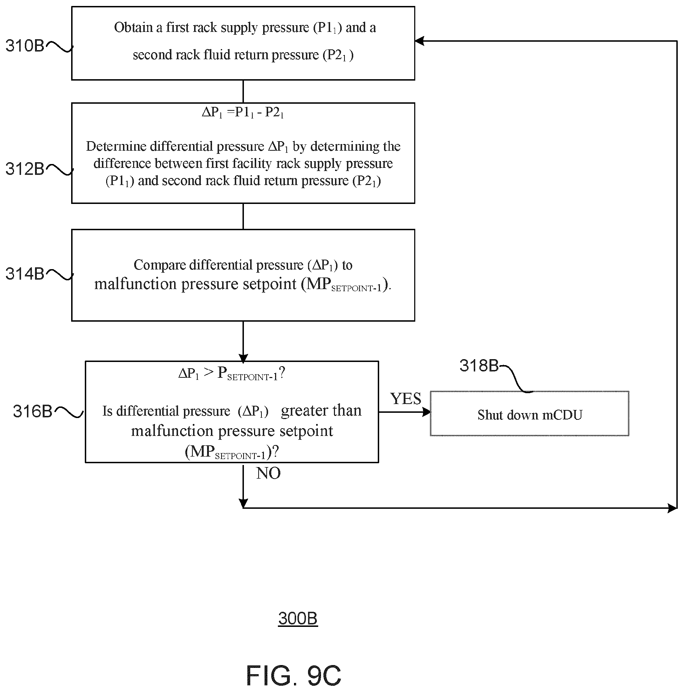

FIG. 9C provides a flowchart 300B illustrating one example method showing, as a result of redundancy of the mCDUs, a process of taking one of the mCDUs offline due to a malfunction or sub-optimal performance. Thereafter, the CDU can be recalibrated to control flow rate and temperature to and from the CDU and/or to the racks coupled to the CDU based on the remainder of the functioning mCDUs in the system.

At block 310B, a first rack supply pressure P1₁ and a second rack cooling fluid return pressure P2₁ may be obtained for each mCDU 10a-10f in the CDU. In one example, sensors at each mCDU 10a-10f can determine flow rate pressure as data rack supply cooling fluid exits each mCDU 10a-10f. For example, at mCDU 10a, first pressure P1₁ of data rack cooling fluid flow can be measured or determined by sensor S4 at coupling C3 or the point where data rack shelf supply line 33a is coupled to data rack supply manifold 24. A second pressure P2₁ of data rack cooling fluid flow can be measured or determined by sensor S3 at coupling C4 or the point where data rack shelf return line 34a is coupled to data rack return manifold 25. In one example, PCL 42 can obtain first pressure P1₁ and second pressure P2₁.

At block 312B, differential pressure ΔP₁ can be determined. Differential pressure ΔP₁ can be obtained by determining the difference in pressure or the pressure drop between the first pressure of first data rack supply cooling fluid P1₁ and the second pressure of data rack cooling fluid return P2₁ for each mCDU, such as mCDU 10a, such that ΔP1 = P1₁ - P2₁, as previously described. In one example, PCL 42 will calculate differential pressure.

At block 314B, differential pressure ΔP₁ can be compared to a malfunction pressure setpoint MP_{SETPOINT-1}. Malfunction pressure setpoint MP_{SETPOINT-1} may be a predetermined maximum pressure drop indicated by the difference in pressure between rack supply cooling fluid exiting the rack supply manifold 24 from a given mCDU and rack return cooling fluid entering the rack return manifold 25 from any given mCDU. Malfunction pressure setpoint MP_{SETPOINT-1} can be used to determine the point at which an mCDU is malfunctioning and can be taken offline for repair and/or to allow for other mCDUs to compensate for the malfunctioning mCDUs performance.

At block 316B, a determination is made as to whether differential pressure ΔP₁ is greater than malfunction pressure setpoint MP_{SETPOINT-1}. For example, PCL 42 may compare the differential pressure ΔP₁ and the malfunction pressure setpoint MP_{SETPOINT-1} and make the determination whether the differential pressure ΔP₁ is greater than the malfunction pressure setpoint MP_{SETPOINT-1}.

When the answer to the question at block 316B is "no," the method can progress back to block 310B to restart the method.

When the answer to the question at block 316B is "yes," the method advances to block 318B. At block 318B, the mCDU can be taken offline and/or shut down. Pump speed of pump P can be shut down and the valves V closed so that fluid no longer flows through the mCDU. For example, PCL 42 can instruct mCDU controller 113 to reduce the pump speed of pump P to zero and to close valve V so that fluid does not flow through the malfunctioning mCDU. In other examples, PCL 42 can communicate with a power supply, such as PDU 42 previously discussed, and instruct PDU 42 to discontinue the supply of power to the mCDU. In other examples, PDU 42 can further instruct mCDU controller 113 to communicate with PDU 42. In still another example, instead of taking mCDU completely offline, PCL 42 can instruct mCDU controller 113 to reduce the pump speed to a negligible amount.

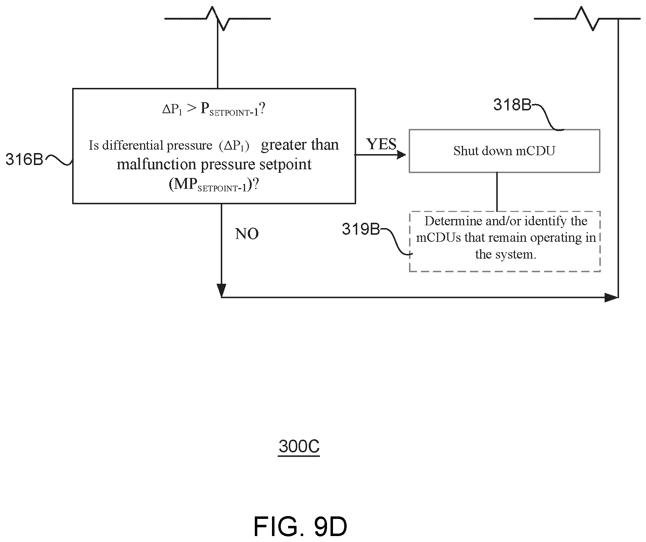

FIG. 9D illustrates another method 300C, which is identical to FIG. 9C, except that it further includes an optional block 319B. As shown, when the mCDU is shut down, a determination can be made as to the number and/or identity of any mCDUs that remain operating in the CDU. This information can be stored and/or conveyed to CDU controller to determine whether modifications are required for each valve V and pump P for each mCDU 10a-10f, as previously discussed regarding FIGS. 8A-8B and 9A-9C.

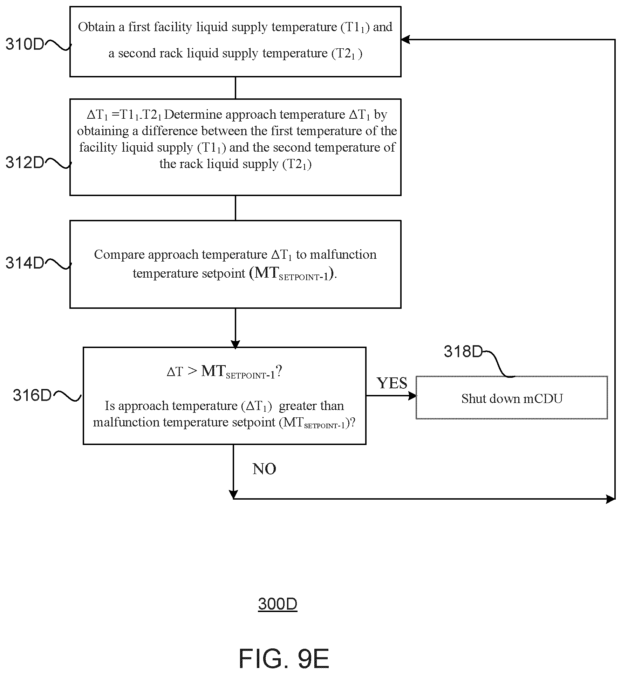

FIGS. 9C-9D provide one example method for determining to shut down an mCDU based upon pressure or pressure drop in the cooling system. Numerous variations can be made with regard to the methods described in FIGS. 9C and 9D. For example, it may be desired to shut down an mCDU when the differential pressure ΔP₁ is greater than or equal to malfunction pressure setpoint MP_{SETPOINT-1}. Additionally, it may be desired to first assess whether malfunction temperature setpoint MT_{SETPOINT-1} has been exceeded, as will be discussed regarding FIGS. 9E-9F, such that both malfunction temperature setpoint MT_{SETPOINT-1} and malfunction pressure setpoint MP_{SETPOINT-1} are exceeded and/or some other predetermined criteria are met before a decision is made to shut down an mCDU

FIG. 9E provides a flowchart 300C illustrating another example method showing, as a result of redundancy of the mCDUs, a process of taking one of the mCDUs offline due to a malfunction or sub-optimal performance. Thereafter, the CDU can be recalibrated to control flow rate and temperature to and from the CDU based on the remainder of the functioning mCDUs in the system.

At box 310C, a first facility liquid supply temperature T1₁ and a second rack liquid supply temperature T2₁ are obtained. As in previous examples, temperature T1₁ can be obtained by a sensor at or adjacent a coupling that joins a facility shelf supply line of an mCDU to facility supply manifold. For example, sensor S4, which is positioned at or adjacent coupling C4, which couples shelf supply line 30a of mCDU10a to rack supply manifold 24, can provide temperature T1₁. Similarly, a sensor at or adjacent a coupling that couples a rack shelf return line to rack return manifold can provide temperature T2₁, For example, sensor S3 at or adjacent coupling C3, which couples rack return line 34a to rack return manifold 24, can provide second temperature T2₁. In one example, temperature telemetry system 44 will determine temperature T1₁ and temperature T2₁.

At box 312C, a differential temperature or approach temperature ΔT₁ is determined. The approach temperature ΔT₁ can be determined by obtaining the difference between the first facility liquid supply temperature T1₁ and the second rack supply temperature T2₁, as previously described herein. In one example, temperature telemetry system 44 can determine the approach temperature ΔT₁.

At box 314C, the approach temperature ΔT₁ can be compared to malfunction temperature setpoint MT_{SETPOINT-1}. In one example, the malfunction temperature setpoint MT_{SETPOINT-1} can be a predetermined temperature representing the desired temperature difference between the first facility supply fluid temperature as facility supply cooling fluid enters CDU 10 at facility supply manifold 22 in first facility cooling loop 12, and the second rack supply temperature as rack supply cooling fluid exits a particular mCDU, such as mCDU 10a and enters rack supply manifold 24 in second rack cooling loop 14 of CDU 10.

At box 316C, a determination is made as to whether the approach temperature ΔT₁ is greater than the temperature setpoint MT_{SETPOINT-1}.

When the answer to the question in box 316C is "yes" and the approach temperature ΔT₁ is greater than the malfunction temperature setpoint MT_{SETPOINT-1}, the method advances to box 318 and the mCDU which is being evaluated can be shut down.

When the answer to the question in box 316C is "no" the method instead advances back to box 310E.

In other examples, prior to shutting down and/or taking an mCDU offline based on an approach temperature ΔT₁ of the mCDU that exceeds malfunction temperature setpoint MT_{SETPOINT-1}, the control system may require more than one determination and over a period of time to conclusively determine that approach temperature ΔT₁ exceeds malfunction temperature setpoint MT_{SETPOINT-1}. For example, if PLC 42 makes a first determination that approach temperature ΔT₁ exceeds malfunction temperature setpoint MT_{SETPOINT-1}, PLC 42 can make additional determinations to confirm the malfunction based on any predetermined set of criteria. For example, PLC 42 can make two more determinations, such as a second time after fifteen minutes and then a third time after another 15 minutes. If approach temperature ΔT₁ exceeds malfunction temperature setpoint MT_{SETPOINT-1} all three times, PLC 42 can then take mCDU offline. This can help to ensure that the mCDU malfunction determination was not made in error, such as if the excessive temperature was a short-term system anomaly that the system already corrected.

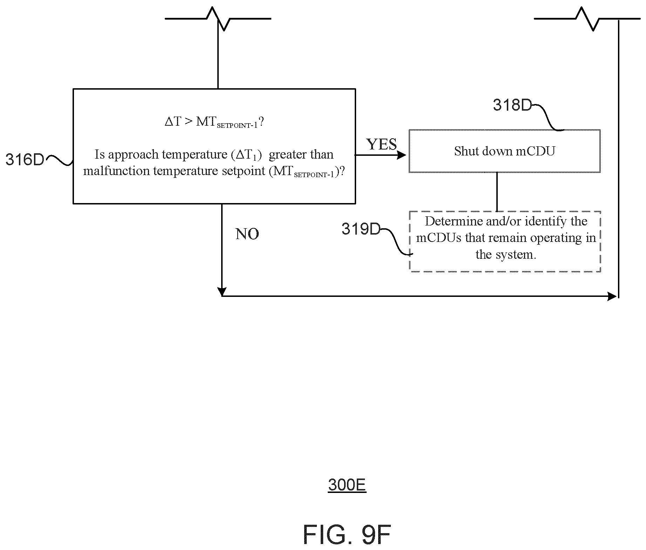

FIG. 9F illustrates another method 300F, which is identical to FIG. 9F, except that it further includes an optional block 319D. As shown, when the mCDU is shut down, a determination can be made as to the number and/or identity of any mCDUs that remain operating in the CDU. This information can be stored and/or conveyed to CDU controller of PCL 42 to determine whether modifications are required for each valve V and pump P for each mCDU 10a-10f, as previously discussed with regards to FIGS. 8A-8B and 9A-9C.

FIGS. 9E-9F provide one example method for determining to shut down an mCDU based upon temperature in cooling system and/or of the CDU. Numerous variations can be made with regard to the methods described in FIGS. 9E and 9F. For example, it may be desired to shut down an mCDU when the differential pressure ΔT₁ is greater than or equal to malfunction temperature setpoint MT_{SETPOINT-1}. Additionally, it may be desired to first assess whether malfunction pressure setpoint MP_{SETPOINT-1} has been exceeded, as previously discussed regarding FIGS. 9C-9D, such that both malfunction temperature setpoint MT_{SETPOINT-1} and malfunction pressure setpoint MP_{SETPOINT-1} are exceeded and/or some other predetermined criteria are met before a decision is made to shut down an mCDU.

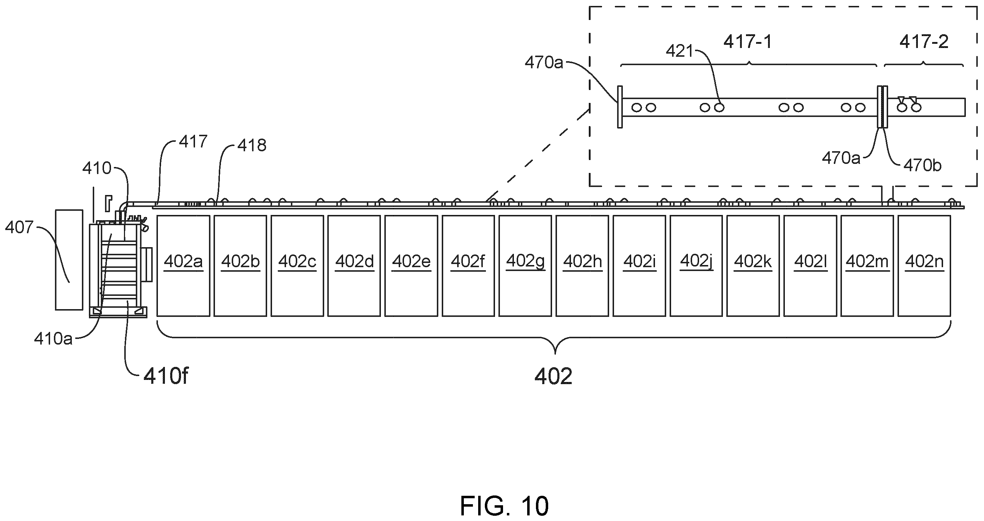

FIG. 10 is a schematic diagram showing modular central rack supply line 417 and modular central rack return line 418, also referred to as modular wall manifolds. The modular wall manifolds allow for a variable number of racks to be added to a cooling system through the use of clamps between each wall manifold section. For example, an additional four racks were added to the prior example, such that there are now fourteen racks 402a-402n (collectively "racks 402") coupled to a single CDU 410 having multiple mCDUs 410a-410f that can regulate the flow of cooling fluid to the racks through secondary or rack loop, as well as allow for improved cooling of cooling fluid that returns from the racks through rack loop. A power supply, such as uninterrupted power supply 407 may be positioned adjacent CDU 410. As shown in the schematic enlarged section, modular wall manifold 417 is shown with two sections: a first section 417-1 of a central supply line and a second section 417-2 of a central supply line. Ports 421 are provided along first and second sections 417-1, 417-2 and are coupled to connectors that are not shown in this view for connecting modular the wall manifolds to racks 402. In one example, quick disconnect valves may be provided along the length of modular wall manifold.

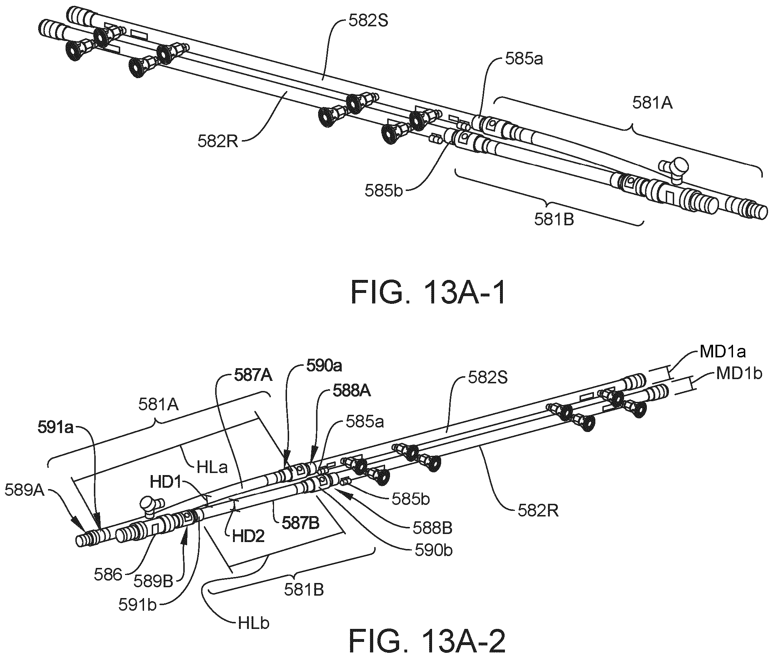

Clamps 470 may be provided at the end of each modular wall manifold section to enable mating to another modular wall manifold section. For example, clamp 470a is provided at the ends of section 417-1 and clamp 470b is shown at the end of section 417-2. In this example, clamps 470a, 470b may be configured so that they can both seal their respective manifold sections and/or interlock with one another. Various types of clamps may be used to enable joining of two manifold sections together. For example, clamps may be configured to mate with one another, such that one clamp includes a male interlocking portion and a second directly adjacent clamp includes a complementary female portion that interlocks with the male interlocking portion to ensure a secure fit. One example clamp that allows for modularity is described in FIGS. 13a-1 through 17B, and will be discussed in greater detail.

FIG. 11 illustrates an example of a physical mCDU unit 410a according to an aspect of the disclosure. The mCDU unit 410a can include similar features and operate in a similar manner as mCDUs previously discussed herein, such as those shown and discussed in FIGS. 1-4, and details of mCDU unit 410a will therefore be limited. In this example, heat exchanger HX-1 allows for the transfer of heat from heated cooling fluid returning from rack manifold to cooling fluid from the supply loop within heat exchanger HX-1. Pump P-1 pumps cooling fluid from mCDU to rack supply manifold and flow control valve V-1 controls flow through primary or supply side. A communication wire connector 473 is illustrated which allows for a wire connection and communication with components within the mCDU and/or the overall system.

FIG. 12 illustrates another view of mCDU 410a. In this example, filtration components may be provided to allow for removal of particulate matter or impurities from cooling fluid within facility shelf supply line 430 and rack shelf supply line 436. For example, sock strainer housings may optionally be provided to filter cooling fluid that implements a sock screen or filter gasket. Sock strainer housing 475 is shown along facility shelf supply line 430, and in one example may be a twenty (20) mesh sock strainer having twenty openings per square inch, but other mesh can be implemented. Sock strainer housing 476 is shown along rack shelf supply line 433, and in one example may be a three hundred twenty-five (325) mesh sock strainer having three hundred twenty-five openings per square inch. In other examples, any other size of mesh may be implemented within respective sock strainer housings 475,476. In still other examples, one or both of sock strainer housings 475,476 can alternatively be provided along other parts or components coupled to mCDU 410a, such as on the facility return line and/or shelf return line.

Tri clamps 477,478 may be provided on respective facility shelf supply line 430 and rack shelf supply line 436 to create leak-proof connections that are easy to assemble, disassemble, and clean. A butterfly check valve 478 may be provided along rack shelf supply line 436 to ensure unidirectional flow of filtered cooling fluid exiting sock strainer housing 476 along rack shelf supply line 436.

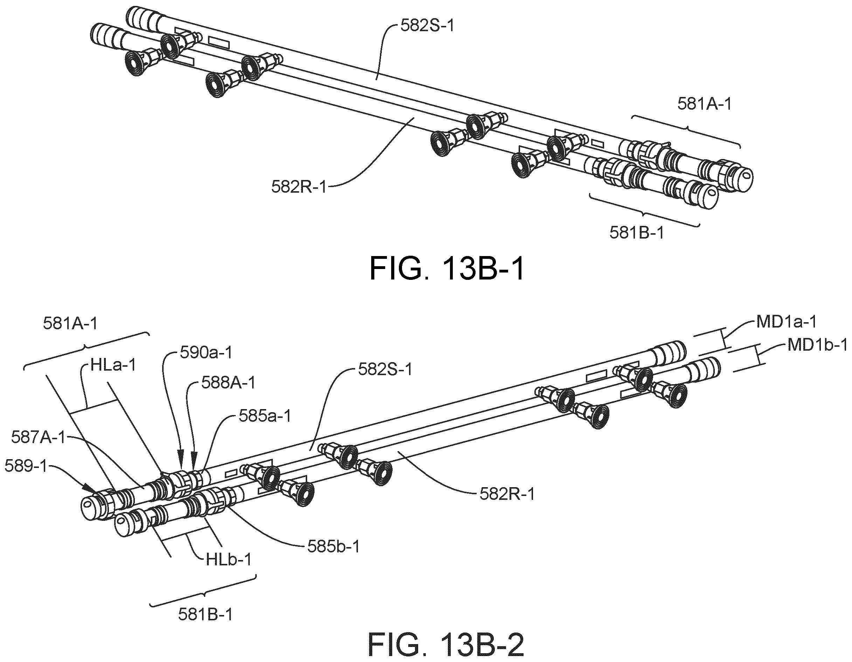

FIGS. 13-18 illustrate various example manifold and manifold adapter configurations, which include hose and clamp configurations to provide another modular manifold system. The modular manifolds described herein can be configured to feed cooling fluid from a CDU to each of the racks coupled to the CDU. The modular manifolds have an extended length to accommodate delivery of cooling fluid to the rack furthest away from the CDU. Instead of having one long modular manifold with a length that extends to the furthest rack and then having to change out the length of the manifold every time a rack is added or removed, manifold adapters can be implemented in the system to provide for greater flexibility in lengthening or shortening the overall rack manifold length.

FIGS. 13A-1, 13A-2, 13B-1, and 13B-2 illustrate respective front top and front bottom perspective views of manifold sections with manifold adapters coupled to an end of the manifold sections according to an aspect of the disclosure. With reference first to FIGS. 13A-1, end 585a of first manifold supply section 582S is shown coupled to first manifold supply adapter 581A and end 585b of first manifold return section 582R is shown coupled to first manifold return adapter 581B. As shown in FIG. 13A-2, first manifold supply adapter 581A and first manifold return adapter 581B may include similar features, such that a discussion of features of one is relevant to the discussion of the other. Manifold adapters may include at least one length of hose and a coupling feature at both ends. In some examples, the coupling feature may be a clamp or other type of coupling. The coupling features may be the same or different.

As shown in FIG. 13A-2, first supply manifold adapter 581A may include a hose 587A and a first clamp connector 588A at a first end 590a of hose 587A, and a second coupling 589A at second end 591a of hose 587A. In this example, coupling 589A is not a clamp and may be a screw connector that is threaded to engage with a connector of another component in the system. First return manifold adapter 581B may include a hose 587B, a first clamp connector 588B at a first end 590b of hose 587B, and second clamp connector 589B at second end 591b of hose 587B. A flow meter may optionally be coupled to any one of the clamp connectors along the supply or return manifold section. For example, flow meter 586, which can be used to indicate the flow rate through hose 587B, is shown coupled to clamp connector 581B.

In this example, first supply manifold diameters MD1a of first manifold supply section 582S and MD1b of first manifold return section 582R may be the same or similar as respective hose diameters HD1 and HD2 to help ensure continuous and uninterrupted flow of cooling fluid through first supply manifold adapters 581A, 581B. Manifold diameters MD1a of first manifold supply section 582S and MD1b of first manifold return section 582R may also be the same relative to one another. The hose lengths HLa of hose 587A and HLb of hose 587B can be any desired length. By way of example only, lengths HLa, HLb may be approximately one-fourth (¼) of the manifold length of a single manifold section.

In other examples, any one of the lengths and diameters of the manifold return and supply sections 582S, 582R, as well as any one of the lengths and diameters of the manifold adapters 581A, 581B can vary and be adjusted to meet any operational needs. For example, FIGS.13B-1 and 13B-2 illustrate another example first manifold supply section 582S-1 and first manifold return section 582R-1, as well as first manifold adapters 581A-1 and 581B-1 coupled to respective ends 585a-1 and 585b-1 of first manifold supply section 582S-1 and first manifold return section 582R-1. In this example, manifold diameters MD1a-1 and MD1b-1 of respective first manifold supply and return sections 582S-1, 582R-1, as shown in FIGS.13B-1 and 13B-2, are greater than first manifold diameters MD1a and MD1b of first manifold supply and return sections 582S, 582R, and hose diameters HD1 and HD2 of hoses 587A and 587B, as shown in FIGS.13B-1 and 13B-2.

FIGS. 15A-15B depict top and bottom views of a plurality of modular manifold supply sections coupled together with manifold adapters, as well as top and bottom views of a plurality of modular manifold return sections coupled together with manifold adapters. For example, first manifold supply section 582S-1, second manifold supply section 582S-2, third manifold supply section 582S-3, and fourth manifold supply section 582S-4 are shown coupled together to form a single elongated manifold section 582S, that can be coupled to additional elongated manifold sections, if desired. As shown, first manifold supply section 582S-1 is coupled to second manifold supply section 582S-2 with a manifold adapter 581A-1. Second manifold supply section 582S-2 is coupled to third manifold supply section 582S-3 with a second manifold adapter 581A-2. Third manifold supply section 582S-3 is coupled to fourth manifold supply section 582-4 with third manifold adapter 581-4.

Similarly, first manifold return section 582R-1, second manifold return section 582R-2, third manifold return section 582R-3, and fourth manifold return section 582R-4 are shown coupled together to form a single elongated manifold return section 582R, that can be further coupled to additional elongated manifold sections, if desired. As shown, first manifold return section 582R-1 is coupled to second manifold return section 582R-2 with a manifold adapter 581A-1. Second manifold return section 582R-2 is coupled to third manifold return section 582R-3 with a second manifold adapter 581A-2. Third manifold return section 582R-3 is coupled to fourth manifold return section 582-4 with third manifold adapter 581-4.

With reference back to FIG. 14A, an enlarged view of a portion of FIG. 15A is shown. An example first manifold supply adapter 581A-1 is shown coupling first manifold supply section 582S-1 to second manifold supply section 582S-2. First manifold supply adapter 581A-1 further includes hose 587A-1 with a first clamp 588A-1 at first end 590-1 of hose 587A-1 and a second clamp 589-1 at second end 591-1 of hose 587A-1. FIG. 14B illustrates an enlarged and exploded view of first clamp 588A-1 standing alone with arms 594 in the open position. As shown, clamp 588A-1 includes a male camlock 592 and female camlock 593. Male camlock 592 has a first end 592A and a second end 592B. First end 592A may be coupled to first manifold supply section 582S-1 and second end 592B couples with female camlock 593. Female camlock 593 includes first end 593A and second end 593B. Arms 594 are rotatable and can move between an open position and a closed position. As shown, arms 594 are in the open position and configured to move and in this example, rotate in the direction of arrows A to a closed position. FIG. 14C shows a cross-sectional view of male camlock 592 and female camlock 593 coupled together in the closed position. Male camlock 592 may be positioned within female camlock 593. In one example, a gasket 595 is positioned between second end 592B of male camlock 592 and first end 593A of female camlock 593 so as to help ensure a leak-proof connection between second end 592B and an interior edge of female gasket 593. Manifold adaptor 581B-1, which couples first return manifold section 582R-1 and second manifold return section 582R-2 may be identical and include the same features.

Manifold adapters 581A-1, 581B-1, as well as all other manifold adapters, can help to improve alignment between elongated sections of the overall manifold. Joining elongated and rigid manifold pipe sections becomes difficult as the length of the pipe or manifold increases, as well as the need to continually add or remove rack servers, which requires restructuring of the existing pipes or manifolds to accommodate change. Providing a flexible and intermediate manifold adapter can allow for greater ease of assembly when joining manifold sections together. This minimizes the attention or focus diverted to data center infrastructure since it is no longer necessary to obtain custom length manifold sections to meet data room needs or to replace existing manifold assemblies that do not support a revised configuration of data racks. Manifold adapters 581A-1, 581B-1 and any manifold adapters further take up the difference in tolerances between two elongated wall manifold sections to provide for a better and more secure fit than directly connecting two elongated wall manifold sections directly together or through use of a rigid connector. Moreover, this can help to improve coupling of manifold sections together to allow for greater ease of assembly.

The hoses used to comprise example hoses 587, 587-1, and any hoses in these systems or any systems described herein may be comprised of a flexible piping that allows for the flow of cooling fluid therethrough. In some examples, hose 587-1 may be comprised of rubber or silicone, may be a homogeneous material, may be comprised of a tube with an outer cover, or may be a tube with an outer cover with intermediate layers provided between the tube and outer cover.

Manifold sections 582S, 582S-1, 582S-1, 582S-2, 582S-3, 582S-4, 582R, 582R-1, 582R-2, 582R-3, and 582R-4, described above, as well as manifolds described in any systems described herein may be comprised of various materials. In some examples, manifolds may be comprised of metal piping, such as stainless steel or copper. In other examples, manifolds may be comprised from polymers, including plastic compounds and high-quality polymers such as including without limitation, polyethylene, PVC, or PEX. In some examples, the polymers that are durable, UV resistant, and have low thermal conductivity may be selected.

FIGS. 16A-16B show examples in which modular adapters provide the ability for fluid in the cooling system to be easily redirected to another non-parallel component or a component that does not extend in the same parallel direction as the manifold sections previously discussed herein. For example, when it is desired to change flow direction, such that the fluid flow no longer flows in the same general direction as a manifold or hose, one side of the hose may be connected to an alternative pipe or hose through a clamp connector or other coupling. For example, as shown in FIG. 16A, a manifold supply adapter 681A may be provided along a manifold supply line and include a hose 687A having a clamp connector 688A coupled to an end 690a of hose 687A. First end 697a of clamp connector 688A is shown connected to a pipe connector 699A and second end 698a of clamp connector 688A may be connected to hose 687A. Pipe connector 699A may be a multi-directional pipe in which cooling fluid may flow in more than one direction. As shown, a section of pipe connector 699A includes first section 699A-1, second section 699A-2, and third section 699A-3. Second section 699A-2 extends in a direction that is angular or non-parallel to the direction in which the component connected to clamp connector 688A at its second end 698a extends, which in this example is hose 687A.

In another example, a different component and/or connector may instead be attached to one end of the manifold adapter hose of a manifold adapter. For example, manifold adapter 681B may be provided along a return manifold line. Manifold adapter 681B may include hose 687B with clamp connector 688B at a first end 690b of hose 687B and, instead of a second similar type of clamp at second end 691b of hose 687B, second end 691b may be directly connected to another pipe 699B via an intermediate coupling 689B. As shown, hose 687B provides the flexibility needed to allow for a change in direction of cooling fluid flowing therethrough and to allow for a coupling 689B at end 691b of hose 687B with pipe connector 699B, which in this example is an elbow. Coupling 689B may be any coupling that allows for connection of hose 687B to pipe connector 699B. As shown in FIG. 16B, pipe connector 699B directs flow in a direction perpendicular to the direction of hose 687B. Similarly, third section 699A-3 of pipe connector 699A along supply manifold 682 also extends in a direction perpendicular to the direction of first section 699A-1 of pipe connector 699A and hose 687A.

FIGS. 17A-17B show additional images of supply manifold line 682 and return manifold line 683 respectively exiting and entering CDU, and which are coupled to manifold adapters 681A, 681B. Manifold adapter 681B is further shown coupled at one end to flow meter 686.

FIG. 18 depicts a portion of a modular wall manifold system 600 that can be implemented into an overall cooling system, such as a cooling system described herein, according to an aspect of the disclosure. Manifold 603 may be a central rack supply manifold of a cooling system and may include ports 621a, 621b, 621c, 621d that are coupled to quick disconnect couplings 628a, 628b, 628c, 628d. Ports 621a, 621b, 621c, 621d may be placeholder ports that are not in use, but can be later utilized if additional racks are later connected to cooling system.

While not in use, hose kits may be coupled to ports 628a, 628d to allow for continued flow of fluid in the cooling system. As shown, hose kit 602 can include a hose 642A with a first quick disconnect coupling 650a that is coupled to quick disconnect coupling 628a of port 621a, as well as a second quick disconnect coupling 650b. Hose kit 604 can include a hose 642B with a first quick disconnect coupling 652a that is coupled to quick disconnect coupling 628d of port 621d, and a second quick disconnect coupling 652b that is coupled to second quick disconnect coupling 650b. In this configuration, fluid flow is permitted between the supply and return manifolds through hoses 642A, 642B, which allow for flow through supply and return manifolds. When data racks are subsequently added to cooling system, couplings 650b, 652b can be disconnected from one another and then connected to respective rack supply and rack return manifolds to allow for flow to rack supply and return manifolds.

FIGS. 19-21 illustrate example charging tools that can be used for system liquid recharge and repressurization and in some examples, the charging tools can be used to help fill or clean any components coupled to a CDU, such as mCDUs, tray server cooling loops, manifolds, and the like. The charging tools may be used to pressurize the overall cooling system once it has been filled. A bladder of pressurized air may be provided within the charging tool to pressurize liquid in the CDU system.

FIG. 19 illustrates a first example charging tool or unit 700 that can be used to fill or charge a CDU with rack supply cooling fluid. For example, charging tool or unit 700 may be movable and provided on a movable base, such as cart 701. Charging unit 700 may include a tank 702 of high pressure cooling fluid that can be used to charge a rack supply manifold with cooling fluid. Tank 702 may have a high volume, such as 150 gallon tank. Hose 711 can couple outlet valve 712 to charge a rack supply manifold. A pump can draw out liquid from tank 702 and pump cooling liquid into the CDU and/or component coupled to CDU. Pressure in tank 702 may be monitored and regulated with pressure regulator 704 and pressure gauge 706 to help maintain a sufficient amount of pressure to ensure flow of cooling fluid into manifold and throughout the CDU system. Inlet valve 714 can be used to refill and pressurize tank 702 with cooling fluid or other liquid.

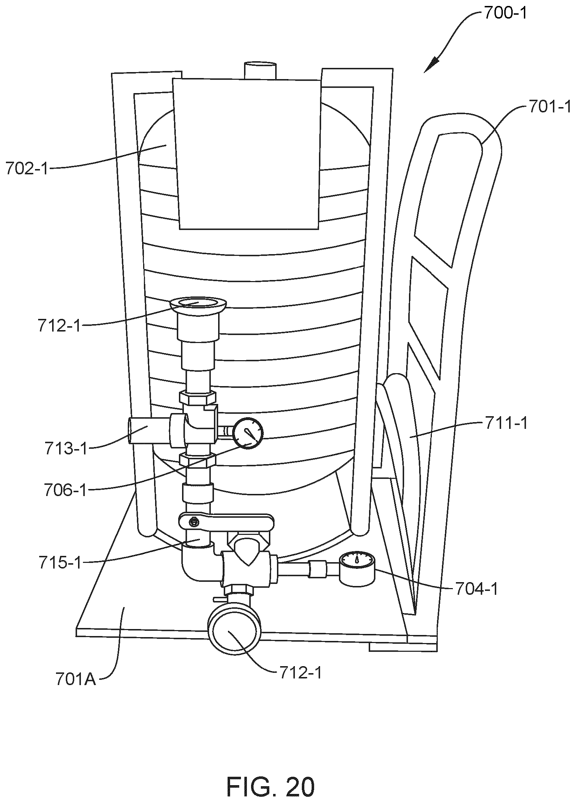

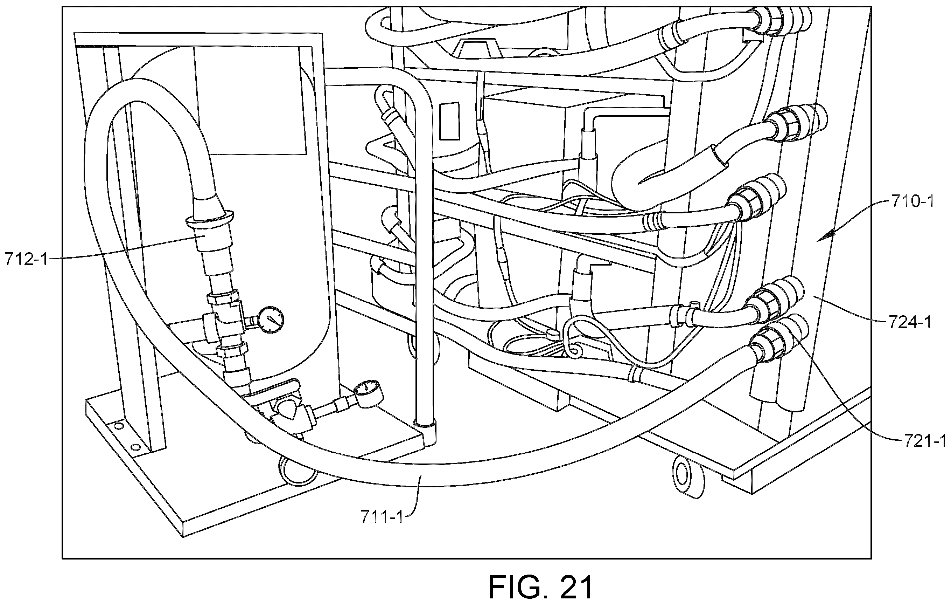

FIG. 20 illustrates another example charging tool 700-1, which may be on a movable cart 701-1. Charging tool 700-1 may also operate in a similar manner as charging tool 700, but include components that are positioned toward base 701A of cart 701-1. For example, charging tool 700-1 may include a tank 702-1, an outlet pressure gauge 706-1 and a pressure regulator 713-1. Pressure in charging tool 700-1 can be determined based on inlet pressure gauge 704-1 and pressure regulator 713-1. A ball valve 715-1 may also be present. In use, as shown in FIG. 21, one end of hose 711-1 can couple with outlet valve 712-1 and a second end of hose 711-1 can couple with a port on CDU 710-1, such as a CDU fill port 721-1 on supply manifold 724-1.

To fill and purge the cooling system, a feeder kit may be implemented. For example, a feeder kit can be used to both flush the entire cooling system or components of cooling system, as well as fill the system with cooling fluid. For example, a tank can be filled with a liquid cleaning agent and pumped throughout a CDU unit, including mCDUs, piping, and components which are connected to the CDU. Once the CDU unit is cleaned, a tank may be filled with cooling fluid, which can then be used to fill the CDU unit and mCDUs with cooling fluid.

FIGS. 22-23 illustrate an example feeder kit 800 that allows for commissioning of the data rack, including cooling system liquid refill and pressurization. As shown, feeder kit 800 includes a tank 802, which in this example may be a 150 gallon tank, although any size tank can be implemented. Hose 811 can be coupled to outlet valve 812, which regulates the flow of fluid into and out of tank 802. A filter and mesh strainer may be provided to filter particulates that may be present in the fluid. A pump 807 may pump liquid from tank 802 through hose 811 and into a CDU, as disclosed herein, or other component coupled to the CDU. Pressure gauge quick disconnect 817 may be provided. Feeder kit 800 can also be used to purge cooling fluid from the cooling system and CDU system. As shown, a purge button 819 may allow for the purging or withdrawal of cooling fluid from a CDU or component of a cooling system connected to the CDU and into another tank, such as tank 802. For example, purge lines 813 and return hose 815 can be implemented to allow for withdrawal of fluid from a CDU or component coupled to a CDU.

FIGS. 24-28 illustrate an example cold plate loop and rack manifold fill and purge tool 900, which can be utilized to service IT equipment trays, such as server trays housed in data racks that are coupled to the CDU. FIGS. 24-25 show respective front and rear views of tool 900, which is housed in a cart 901. Tool 900 may be a smaller version of the feed kit and/or charger kit previously described herein, since the amount of fluid required to service and charge cooling loops on server trays is significantly reduced, compared to the amount of fluid required to charge the CDU and manifolds coupling the data racks with the CDU. FIG. 24 illustrates some of the components of cart 901, including pressure gauge 905, pump 918, check valve 919, pressure sensor 926, and filter 921. In this example, an operator can operate tool 900 using computing or control system 928 housed in a control box 928A. An operator can operate tool 900 and otherwise communicate with the control system 928 through screen 929, which in this example may be a touch screen.

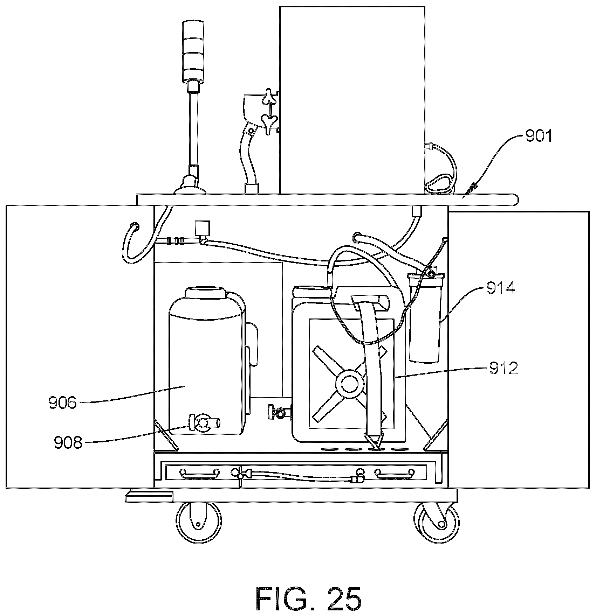

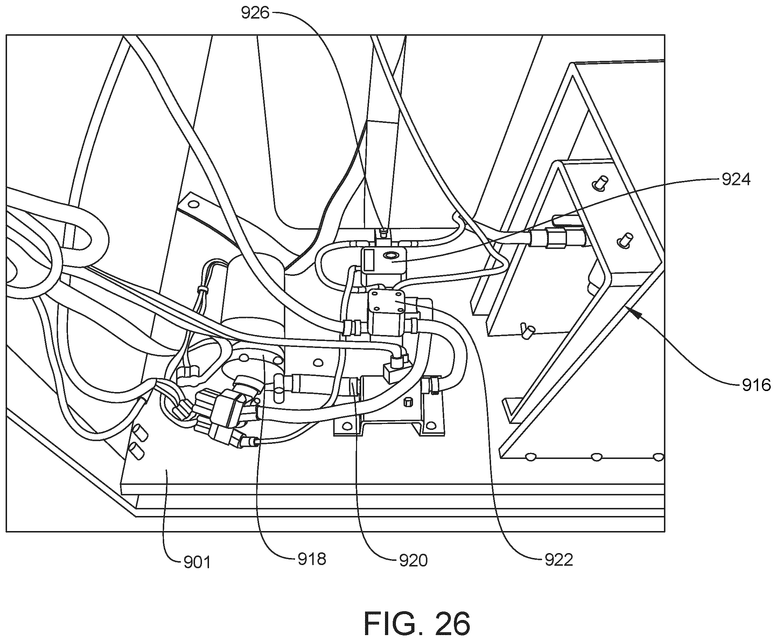

FIG. 25 depicts a drain tank 906, drain valve 908, and hose that can be used to collect fluid withdrawn from a server tray, such as from a cooling loop disposed on a server tray. Supply tank 912 is also shown with a filter 914 and hoses to supply cooling fluid to a tray and also allow for return of fluid to drain tank 906. FIG. 26 shows another view of internal components on cart 901. An example air compressor 916, pump 918, pressure sensor 920, solenoid valve 922 for water, solenoid valve 924 for air, and pressure sensor 926 for gas can be seen in this view. Air compressor 916 can be used to assist with pushing out or purging liquid from the cooling loops on IT equipment trays on the data racks. As best shown in FIG. 24, tool 900 may be coupled directly or wirelessly to a computing system 928 that assists with operation of tool 900.

FIGS. 27-28 depict schematic views of cold plate loop and rack manifold purge tool 900. With reference first to FIG. 27, tool 900 is schematically illustrated. As shown, supply hose 931A and return hose 931B with corresponding quick disconnects 932A, 932B can be provided with cart 901. Hoses 931A, 931B can be coupled with ports on server trays or otherwise coupled with a component that can enable servicing of cooling loops on server trays, including charging cooling loops or purging liquid from cooling loops using compressed air from air compressor 916.

FIG. 28 schematically illustrates supply lines 950 and return lines 952 within cabinet 901. A liquid supply tank 912 may contain cooling fluid or other fluid that is pumped through a hose or line to the IT equipment on a data rack. Valve 922, which in some examples may be a solenoid valve, may be provided along supply line 950. Valve 924, which may also be a solenoid valve, may be provided along line 950A, which feeds into supply line 950. A tank 918 for liquid return or waste is also shown that receives liquid returned along return line 952 from IT equipment trays and/or data racks. A valve 925, such as a solenoid valve, may be positioned along return line 952. Each of the solenoid valves 922, 924, 925 may be activated or opened by computing device 928, so as to pressurize cold plate loops on the IT equipment trays with liquid.

According to an aspect of the disclosure, a system for thermal management of computing devices includes a first facility cooling loop, a second rack cooling loop, and a primary and modular fluid coolant distribution unit ("CDU"). Facility cooling fluid flows through the first facility cooling loop, which includes a central facility supply line and a central facility return line. Rack cooling fluid flows through the second rack cooling loop and includes a central rack supply line and a central rack return line. The CDU distributes rack cooling fluid to a data rack and further includes a facility supply manifold coupled to the central facility supply line, a facility return manifold coupled to the central facility return line, a rack supply manifold coupled to the central rack supply line, a rack return manifold coupled to the central rack return line, and a plurality of micro or compact modular CDU ("mCDU") units. Each mCDU unit further includes a facility shelf supply line that is coupled to the facility supply manifold; a facility shelf return line that is coupled to the facility return manifold; an adjustable control valve that is positioned along the shelf return line; a rack shelf supply line that is coupled to the rack supply manifold; a rack shelf return line that is coupled to the rack return manifold; a pump that is positioned along the rack shelf supply line; and a heat exchanger that is disposed between the first facility cooling loop and the second rack cooling loop. The heat exchanger has a first portion forming part of the first facility cooling loop and a second portion forming part of the second rack cooling loop. Heat from the rack cooling fluid within the second portion of the heat exchanger is transferred to the facility cooling fluid within the first portion of the heat exchanger. The facility supply manifold, the facility return manifold, the facility shelf supply line, and the facility shelf return line collectively form part of the first facility cooling loop. The rack supply manifold, the rack return manifold, the rack shelf supply line, and the rack shelf return line form part of the second rack cooling loop. Facility cooling fluid from the first facility cooling loop and rack cooling fluid from the second rack cooling loop are isolated from one another; and/or
each mCDU further comprises a fluid reservoir along the second rack cooling loop. The fluid reservoir supplies rack cooling fluid to the pump; and/or
each of the plurality of mCDUs further includes a first filter positioned along the first facility cooling loop and a second filter positioned along the second rack cooling loop; and/or
the system further includes a CDU housing. The facility supply manifold and the facility return manifold are positioned adjacent one side of the CDU housing. The rack supply manifold and the rack return manifold are positioned adjacent an opposed side of the CDU housing; and/or
the system further includes a CDU housing having movable shelves. Each mCDU is positioned adjacent one of the movable shelves so that each mCDU overlies one another; and/or
the CDU housing includes a front and a rear. The front of the CDU housing has an opening and the plurality of mCDUs are arranged on the movable shelves so that the mCDUs are exposed through the opening and accessible at the front of the CDU housing; and/or
the plurality of mCDUs is six mCDUs, wherein only five mCDUs are required to operate the system, and wherein the sixth mCDU provides redundancy for the CDU; and/or
one of the plurality of mCDUs is a redundant mCDU such that the system can operate without the redundant mCDU; and/or
the system further includes a data rack, which further includes a data rack housing; a plurality of movable shelves; a plurality of computing devices disposed at the plurality of shelves; a first data rack housing supply manifold and a first data rack housing return manifold positioned on one side of the data rack housing; and a second data rack housing supply manifold and a second data rack housing return manifold positioned on an opposed side of the data rack housing. The first data rack housing supply manifold and the second data rack housing supply manifold are coupled to the central rack supply line. The second data rack housing return manifold and the second data rack housing return manifold are coupled to the central rack return line; and/or
the system further includes one or more processors in communication with the valve of each of the plurality of mCDU. The one or more processors may be configured to receive a first temperature from a facility supply side of the first facility cooling loop; receive a second temperature from a rack supply side of the second rack cooling loop; compare a difference between the first temperature and the second temperature to a predetermined approach temperature setpoint; determine whether the difference is greater than, equal to, or less than a predetermined temperature setpoint; and adjust a size of the opening of the valve based on the determination that the difference is either greater than or less than the predetermined temperature setpoint; and/or
the predetermined approach temperature setpoint is a predetermined threshold difference between a temperature of facility cooling fluid as the facility cooling fluid in the first facility cooling loop enters each mCDU and a temperature of rack supply fluid as the rack cooling fluid in the second rack cooling loop exits each mCDU and approaches the at least one data rack; and/or
the system further comprises includes a temperature telemetry system. The temperature telemetry system may provide the first temperature of the facility cooling fluid. The first temperature is the temperature of the facility cooling fluid at or near a connection between the facility supply manifold and the facility shelf supply line; and/or
the temperature telemetry system provides the second temperature of the rack cooling fluid, wherein the second temperature is the temperature of the rack cooling fluid at or near a connection between the rack supply manifold and the rack shelf supply line; and/or
the one or more processors are in communication with the pump. The one or more processors are further configured to receive a first flow rate pressure of rack cooling fluid from a rack supply side of the second rack cooling loop; receive a second flow rate pressure data of rack cooling fluid from a rack return side of the second rack cooling loop; compare an actual difference between the first flow rate pressure and the second flow rate pressure to a predetermined flow rate pressure difference setpoint; determine whether the actual difference is greater than, equal to, or less than the predetermined flow rate pressure difference setpoint; and adjust a speed of the pump based on a determination that the actual difference is either greater than or less than the predetermined flow rate pressure difference setpoint; and/or
the predetermined pressure difference setpoint is a predetermined threshold difference between the flow rate pressure of rack fluid exiting each mCDU and the flow rate pressure of rack fluid returning to each mCDU; and/or
the system further comprises a pressure telemetry system. The pressure telemetry system may provide the first flow rate pressure of the rack cooling fluid. The first flow rate pressure is the flow rate pressure of rack cooling fluid at or near a connection between the rack supply manifold and the rack shelf supply line; and/or
the pressure telemetry system provides the second flow rate pressure of the rack cooling fluid. The second flow rate pressure is the flow rate pressure of rack cooling fluid at or near a connection between the rack return manifold and the rack shelf return line.

According to another aspect of the disclosure, a method for providing liquid cooling for a data center includes adjusting a valve opening of a micro or compact modular coolant distribution unit ("mCDU") of a CDU of a data center cooling system. The adjusting the valve includes obtaining a first facility liquid supply temperature and a second rack liquid supply temperature; determining an actual approach temperature by obtaining a difference between the first facility liquid supply temperature and the second rack liquid supply temperature; comparing the actual approach temperature to a predetermined approach temperature setpoint; wherein when the actual approach temperature is greater than the predetermined approach temperature setpoint, increasing a size of the opening of the valve; wherein when the actual approach temperature is less than the predetermined approach temperature setpoint, decreasing a size of the opening of the valve; wherein when the actual approach temperature is neither greater or less than the predetermined approach temperature setpoint, the approach temperature is equal to the approach temperature setpoint and the valve may remain the same; and/or
the CDU comprises a plurality of mCDUs having a plurality of valves, and the method includes adjusting each of the plurality of valves; and/or
when the actual approach temperature is greater than or less than the predetermined approach temperatures setpoint, a determination can be made as to how much to adjust the valve opening to bring the size closer to the predetermined approach temperature setpoint; and/or
the method further includes adjusting a pump speed of a pump of the mCDU on a rack supply side. The method for adjusting the pump speed further includes obtaining a first flow rate pressure of rack cooling fluid from the rack supply side of the second rack cooling loop; obtaining a second flow rate pressure data of rack cooling fluid from a rack return side of the second rack cooling loop; obtaining an actual pressure differential between the first flow rate pressure and the second flow rate pressure; wherein when the actual pressure differential is greater than a predetermined pressure difference setpoint, decreasing a speed of the pump, and wherein when the actual pressure differential is less than the predetermined pressure difference setpoint, increase a speed of the pump, and wherein when the actual pressure differential is neither greater than or less than the predetermined pressure difference setpoint, the approach temperature is equal to the approach temperature setpoint and a current pump speed can be maintained.

According to an aspect of the disclosure, a fluid coolant distribution unit ("CDU") is disclosed. The CDU further includes a CDU inlet, a facility valve, a CDU outlet, a CDU inlet, a facility supply manifold fluidly, a facility return manifold, a rack supply manifold, a rack return manifold, and a plurality of modular CDUs ("mCDUs"). Facility cooling fluid from a central facility supply line external to the CDU flows through the CDU inlet. A CDU outlet may be fluidly coupled to a central rack supply line external to the CDU and a rack cooling fluid may exit the CDU through the CDU outlet and flow to a plurality of downstream data racks fluidly coupled to the CDU. A facility supply manifold may be fluidly coupled to the central facility supply line. The CDU inlet may be positioned between the facility supply manifold and the central facility supply line. The facility return manifold may be fluidly coupled to a central facility return line and the rack supply manifold may be fluidly coupled to the central rack supply line. The CDU outlet may be positioned between the rack supply manifold and the central facility supply line. A plurality of modular CDUs ("mCDU"), each mCDU may include a facility shelf supply line, a facility shelf return line, a control valve, a rack shelf supply line, a rack shelf return line, a pump and a heat exchanger. The facility shelf supply line may be coupled to the facility supply manifold. The facility shelf return line coupled to the facility return manifold. The control valve may be configured to regulate the amount of facility cooling fluid flowing through the mCDU. The rack shelf supply line may be coupled to the rack supply manifold. The rack shelf return line may be coupled to the rack return manifold. The pump may be positioned along the rack shelf supply line. The heat exchanger may be disposed between a first facility cooling loop and a second rack cooling loop. The heat exchanger configured to transfer heat from the rack supply fluid flowing through a portion of the second rack cooling loop within the mCDU. The facility supply manifold, the facility return manifold, the facility shelf supply line of each of the mCDUs, and the facility shelf return line of each of the mCDUS comprise the first facility cooling loop. The rack supply manifold, the rack return manifold, the rack shelf supply line of each of the mCDUS, and the rack shelf return line of each of the mCDUS comprise the second rack cooling loop. The facility cooling fluid from the first facility cooling loop and the rack cooling fluid from the second rack cooling loop are isolated from one another. The facility shelf supply lines of each of the plurality of mCDUs collectively supply the rack cooling fluid flowing through the rack supply manifold and the CDU outlet to the plurality of downstream racks; and/or
a facility valve configured to regulate an amount of cooling fluid from the central facility supply line that flows through the CDU; and/or
each mCDU further comprises a fluid reservoir positioned along the second rack cooling loop, the fluid reservoir supplying the rack cooling fluid to the pump; and/or
each of the plurality of mCDUs further comprises a first filter positioned along the first facility cooling loop and a second filter positioned along the second rack cooling loop; and/or
the CDU further comprises a CDU housing having movable shelves. Each mCDU is positioned adjacent one of the movable shelves so that each mCDU overlies one another. The CDU housing including a front and a rear, wherein a front of the CDU housing has an opening and the plurality of mCDUs are arranged on the movable shelves so that the mCDUs are exposed through the opening and accessible at the front of the CDU housing; and/or
the facility supply manifold, the facility return manifold, the rack supply manifold, and the rack return manifold are coupled to the CDU housing so as to be movable with the CDU; and/or
the plurality of mCDUs includes a redundant mCDU, wherein the redundant mCDU operates at the same time as the other plurality of mCDUs, and wherein the redundant mCDU is not required for the CDU to operate; and/or
the plurality of mCDUs comprises six mCDUs, and wherein only five mCDUs are required for the CDU to operate, and wherein the sixth mCDU is a redundant mCDU.

According to another aspect of the disclosure, a system for liquid cooling of information technology ("IT") equipment comprises a fluid coolant distribution unit ("CDU") according to the aspects of the disclosure as described in paragraph [00223] above. The control system may may comprise one or more processors in communication with the valve of each of the plurality of mCDUs. For each of the plurality of mCDUs the one or more processors are configured to obtain a first temperature of the facility cooling fluid entering the mCDU along the facility shelf supply line; obtain a second temperature of the rack cooling fluid exiting the mCDU along the rack shelf supply line; determine a difference between the first temperature and the second temperature; compare the difference to a predetermined temperature setpoint; determine whether the difference is greater than, equal to, or less than the predetermined temperature setpoint; and modify a size of the opening of the control valve when the difference is either greater than or less than the predetermined temperature setpoint; and /or
the predetermined temperature setpoint is a predetermined threshold difference between a temperature of facility cooling fluid at the CDU inlet and a temperature of rack supply fluid at the CDU outlet; and/or
the first temperature of the facility cooling fluid is the temperature of the facility cooling fluid at or near a connection between the facility supply manifold and the facility shelf supply line; and/or
the second temperature of the rack cooling fluid is the temperature of the rack cooling fluid at or near a connection between the rack supply manifold and the rack shelf supply line; and/or
the one or more processors further communicate with the pump of each of the plurality of mCDUs, and for each of the plurality of mCDUs the one or more processors are configured to obtain a first flow rate pressure of rack cooling fluid exiting the mCDU along the rack shelf supply line; obtain a second flow rate pressure of rack cooling fluid entering the mCDU along the rack shelf return line; determine the difference between the first flow rate pressure and the second flow rate pressure; compare the difference to a predetermined flow rate pressure difference setpoint; determine whether the difference is greater than, equal to, or less than the predetermined flow rate pressure difference setpoint; and modify a speed of the pump when the difference is either greater than or less than the predetermined flowrate pressure difference setpoint; and/or
   the predetermined flow rate pressure difference setpoint comprises a predetermined threshold difference between a flow rate pressure of the rack cooling fluid exiting the rack supply manifold and a flow rate pressure of the rack cooling fluid entering the rack return manifold; and/or
the predetermined flow rate pressure difference setpoint comprises a predetermined threshold difference between a flow rate pressure of the rack cooling fluid CDU outlet adjacent the rack supply manifold and the rack cooling fluid entering the rack return manifold at a CDU inlet adjacent the rack return manifold; and/or
the first flow rate pressure comprises the flow rate pressure of the rack cooling fluid at or near a connection between the rack supply manifold and the rack shelf supply line.; and/or
the second flow rate pressure of the rack cooling fluid comprises the flow rate pressure of rack cooling fluid at or near a connection between the rack supply manifold and the rack shelf supply line; and/or
the system further comprises the first facility cooling loop, the second rack cooling loop, and the plurality of downstream data racks. Facility cooling fluid flows through the first cooling loop. The first facility cooling loop further comprises the central facility supply line and the central facility return line. The rack cooling fluid flows through the second rack cooling loop. The second rack cooling loop comprising the central rack supply line and the central rack return line; and/or
each of the plurality of downstream data racks further comprise a data rack housing having a plurality of shelves for housing a plurality of computing devices disposed at the plurality of shelves. A first data rack housing supply manifold and a first data rack housing return manifold may be positioned adjacent the data rack housing. A second data rack housing supply manifold and a second data rack housing return manifold positioned adjacent the data rack housing. The first data rack housing supply manifold and the second data rack housing supply manifold may be coupled to the central rack supply line. The second data rack housing return manifold and the second data rack housing return manifold may be coupled to the central rack return line; and/or
the central rack supply line further comprises a plurality of elongated manifolds through which cooling fluid flows, the plurality of elongated manifolds having ends coupled together, the elongated manifolds overlying the plurality of downstream data racks, the system further comprising at least one manifold adapter coupling a first manifold and a second manifold of the plurality of elongated manifolds together, each of the first and second manifolds having an end, the manifold adapter comprising a hose having a male clamp connector at first and second ends of the manifold adapter, the first end of the male clamp connector coupling with a first female connector coupled to an end of the first manifold, and the second end of the male clamp connector coupling with a second female connector coupled to an end of the second manifold; and/or
the system further includes a control system comprising one or more processors in communication with each of the plurality of mCDUs and a power distribution unit ("PDU") configured to supply power to each of the plurality of mCDUs. For each of the plurality of mCDUs the one or more processors are configured to obtain a first facility liquid supply temperature and a second rack liquid supply temperature; determine an approach temperature by obtaining a difference between the first facility liquid supply temperature and the second rack liquid supply temperature; compare the approach temperature to a malfunction temperature setpoint; and instruct the PDU to shut down power to the mCDU when the approach temperature is greater than the malfunction temperature setpoint; and/or
the system further includes a control system comprising one or more processors in communication with each of the plurality of mCDUs and a power distribution unit ("PDU") configured to supply power to each of the plurality of mCDUs. For each of the plurality of mCDUs the one or more processors are configured to: obtain a first rack supply pressure and a second rack fluid return pressure; determine a differential pressure by determining a difference between the first rack supply pressure and the second rack fluid return pressure; compare the differential pressure to a malfunction pressure setpoint; and instruct the PDU to shut down power to the mCDU when the differential pressure is greater than malfunction pressure setpoint.

According to another aspect of the disclosure, a method for providing liquid cooling of information technology equipment in a data center comprises adjusting a size of a plurality of valve openings of a corresponding plurality of valves. Each valve corresponds to one of a plurality of modular coolant distribution units("mCDUs") of a coolant distribution unit ("CDU") and each valve is configured to regulate an amount of cooling fluid flowing through the corresponding one of the plurality of mCDUs. For each of the plurality of mCDUs, the adjusting comprises obtaining a first facility liquid supply temperature and a second rack liquid supply temperature; determining an approach temperature by obtaining a difference between the first facility liquid supply temperature and the second rack liquid supply temperature; comparing the approach temperature to a predetermined approach temperature setpoint; increasing the size of the opening of the valve when the approach temperature is greater than the predetermined approach temperature setpoint; decreasing the size of the opening of the valve when the approach temperature is less than the predetermined approach temperature setpoint; and making no adjustments to the size of the opening when the approach temperature is equal to the predetermined approach temperature setpoint; and/or
adjusting a pump speed of a plurality of valve pumps of a corresponding plurality of the mCDUs. Each of the plurality of pumps is configured to regulate a rate of flow of cooling fluid flowing through each of the corresponding plurality of mCDUs. The adjusting comprising for each of the plurality of mCDUs: obtaining a first flow rate pressure of rack cooling fluid from a rack supply side of the second rack cooling loop; obtaining a second flow rate pressure data of rack cooling fluid from a rack return side of the second rack cooling loop; obtaining an a pressure differential between the first flow rate pressure and the second flow rate pressure; decreasing the pump speed when the pressure differential is greater than a predetermined pressure difference setpoint; increasing the pump speed when the pressure differential is less than the predetermined pressure difference setpoint; and making no adjustments to the pump speed when the pressure differential is equal to the predetermined pressure difference setpoint.

Although the technology herein has been described with reference to particular examples, it is to be understood that these examples are merely illustrative of the principles and applications of the disclosed technology. It is, therefore, to be understood that numerous modifications may be made to the illustrative examples and that other arrangements may be devised without departing from the spirit and scope of the present technology as defined by the appended claims.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including," and the like, should not be interpreted as limiting the subject matter of the claims to the specific examples; rather, the examples are intended to illustrate only some but not all possible variations of the disclosed technology. Further, the same reference numbers in different drawings can identify the same or similar elements.

## Claims

1. A fluid coolant distribution unit ("CDU") comprising:
a CDU inlet through which a facility cooling fluid from a central facility supply line external to the CDU flows;
a CDU outlet fluidly coupled to a central rack supply line external to the CDU and through which a rack cooling fluid exits the CDU and flows to a plurality of downstream data racks fluidly coupled to the CDU;
a facility supply manifold fluidly coupled to the central facility supply line, the CDU inlet being positioned between the facility supply manifold and the central facility supply line;
a facility return manifold fluidly coupled to a central facility return line;
a rack supply manifold fluidly coupled to the central rack supply line, the CDU outlet being positioned between the rack supply manifold and the central facility supply line;
a rack return manifold fluidly coupled to a central rack return line;
a plurality of modular CDUs ("mCDUs"), each mCDU comprising:
a facility shelf supply line coupled to the facility supply manifold;
a facility shelf return line coupled to the facility return manifold;
a control valve configured to regulate the amount of facility cooling fluid flowing through the mCDU;
a rack shelf supply line coupled to the rack supply manifold;
a rack shelf return line coupled to the rack return manifold;
a pump positioned along the rack shelf supply line, and
a heat exchanger disposed between a first facility cooling loop and a second rack cooling loop, the heat exchanger configured to transfer heat from the rack cooling fluid flowing through a portion of the second rack cooling loop within the mCDU to the facility cooling fluid flowing through a portion of the
first facility cooling loop within the mCDU,
wherein the facility supply manifold, the facility return manifold, the facility shelf supply line of each of the mCDUs, and the facility shelf return line of each of the mCDUs comprise the first facility cooling loop,
wherein the rack supply manifold, the rack return manifold, the rack shelf supply line of each of the mCDUs, and the rack shelf return line of each of the mCDUS comprise the second rack cooling loop,
wherein the facility cooling fluid from the first facility cooling loop and the rack cooling fluid from the second rack cooling loop are isolated from one another, and
wherein the facility shelf supply lines of each of the plurality of mCDUs collectively supply the rack cooling fluid flowing through the rack supply manifold and the CDU outlet to the plurality of downstream data racks.

2. The CDU of claim 1, further comprising a facility valve configured to regulate an amount of cooling fluid flowing through the CDU from the central facility supply line; and/or
each mCDU further comprises a fluid reservoir positioned along the second rack cooling loop, the fluid reservoir supplying the rack cooling fluid to the pump; and/or
each of the plurality of mCDUs further comprises a first filter positioned along the first facility cooling loop and a second filter positioned along the second rack cooling loop.

3. The CDU of claim 1 or claim 2, wherein the facility supply manifold, the facility return manifold, the rack supply manifold, and the rack return manifold are coupled to the CDU housing so as to be movable with the CDU.

4. The CDU of any one of claims 1 to 3, wherein the plurality of mCDUs includes a redundant mCDU, wherein the redundant mCDU operates at the same time as the other plurality of mCDUs, and wherein the redundant mCDU is not required for the CDU to operate; and optionally
wherein the plurality of mCDUs comprises six mCDUs, and wherein only five mCDUs are required for the CDU to operate, and wherein the sixth mCDU is a redundant mCDU.

5. A system for liquid cooling of information technology equipment in a data center comprising:
the CDU of any one of claims 1-4; and
a control system comprising one or more processors in communication with the valve of each of the plurality of mCDUs, and for each of the plurality of mCDUs the one or more processors are configured to:
obtain a first temperature of the facility cooling fluid entering the mCDU along the facility shelf supply line;
obtain a second temperature of the rack cooling fluid exiting the mCDU along the rack shelf supply line;
determine a difference between the first temperature and the second temperature;
compare the difference to a predetermined temperature setpoint;
determine whether the difference is greater than, equal to, or less than the predetermined temperature setpoint; and
modify a size of the opening of the control valve when the difference is either greater than or less than the predetermined temperature setpoint.

6. The system of claim 5, wherein the predetermined temperature setpoint is a predetermined threshold difference between a temperature of facility cooling fluid at the CDU inlet and a temperature of rack supply fluid at the CDU outlet.

7. The system of claim 6, wherein the first temperature of the facility cooling fluid is the temperature of the facility cooling fluid at or near a connection between the facility supply manifold and the facility shelf supply line.

8. The system of claim 7, wherein the second temperature of the rack cooling fluid is the temperature of the rack cooling fluid at or near a connection between the rack supply manifold and the rack shelf supply line.

9. The system of any one of claims 5-8, wherein the one or more processors further communicate with the pump of each of the plurality of mCDUs, and for each of the plurality of mCDUs the one or more processors are configured to:
obtain a first flow rate pressure of rack cooling fluid exiting the mCDU along the rack shelf supply line;
obtain a second flow rate pressure of rack cooling fluid entering the mCDU along the rack shelf return line;
determine the difference between the first flow rate pressure and the second flow rate pressure;
compare the difference to a predetermined flow rate pressure difference setpoint;
determine whether the difference is greater than, equal to, or less than the predetermined flow rate pressure difference setpoint; and
modify a speed of the pump when the difference is either greater than or less than the predetermined flowrate pressure difference setpoint.

10. The system of claim 9, wherein the predetermined flow rate pressure difference setpoint comprises a predetermined threshold difference between a flow rate pressure of the rack cooling fluid exiting the rack supply manifold and a flow rate pressure of the rack cooling fluid entering the rack return manifold

11. The system of any one of claims 8-10, wherein the first flow rate pressure comprises the flow rate pressure of the rack cooling fluid at or near a connection between the rack supply manifold and the rack shelf supply line.

12. The system of any one of claims 9-11, wherein the second flow rate pressure of the rack cooling fluid comprises the flow rate pressure of rack cooling fluid at or near a connection between the rack return manifold and the rack shelf return line.

13. The system of any one of claims 5-12, further comprising:
the first facility cooling loop through which the facility cooling fluid flows, the first facility cooling loop comprising the central facility supply line and the central facility return line;
the second rack cooling loop through which the rack cooling fluid flows, the second rack cooling loop comprising the central rack supply line and the central rack return line; and
the plurality of downstream data racks; and optionally
wherein the central rack supply line further comprises a plurality of elongated manifolds through which cooling fluid flows, the plurality of elongated manifolds having ends coupled together, the elongated manifolds overlying the plurality of downstream data racks, the system further comprising at least one manifold adapter coupling a first manifold and a second manifold of the plurality of elongated manifolds together, each of the first and second manifolds having an end, the manifold adapter comprising a hose having a male clamp connector at first and second ends of the manifold adapter, the first end of the male clamp connector coupling with a first female connector coupled to an end of the first manifold, and the second end of the male clamp connector coupling with a second female connector coupled to an end of the second manifold; and optionally,
each of the plurality of downstream data racks further comprises:
a data rack housing having a plurality of movable shelves for housing a plurality of computing devices disposed at the plurality of shelves;
a first data rack housing supply manifold and a first data rack housing return manifold positioned adjacent the data rack housing; and
a second data rack housing supply manifold and a second data rack housing return manifold positioned adjacent the data rack housing,
wherein the first data rack housing supply manifold and the second data rack housing supply manifold are coupled to the central rack supply line, and
wherein the second data rack housing return manifold and the second data rack housing return manifold are coupled to the central rack return line.

14. The system of any one of claims 5-13, further comprising:
a control system comprising one or more processors in communication with each of the plurality of mCDUs and a power distribution unit ("PDU") configured to supply power to each of the plurality of mCDUs, and for each of the plurality of mCDUs the one or more processors are configured to:
obtain a first facility liquid supply temperature and a second rack liquid supply temperature;
determine an approach temperature by obtaining a difference between the first facility liquid supply temperature and the second rack liquid supply temperature;
compare the approach temperature to a malfunction temperature setpoint; and
instruct the PDU to shut down power to the mCDU when the approach temperature is greater than the malfunction temperature setpoint; and/or
for each of the plurality of mCDUs the one or more processors are configured to:
obtain a first rack supply pressure and a second rack fluid return pressure;
determine a differential pressure by determining a difference between the first rack supply pressure and the second rack fluid return pressure;
compare the differential pressure to a malfunction pressure setpoint; and
instruct the PDU to shut down power to the mCDU when the differential pressure is greater than malfunction pressure setpoint.

15. A method for providing liquid cooling of information technology equipment in a data center comprising:
adjusting a size of a plurality of valve openings of a corresponding plurality of valves, each valve corresponding to one of a plurality of modular coolant distribution units ("mCDUs") of a coolant distribution unit ("CDU") and configured to regulate an amount of cooling fluid flowing through the corresponding one of the plurality of mCDUs, the adjusting comprising for each of the plurality of mCDUs:
obtaining a first facility liquid supply temperature and a second rack liquid supply temperature;
determining an approach temperature by obtaining a difference between the first facility liquid supply temperature and the second rack liquid supply temperature;
comparing the approach temperature to a predetermined approach temperature setpoint;
increasing the size of the opening of the valve when the approach temperature is greater than the predetermined approach temperature setpoint;
decreasing the size of the opening of the valve when the approach temperature is less than the predetermined approach temperature setpoint; and
making no adjustments to the size of the opening when the approach temperature is equal to the predetermined approach temperature setpoint; and/or
adjusting a pump speed of a plurality of pumps of a corresponding plurality of mCDUs, each of the plurality of pumps configured to regulate a rate of flow of cooling fluid flowing through each of the corresponding plurality of mCDUs, the adjusting comprising for each of the plurality of mCDUs:
obtaining a first flow rate pressure of rack cooling fluid from a rack supply side of the second rack cooling loop;
obtaining a second flow rate pressure data of rack cooling fluid from a rack return side of the second rack cooling loop;
obtaining a pressure differential between the first flow rate pressure and the second flow rate pressure;
decreasing the pump speed when the pressure differential is greater than a predetermined pressure difference setpoint;
increasing the pump speed when the pressure differential is less than the predetermined pressure difference setpoint; and
making no adjustments to the pump of the pump when the pressure differential is equal to the predetermined pressure difference setpoint.
